# EUROPEAN PATENT APPLICATION

(11) **EP 3 136 424 A2**
(43) Date of publication of application: **01.03.2017**
(21) Application number: 16184770.2
(22) Date of filing: 18.08.2016
(51) Int. Cl.: H01L 21/28, H01L 29/423, H01L 29/66, H01L 29/792, H01L 27/11565, H01L 27/1157, H01L 27/11573

(54) **SEMICONDUCTOR DEVICE AND METHOD OF MANUFACTURING SEMICONDUCTOR DEVICE**

(30) Priority: 28.08.2015 JP 2015169379
(71) Applicant: Renesas Electronics Corporation, Tokyo 135-0061 (JP)
(72) Inventor: Arigane, Tsuyoshi, Chiyoda-ku, Tokyo 100-8280 (JP); Hisamoto, Digh, Chiyoda-ku, Tokyo 100-8280 (JP)
(74) Representative: Glawe, Delfs, Moll

(57) **Abstract**

A property of a semiconductor device having a non-volatile memory is improved. A semiconductor device, which has a control gate electrode part and a memory gate electrode part placed above a semiconductor substrate of a non-volatile memory, is configured as follows. A thick film portion is formed in an end portion of the control gate insulating film on the memory gate electrode part side, below the control gate electrode part. According to this configuration, even when holes are efficiently injected to a comer portion of the memory gate electrode part by an FN tunnel erasing method, electrons can be efficiently injected to the comer portion of the memory gate electrode part by an SSI injection method. Thus, a mismatch of the electron/hole distribution can be moderated, so that the retention property of the memory cell can be improved.

## Description

### TECHNICAL FIELD OF THE INVENTION

The present invention relates to a semiconductor device and a method of manufacturing the semiconductor device. For example, the present invention is suitably used for a semiconductor device having a nonvolatile memory cell.

### BACKGROUND OF THE INVENTION

A memory cell including a split-gate-type cell using a metal-oxide-nitride-oxide-semiconductor (MONOS) film is used as a type of a nonvolatile memory, in some cases. At this time, the memory cell includes two MISFETs of a control transistor having a control gate electrode and a memory transistor having a memory gate electrode.

For example, Patent Document 1 (Specification of U.S. Patent No. 7847343) discloses a non-volatile semiconductor memory device having a split gate configuration in which a memory gate is formed on a convex type substrate.

Moreover, Patent Document 2 (Japanese Patent Application Laid-Open Publication No. 2009-54707) discloses a split-gate type MONOS memory cell in which a thickness of a gate insulating film below an end portion in a gate-length direction of a selection gate electrode is made thicker than a thickness of a gate insulating film below a center portion in the gate-length direction thereof

### SUMMARY OF THE INVENTION

The present inventors research and develop a semiconductor device having a nonvolatile memory cell as described above, and study a Fowler-Nordheim (FN) type erasing method that erases the accumulated charge by injecting a hole from a memory gate (MG).

However, it has been found that retention property (charge holding property) is degraded when holes are injected from the memory gate (MG).

Accordingly, it is desired to develop a semiconductor device having a non-volatile memory cell having favorable retention property

Other object and novel characteristics of the present invention will be apparent from the description of the present specification and the accompanying drawings.

The typical ones of the inventions disclosed in the present application will be briefly described as follows.

A semiconductor device shown in one embodiment disclosed in the present application has: a first gate electrode part placed above a semiconductor substrate; and a second gate electrode part placed above the semiconductor substrate so as to be adjacent to the first gate electrode part. Moreover, a first insulating film formed between the first gate electrode part and the semiconductor substrate has a thick film portion at its end portion on the second gate electrode part side. Athickness of this thick film portion is largerthan a film thickness of an end portion of the first insulating film on the side opposite to the second gate electrode part side.

According to a semiconductor device described in a typical embodiment disclosed in the present application, a property of the semiconductor device can be improved.

### BRIEF DESCRIPTIONS OF THE DRAWINGS

FIG 1 is a cross-sectional view showing a semiconductor device according to a first embodiment;
FIG 2 is a cross-sectional view showing the semiconductor device according to the first embodiment;
FIG 3 is a cross-sectional view showing the semiconductor device according to the first embodiment;
FIG 4 is a plan view showing a memory array of the semiconductor device according to the first embodiment;
FIG 5 is a circuit diagram showing a memory array of the semiconductor device according to the first embodiment;
FIG 6 is a block diagram showing a configuration example of the semiconductor device according to the first embodiment;
FIG 7 is a diagram showing a flow from a start to an end of erasing;
FIG 8 is a diagram showing a first example of an erasing pulse;
FIG 9 is a diagram showing a second example of an erasing pulse;
FIG 10 is a diagram showing a flow from a start to an end of writing;
FIG 11 is a diagram showing a first example of a writing pulse;
FIG 12 is a diagram showing a second example of a writing pulse;
FIG 13 is a cross-sectional view showing a semiconductor device according to a comparative example;
FIG 14 is a cross-sectional view showing a semiconductor device according to a comparative example;
FIG 15 is a cross-sectional view showing a semiconductor device according to a comparative example;
FIGs. 16A and 16B are a cross-sectional view and a plan view showing a semiconductor device according to a first embodiment;
FIG 17 is a view schematically showing a horizontal cross-sectional surface of the semiconductor device of the first embodiment and a distribution state of electrons and holes at the time of operations;
FIG 18 is a view schematically showing a horizontal cross-sectional surface of the semiconductor device of the first embodiment and a distribution state of electrons and holes at the time of operations;
FIG 19 is a view schematically showing a horizontal cross-sectional surface of the semiconductor device of the first embodiment and a distribution state of electrons and holes at the time of operations;
FIG 20 is a diagram showing a relation between change of a threshold potential and high-temperature retention time;
FIG 21 is a cross-sectional view showing a semiconductor device according to the first embodiment;
FIG 22 is a cross-sectional view showing a manufacturing process of the semiconductor device according to the first embodiment;
FIG 23 is a cross-sectional view showing a manufacturing process of the semiconductor device according to the first embodiment;
FIG 24 is a cross-sectional view showing a manufacturing process of the semiconductor device according to the first embodiment;
FIG 25 is a cross-sectional view showing a manufacturing process of the semiconductor device according to the first embodiment;
FIG 26 is a cross-sectional view showing a manufacturing process of the semiconductor device according to the first embodiment;
FIG 27 is a cross-sectional view showing a manufacturing process of the semiconductor device according to the first embodiment;
FIG 28 is a cross-sectional view showing a manufacturing process of the semiconductor device according to the first embodiment;
FIG 29 is a cross-sectional view showing a manufacturing process of the semiconductor device according to the first embodiment;
FIGs. 30A and 30B are a cross-sectional view and a plan view showing a manufacturing process of the semiconductor device according to the first embodiment;
FIG 31 is a cross-sectional view showing a manufacturing process of the semiconductor device according to the first embodiment;
FIG 32 is a cross-sectional view showing a manufacturing process of the semiconductor device according to the first embodiment;
FIG 33 is a cross-sectional view showing a manufacturing process of the semiconductor device according to the first embodiment;
FIG 34 is a cross-sectional view showing a manufacturing process of the semiconductor device according to the first embodiment;
FIG 35 is a cross-sectional view showing a manufacturing process of the semiconductor device according to the first embodiment;
FIG 36 is a cross-sectional view showing a manufacturing process of the semiconductor device according to the first embodiment;
FIG 37 is a cross-sectional view showing a manufacturing process of the semiconductor device according to the first embodiment;
FIG 38 is a cross-sectional view showing a manufacturing process of the semiconductor device according to the first embodiment;
FIG 39 is a cross-sectional view showing a semiconductor device according to a second embodiment;
FIG 40 is a cross-sectional view showing a semiconductor device according to the second embodiment;
FIG 41 is a cross-sectional view showing a semiconductor device according to the second embodiment;
FIG 42 is a cross-sectional view showing a manufacturing process of the semiconductor device according to the second embodiment;
FIG 43 is a cross-sectional view showing a manufacturing process of the semiconductor device according to the second embodiment;
FIG 44 is a cross-sectional view showing a manufacturing process of the semiconductor device according to the second embodiment;
FIG 45 is a cross-sectional view showing a manufacturing process of the semiconductor device according to the second embodiment;
FIG 46 is a cross-sectional view showing a manufacturing process of the semiconductor device according to the second embodiment;
FIG 47 is a cross-sectional view showing a manufacturing process of the semiconductor device according to the second embodiment;
FIG 48 is a cross-sectional view showing a manufacturing process of the semiconductor device according to the second embodiment;
FIG 49 is a cross-sectional view showing a manufacturing process of the semiconductor device according to the second embodiment;
FIG 50 is a cross-sectional view showing a manufacturing process of the semiconductor device according to the second embodiment;
FIG 51 is a cross-sectional view showing a manufacturing process of the semiconductor device according to the second embodiment;
FIG 52 is a cross-sectional view showing a manufacturing process of the semiconductor device according to the second embodiment;
FIG 53 is a cross-sectional view showing a manufacturing process of the semiconductor device according to the second embodiment;
FIG 54 is a cross-sectional view showing a manufacturing process of the semiconductor device according to the second embodiment;
FIG 55 is a cross-sectional view showing a manufacturing process of the semiconductor device according to the second embodiment;
FIG 56 is a cross-sectional view showing a semiconductor device according to a third embodiment;
FIG 57 is a cross-sectional view showing a semiconductor device according to the third embodiment;
FIG 58 is a cross-sectional view showing a semiconductor device according to the third embodiment;
FIG 59 is a cross-sectional view showing a semiconductor device according to the third embodiment;
FIG 60 is a cross-sectional view showing a manufacturing process of the semiconductor device according to the third embodiment;
FIG 61 is a cross-sectional view showing a manufacturing process of the semiconductor device according to the third embodiment;
FIG 62 is a cross-sectional view showing a manufacturing process of the semiconductor device according to the third embodiment;
FIG 63 is a cross-sectional view showing a manufacturing process of the semiconductor device according to the third embodiment;
FIG 64 is a cross-sectional view showing a manufacturing process of the semiconductor device according to the third embodiment;
FIG 65 is a cross-sectional view showing a manufacturing process of the semiconductor device according to the third embodiment;
FIG 66 is a cross-sectional view showing a manufacturing process of the semiconductor device according to the third embodiment;
FIG 67 is a cross-sectional view showing a manufacturing process of the semiconductor device according to the third embodiment;
FIG 68 is a cross-sectional view showing a manufacturing process of the semiconductor device according to the third embodiment;
FIG 69 is a cross-sectional view showing a manufacturing process of the semiconductor device according to the third embodiment;
FIG 70 is a cross-sectional view showing a manufacturing process of the semiconductor device according to the third embodiment;
FIG 71 is a cross-sectional view showing a manufacturing process of the semiconductor device according to the third embodiment;
FIG 72 is a cross-sectional view showing a manufacturing process of the semiconductor device according to the third embodiment;
FIG 73 is a cross-sectional view showing a manufacturing process of the semiconductor device according to the third embodiment;
FIG 74 is a cross-sectional view showing a manufacturing process of the semiconductor device according to the third embodiment;
FIG 75 is a cross-sectional view showing a manufacturing process of the semiconductor device according to the third embodiment;
FIG 76 is a cross-sectional view showing a manufacturing process of the semiconductor device according to the third embodiment;
FIG 77 is a cross-sectional view showing a manufacturing process of the semiconductor device according to the third embodiment;
FIG 78 is a cross-sectional view showing a manufacturing process of the semiconductor device according to the third embodiment;
FIG 79 is a cross-sectional view showing a manufacturing process of the semiconductor device according to the third embodiment;
FIG 80 is a cross-sectional view showing a manufacturing process of the semiconductor device according to the third embodiment;
FIG 81 is a cross-sectional view showing a manufacturing process of the semiconductor device according to the third embodiment;
FIG 82 is a cross-sectional view showing a manufacturing process of the semiconductor device according to the third embodiment;
FIG 83 is a cross-sectional view showing a manufacturing process of the semiconductor device according to the third embodiment;
FIG 84 is a cross-sectional view showing a manufacturing process of the semiconductor device according to the third embodiment;
FIG 85 is a cross-sectional view showing a manufacturing process of the semiconductor device according to the third embodiment;
FIG 86 is a cross-sectional view showing a semiconductor device according to a fourth embodiment;
FIG 87 is a cross-sectional view showing a semiconductor device according to the fourth embodiment;
FIG 88 is a cross-sectional view showing a semiconductor device according to the fourth embodiment;
FIG 89 is a cross-sectional view showing a manufacturing process of the semiconductor device according to the fourth embodiment;
FIG 90 is a cross-sectional view showing a manufacturing process of the semiconductor device according to the fourth embodiment;
FIG 91 is a cross-sectional view showing a manufacturing process of the semiconductor device according to the fourth embodiment;
FIG 92 is a cross-sectional view showing a manufacturing process of the semiconductor device according to the fourth embodiment;
FIG 93 is a cross-sectional view showing a manufacturing process of the semiconductor device according to the fourth embodiment;
FIG 94 is a cross-sectional view showing a manufacturing process of the semiconductor device according to the fourth embodiment;
FIG 95 is a cross-sectional view showing a manufacturing process of the semiconductor device according to the fourth embodiment;
FIG 96 is a cross-sectional view showing a manufacturing process of the semiconductor device according to the fourth embodiment;
FIG 97 is a cross-sectional view showing a manufacturing process of the semiconductor device according to the fourth embodiment;
FIG 98 is a cross-sectional view showing a manufacturing process of the semiconductor device according to the fourth embodiment;
FIG 99 is a cross-sectional view showing a manufacturing process of the semiconductor device according to the fourth embodiment;
FIG 100 is a cross-sectional view showing a manufacturing process of the semiconductor device according to the fourth embodiment;
FIG 101 is a cross-sectional view showing a manufacturing process of the semiconductor device according to the fourth embodiment;
FIG 102 is a cross-sectional view showing a manufacturing process of the semiconductor device according to the fourth embodiment;
FIG 103 is a cross-sectional view showing a manufacturing process of the semiconductor device according to the fourth embodiment;
FIG 104 is a cross-sectional view showing a manufacturing process of the semiconductor device according to the fourth embodiment;
FIG 105 is a cross-sectional view showing a manufacturing process of the semiconductor device according to the fourth embodiment;
FIG 106 is a cross-sectional view showing a manufacturing process of the semiconductor device according to the fourth embodiment;
FIG 107 is a cross-sectional view showing a manufacturing process of the semiconductor device according to the fourth embodiment;
FIG 108 is a cross-sectional view showing a manufacturing process of the semiconductor device according to the fourth embodiment; and
FIG 109 is a cross-sectional view showing a semiconductor device according to an application example.

### DESCRIPTIONS OF THE PREFERRED EMBODIMENTS

In the embodiments described below, the invention will be described in a plurality of sections or embodiments when required as a matter of convenience. However, these sections or embodiments are not irrelevant to each other unless otherwise stated, and the one relates to the entire or a part of the other as a modification example, details, or a supplementary explanation thereof. Also, in the embodiments described below, when referring to the number of elements (including number of pieces, values, amount, range, and others), the number of the elements is not limited to a specific number unless otherwise stated or except the case where the number is apparently limited to a specific number in principle. The number larger or smaller than the specified number is also applicable.

Further, in the embodiments described below, the components (including element steps) are not always indispensable unless otherwise stated or except the case where the components are apparently indispensable in principle. Similarly, in the embodiments described below, when the shape of the components, positional relation thereof, and others are mentioned, the substantially approximate and similar shapes and others are included therein unless otherwise stated or except the case where it is conceivable that they are apparently excluded in principle. The same goes for the numerical value (including the number of pieces, numerical values, the amount, the range, and others) described above.

Hereinafter, the embodiments are described in detail based on the drawings. Note that components having the same function are denoted by the same or relative reference characters throughout all the drawings for describing the embodiments, and the repetitive description thereof is omitted. Also, when there are a plurality of similar units (portions), a symbol is added to a reference character of a generic name to indicate an individual or a specific portion in some cases. Also, in the following embodiments, the description of the same or similar portions is not repeated in principle unless otherwise required.

Also, in some drawings used in the embodiments, hatching is omitted even in a cross-sectional view so as to make the drawings easy to see. Also, hatching is used even in a plan view so as to make the drawings easy to see.

Also, in the cross-sectional view and the plan views, a size of each portion does not correspond to that of a practical device, and a specific portion is shown to be relatively large so as to make the drawings easy to see in some cases. Also, even when the cross-sectional views and the plan views correspond to each other, a specific portion is shown to be relatively large so as to make the drawings easy to see in some cases.

### (First embodiment)

### [Description of structure]

A configuration of a semiconductor device according to the present embodiment is described below, with reference to the drawings. The semiconductor device according to the present embodiment has a memory cell (a memory transistor, and a control transistor) formed in a memory cell region MA. The transistor mentioned herein is also called a metal insulator semiconductor field effect transistor (MISFET).

### (Description of configuration of memory cell)

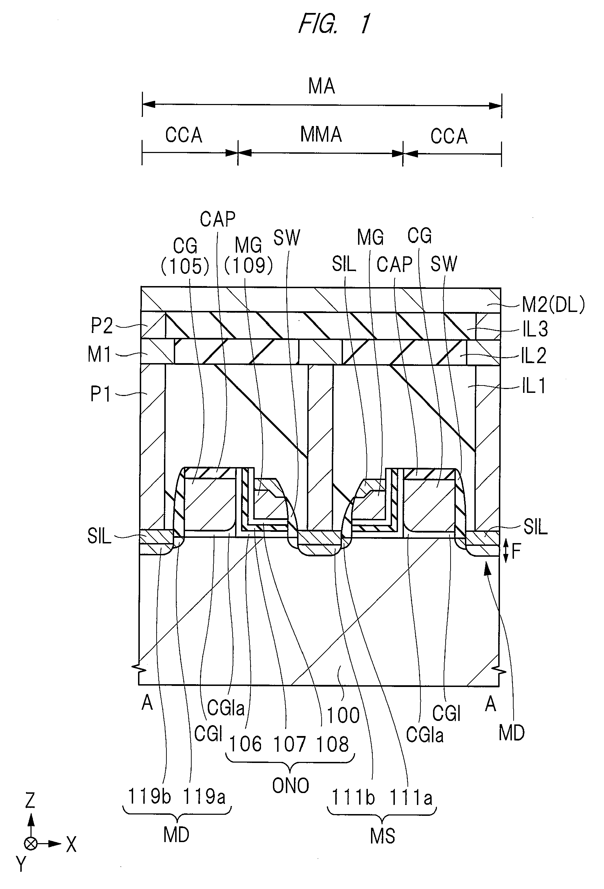

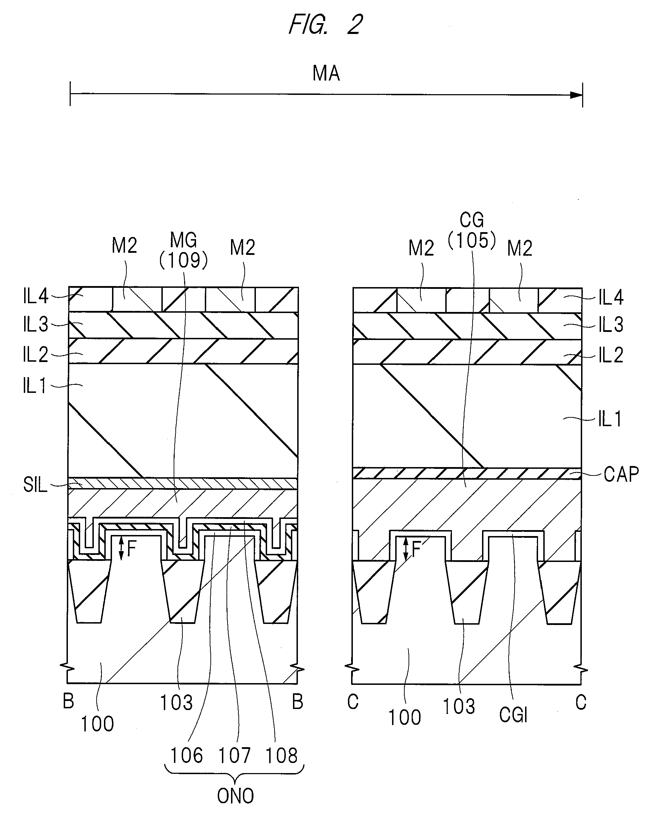

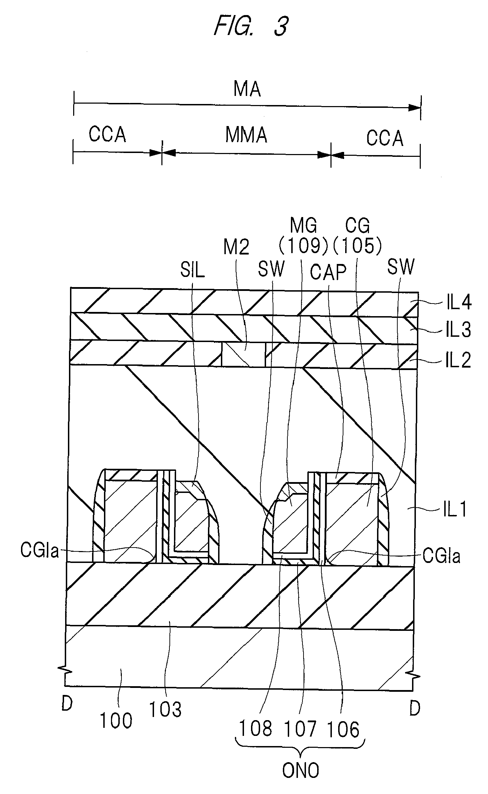

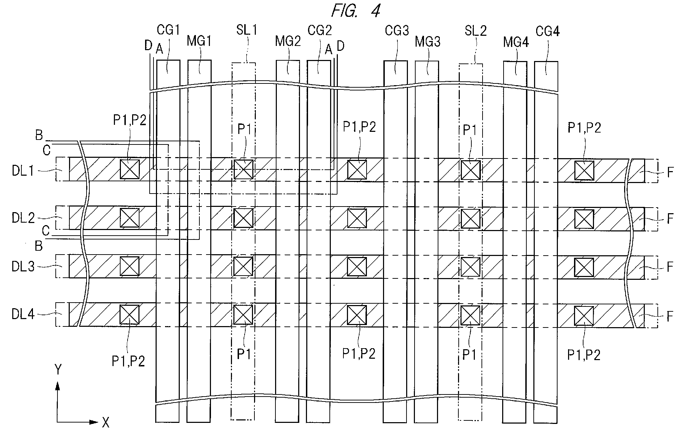

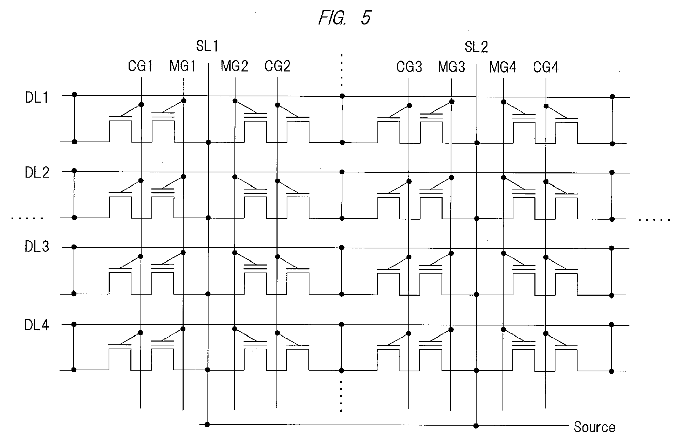

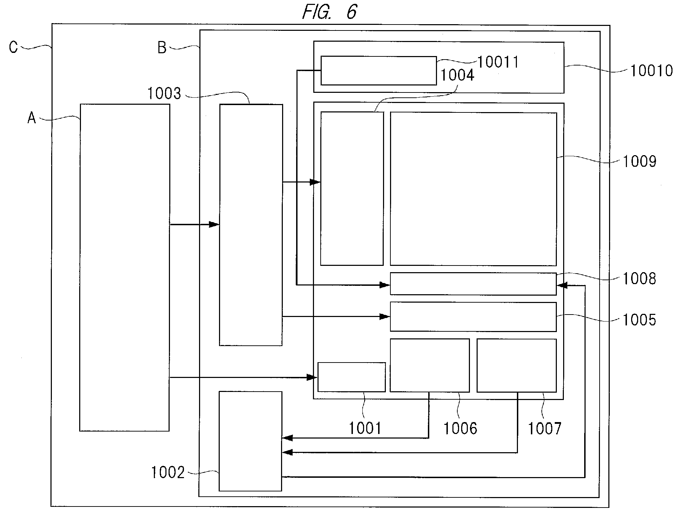

FIGs. 1 to 3 are cross-sectional views showing the semiconductor device according to the present embodiment. FIG 4 is a plan view showing a memory array of the semiconductor device according to the present embodiment. For example, FIG 1 corresponds to a cross-sectional view taken along line A-A of FIG 4, FIG 2 corresponds to cross-sectional views taken along lines B-B and C-C of FIG 4, FIG 3 corresponds to a cross-sectional view taken along line D-D of FIG 4. FIG 5 is a circuit diagram showing the memory array of the semiconductor device according to the present embodiment. FIG 6 is a block diagram showing an example of a configuration of the semiconductor device according to the present embodiment.

As shown in FIGs. 1 to 3, the memory cell (a memory element, element) includes a control transistor having a control gate electrode part CG, and a memory transistor having a memory gate electrode part MG

More specifically, the memory cell has the control gate electrode part CG placed above a semiconductor substrate 100 (a fin F), and the memory gate electrode part MG placed above the semiconductor substrate 100 (the fin F) and next to the control gate electrode part CG Each of the control gate electrode part CG and the memory gate electrode part MG is made of, for example, a silicon film. A metal silicide film SIL is formed on the upper side of the silicon film.

Moreover, in the present embodiment, the control gate electrode part CG and the memory gate electrode part MG are placed on a fin F having a rectangular parallelepiped shape via an insulating film (CG1, ONO). The fin F is formed of an upper portion of the semiconductor substrate 100 (fin F), and a plane shape of the fin F has a line shape (rectangular shape having its longer side in an X-direction) having a certain width (length in a Y-direction) as described later. In FIG 4, four fins F are placed in the Y-direction with a certain interval (pitch).

Furthermore, between the control gate electrode part CG and the semiconductor substrate 100 (fins F), a control gate insulating film CGI is placed. This control gate insulating film CGI is made of, for example, a silicon oxide film. In the present embodiment, the control gate insulating film CGI has a large film thickness in its end portion on the memory gate electrode part MG side. In other words, the control gate insulating film CGI has a thick film portion CGIa at its end portion on the memory gate electrode part MG side. In the further other words, the film thickness in the end portion of the control gate insulating film CGI on the memory gate electrode part MG side (film thickness of the thin film portion CGIa) is larger than the film thickness in the end portion of the control gate insulating film CGI on the side opposed to the memory gate electrode part MG side. In this manner, by increasing the film thickness of the end portion of the control gate insulating film CGI on the memory gate electrode part MC side, the retention property (charge holding property) of the memory cell can be improved. The details will be described later.

The memory cell further has an insulating film ONO (106, 107, 108) placed between the memory gate electrode part MG and the semiconductor substrate 100 (the fin F). The insulating film ONO is formed of, for example, a lower layer insulating film 106, a middle layer insulating film 107 placed on the lower layer insulating film 106, and an upper layer insulating film 108 placed on the middle layer insulating film 107. The middle layer insulating film 107 becomes a charge accumulating part. The lower layer insulating film 106 is made of, for example, a silicon oxide film The middle layer insulating film 107 is made of, for example, a silicon nitride film. The upper layer insulating film 108 is made of, for example, a silicon oxynitride film.

The insulating film ONO (106, 107, 108) is placed between the memory gate electrode part MG and the semiconductor substrate 100 (the fin F), and between the control gate electrode part CG and the memory gate electrode part MG

The memory cell further has a drain region MD and a source region MS which are formed in the fin F of the semiconductor substrate 100. A sidewall insulating film (a sidewall, a side wall spacer) SW made of an insulating film is formed on a side wall part of a composite pattern of the memory gate electrode part MG and the control gate electrode part CG.

The drain region MD is made of an n⁺-type semiconductor region 119b, and an n⁻-type semiconductor region 119a. The n⁻-type semiconductor region 119a is formed to be self aligned with respect to the side wall of the control gate electrode part CG The n⁺-type semiconductor region 119b is formed to be self aligned with respect to a side surface of the sidewall insulating film SW on the control gate electrode part CG side, and has a deeper junction depth and a higher impurity concentration than those of the n⁻-type semiconductor region 119a.

The source region MS is made of an n⁺-type semiconductor region 111b, and an n⁻-type semiconductor region 111a. The n⁻-type semiconductor region 111a is formed to be self aligned with respect to the side wall of the memory gate electrode part MG The n⁺-type semiconductor region 111b is formed to be self aligned with respect to a side surface of the side wall insulating film SW on the memory gate electrode part MG side, and has a deeper junction depth and a higher impurity concentration than those of the n⁻-type semiconductor region 111a.

Such a source region (or drain region) formed of a low-concentration semiconductor region and a high-concentration semiconductor region is called a lightly doped drain (LDD) structure.

In the present specification, note that the drain region MD and the source region MS are defined on the basis of an operation time. It is collectively assumed that a semiconductor region to which a low voltage is applied at the time of a reading operation described later is called a source region MS, and that a semiconductor region to which a high voltage is applied at the time of the reading operation is called a drain region MD.

A metal silicide film SIL is formed on the upper portion of the drain region MD (n⁺-type semiconductor region 119b) and of the source region MS (n⁺-type semiconductor region 111b). Also, a metal silicide film SIL is formed on the upper portion of the memory gate electrode MG Also, a cap insulating film CAP is formed on the upper portion of the control gate electrode CG The cap insulating film CAP is made of, for example, a silicon nitride film.

Moreover, on the memory cell, interlayer insulating films IL1, IL2, IL3 and IL4 are formed. Each of these films is made of, for example, a silicon oxide film. A plug P1 is formed in the interlayer insulating film IL1, and a wiring M1 is formed on the plug P1. A plug P2 is formed in the interlayer insulating film IL3, and a wiring M2 is formed on the plug P2. Each of the wirings M1 and M2 is, for example, a buried wiring, and is made of a conductive material such as metal. Here, the wirings M1 and M2 are buried in the interlayer insulating films IL2 and IL4.

Here, the two memory cells shown in FIG 1 are placed almost symmetric with respect to the source region MS. As described later, note that a plurality of memory cells are further placed in the memory cell region MA. For example, on the left of the memory cell on the left side of the memory cell region MA shown in FIG 1, a memory cell (not shown) which shares the drain region MD is placed.

A region between the control gate electrode parts CG which sandwich the drain region MD therebetween is assumed to be a region CCA. A region between the memory gate electrode parts MG which sandwich the source region MS therebetween is assumed to be a region MMA. In FIG 1, the regions CCA are located on both sides of the region MMA. The region MMA includes a region in which the insulating film ONO (106, 107, 108) placed along the side wall of the memory gate electrode part MG is formed

As described above, a memory cell group (row) is configured by arranging a plurality of memory cells in the right-left direction of FIG 1 (in the gate length direction) so that the shared source region MS and the shared drain region MD are placed alternately. Also, a memory cell group (column) is formed by arranging a plurality of memory cells in a direction perpendicular to the plane of the sheet of FIG 1 (in the gate width direction). In this manner, the plurality of the memory cells are formed in an array form The memory array is described below with reference to FIGs. 4 to 6.

### (Memory Array)

As shown in FIG 4, a plurality of fins F (active regions, hatching portions) which linearly extend in the X-direction are provided. A portion between the fins F is an element isolation region (103).

The control gate electrode parts CG (CG1, CG2, CG3, CG4) and memory gate electrode parts MG (MG1, MG2, MG3, MG4) of the memory cell extend in the Y-direction (direction intersecting an A-A cross sectional portion, vertical direction of the paper) so as to cross the fins F. Moreover, the source lines SL (SL1, SL2) extend in the Y-direction above the fins F so as to cross the fins F. The source region (MS, n⁺-type semiconductor region 111b) and the source line SL in the fin F are connected to each other through the plug (contact plug, connection part) P1. On the plurality of fins F, the source lines SL are placed in the Y-direction so as to connect plugs P1 on the source lines SL that are along each other in the Y-direction.

The control gate electrode part CG and the memory gate electrode part MG are placed so as to be symmetrical to each other with respect to the source line SL. The drain region MD (n⁺-type semiconductor region 119b) and the drain line DL in the fin F are connected to each other through the plug (contact plug, connection part) P1, P2 or others. On the respective fins F, the wirings (ML1, ML2, ML3, ML4) are placed in the X-direction so as to connect the plugs P2 on the drain region MD that are along each other in the X-direction.

As shown in FIG 5, the memory cell (the memory transistor, the control transistor) is placed in an array form at the intersection ofthe source line (SL1, SL2) and the drain line (DL1, DL2, DL3, DL4).

As shown in FIG 6, a memory cell array 1009 is provided in a memory section B. The semiconductor device C according to the present embodiment is formed of, for example, the memory section B and a logic sectionA.

The memory section B is configured of, for example, a control circuit 1001, an input/output circuit 1002, an address buffer 1003, a row decoder 1004, a column decoder 1005, a verification sense amplifier circuit 1006, a high-speed read sense amplifier circuit 1007, a writing circuit 1008, a memory cell array 1009, and a power supply circuit 1010. The control circuit 1001 stores temporarily and controls a control signal which is input from the logic section A. The control circuit 1001 also controls potentials of the control gate electrode part CG and the memory gate electrode part MG of the memory cell in the memory cell array 1009. Various types of data such as data read from the memory cell array 1009 or written to the memory cell array 1009, and program data, are input to and output from the input/output circuit 1002. The address buffer 1003 stores temporarily an address which is input from the logic section A. The row decoder 1004 and the column decoder 1005 are each connected to the address buffer 1003. The row decoder 1004 performs decoding based on a row address output from the address buffer 1003, and the column decoder 1005 performs decoding based on a column address output from the address buffer 1003. The verification sense amplifier circuit 1006 is a sense amplifier used for verification of erasing and writing, and the high-speed read sense amplifier circuit 1007 is a sense amplifier for reading, which is used at the time of data reading. The writing circuit 1008 controls the data writing by latching the written data which is input via the input/output circuit 1002. The power supply circuit 1010 is configured of a voltage generating circuit which generates various voltages used at the time of data writing, erasing, and verification, a current trimming circuit 1011 which generates a voltage of a certain value and which supplies the voltage to the writing circuit, and others.

Note that configurations shown in FIGs. 4 to 6 are examples, and the configuration of the semiconductor device according to the present embodiment is not limited to these examples.

### (Operation)

Subsequently, an example of a basic operation of the memory cell is described. As the operations of the memory cell, three operations of the memory cell (1) reading operation, (2) erasing operation, and (3) writing operation are described. However, these operations have various definitions, and, particularly, the erasing operation and the writing operation may be defined to be opposite to each other.

### (1) Reading Operation

For example, a positive potential of about 1.2 V is applied to the drain region MD on the control gate electrode part CG side, and a positive potential of about 1.2 V is applied to the control gate electrode part CG, so that the channel below the control gate electrode part CG is turned on. Then, by setting the memory gate electrode part MG to a predetermined potential (that is, a middle potential between a threshold value in the writing state and a threshold value in the erasing state), charge information that has been held can be read out as an electric current. Here, by setting the middle potential between the threshold value in the writing state and the threshold value in the erasing state to 0 V, it is not required to boost a voltage to be applied to the memory gate electrode part MG inside the power-supply circuit, so that a speed of the reading operation can be increased.

### (2) Erasing Operation

For example, a voltage of 12 V is applied to the memory gate electrode part MG, a voltage of 0 V is applied to the control gate electrode part CG, a voltage of 0 V is applied to the source region MS on the memory gate electrode part MG side, and a voltage of 0 V is applied to the drain region MD on the control gate electrode part CG side. In this manner, a hole is injected by the FN tunneling phenomena from the memory gate electrode part MG side into a silicon nitride film (middle layer insulating film 107, charge accumulating part), so that the erasing of the accumulated charge (here, electron) is performed (FN tunnel erasing method). However, the drain region MD on the control gate electrode part CG side may be electrically opened. Also, a potential of about 1 V may be applied to the control gate electrode part CG

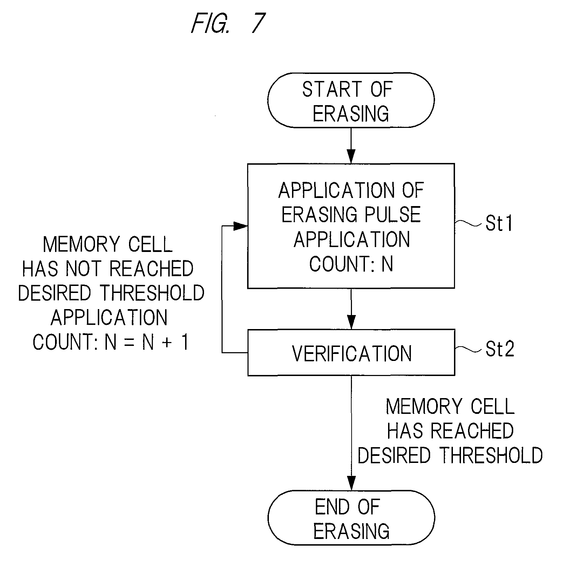

FIG 7 is a diagram showing a flow from a start to an end of erasing. As shown in FIG 7, the erasing operation is performed by applying the erasing pulse to inject the hole into the silicon nitride film (middle layer insulating film 107). Then, by the verification operation, it is verified whether or not the memory cell has reached a desired threshold. When the memory cell has not reached the desired threshold, such a sequence as applying the erasing pulse again is repeated. When the memory cell has reached the desired threshold, the erasing operation ends.

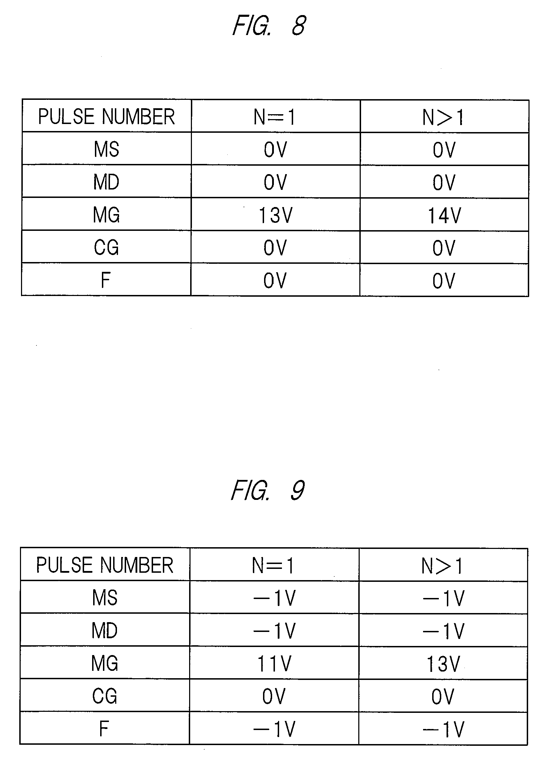

An erasing condition used when the erasing is further performed (N > 1) after the verification subsequent to the first erasing (N = 1) is not necessarily the same as that of the first erasing. A first example of an erasing pulse is shown in FIG 8. As shown in FIG 8, in the first erasing (N = 1), the memory gate electrode part MG is at 13 V, the control gate electrode part CG is at 0 V, the drain region MD is at 0 V, the source region MS is at 0 V, and the fin F (semiconductor substrate 100) is at 0 V In the second and following erasing (N > 1), the memory gate electrode part MG is at 14 V, the control gate electrode part CG is at 0 V, the drain region MD is at 0 V, the source region MS is at 0 V, and the fin F (semiconductor substrate 100) is at 0 V

A second example of an erasing pulse is shown in FIG 9. As shown in FIG 9, a negative potential may be applied to the fin F (semiconductor substrate 100). As shown in FIG 9, in the first erasing (N = 1), the memory gate electrode part MG is at 11 V, the control gate electrode part CG is at 0 V, the drain region MD is at -1 V, the source region MS is at -1 V, and the fin F (semiconductor substrate 100) is at -1 V In the second and following erasing (N > 1), the memory gate electrode part MG is at 11 V, the control gate electrode part CG is at 0 V, the drain region MD is at -1 V, the source region MS is at -1 V, and the fin F (semiconductor substrate 100) is at -1 V In this case, a potential difference between the memory gate electrode part MG and the fin F (semiconductor substrate 100) is larger than a potential difference between the memory gate electrode part MG and the control gate electrode part CG Therefore, holes are easily injected into the silicon nitride film (charge accumulating film 107) below the memory gate electrode part MG, and electrons in the silicon nitride film (charge accumulating film 107) are efficiently erased.

### (3) Writing Operation

For example, a voltage of 9.5 V is applied to the memory gate electrode part MG, a voltage of 0.9 V is applied to the control gate electrode part CG, a voltage of 5.7 V is applied to the source region MS on the memory gate electrode part MG side, and a potential lower than that of the source region, for example, 0.3 V, is applied to the drain region MD on the control gate electrode part CG side. Thus, electrons are collectively injected to the end portion of the memory gate electrode part MG on the control gate electrode part CG side. This injection method is referred to as an SSI (Source Side Hot Electron) injection method.

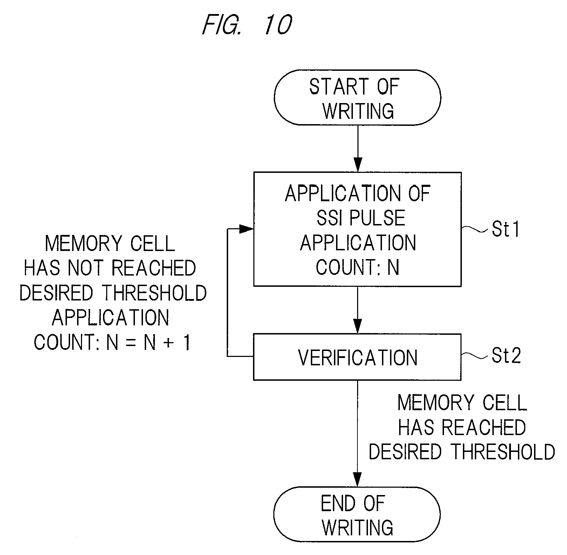

FIG 10 is a diagram showing a flow from a start to an end of writing. As shown in FIG 10, the writing is performed by applying an SSI pulse so as to inject an electron into the silicon nitride film (middle layer insulating film 107), and then, it is verified whether or not the memory cell has reached a desired threshold by a verification operation. When the memory cell has not reached the desired threshold, such a sequence as applying the SSI pulse again is repeated. When the memory cell has reached the desired threshold, the writing ends.

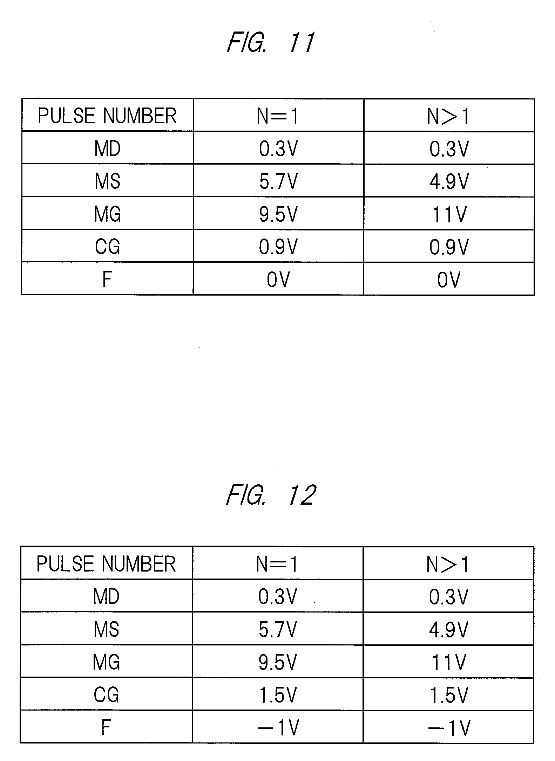

A writing condition used when the writing is further performed (N > 1) after the verification subsequent to the first writing (N = 1) is not necessarily the same as that of the first writing. A first example of a writing pulse is shown in FIG 11. As shown in FIG 11, in the first writing (N = 1), the memory gate electrode part MG is at 9.5 V, the control gate electrode part CG is at 0.9 V, the source region MS is at 5.7 V, the drain region MD is at 0.3 V, and the fin F (semiconductor substrate 100) is at 0 V In the second and following writing (N > 1), the memory gate electrode part MG is at 11 V, the control gate electrode part CG is at 0.9 V, the source region MS is at 4.9 V, the drain region MD is at 0.3 V, and the fin F (semiconductor substrate 100) is at 0 V

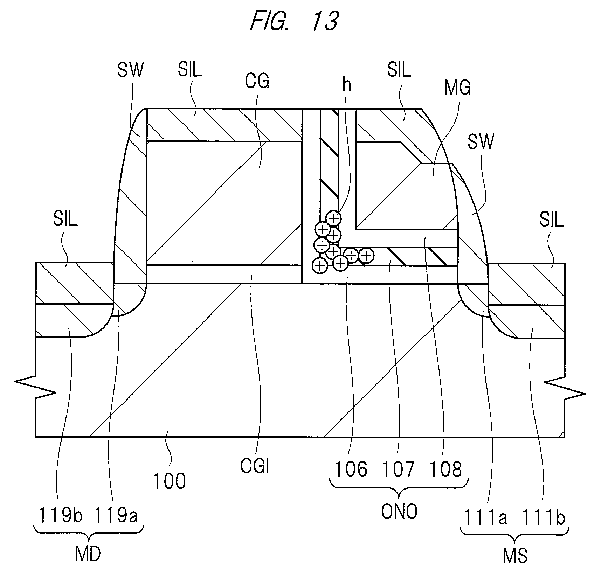

A second example of a writing pulse is shown in FIG 12. As shown in FIG 12, a negative potential may be applied to the fin F (semiconductor substrate 100). As shown in FIG 13, in the first writing (N = 1), the memory gate electrode part MG is at 9.5 V, the control gate electrode part CG is at 1.5 V, the source region MS is at 5.7 V, the drain region MD is at 0.3 V, and the fin F (semiconductor substrate 100) is at -1 V In the second and following writing (N > 1), the memory gate electrode part MG is at 11 V, the control gate electrode part CG is at 1.5 V, the source region MS is at 4.9 V, the drain region MD is at 0.3 V, and the fin F (semiconductor substrate 100) is at -1 V In this case, potential differences between the drain region MD and the fin F (semiconductor substrate 100), and between the memory gate electrode part MG and the fin F (semiconductor substrate 100) can be increased, and therefore, the writing speed can be increased.

In this manner, according to the present embodiment, since the thick film portion CGIa is formed in the end portion of the control gate insulating film CGI on the memory gate electrode part MG side, the retention property (charge holding property of the memory cell) can be improved.

FIGs. 13 to 15 are cross-sectional views each showing a semiconductor device of a comparative example. The semiconductor device of the comparative example is significantly different from the semiconductor device of FIG 1 in that the control gate insulating film CGI has a substantially uniform film thickness, without being provided with the thick film portion CGIa in the end portion on the memory gate electrode part MG side. Note that the semiconductor device of the comparative example does not have fins, and is formed on the main surface of the semiconductor substrate 100. Moreover, on the control gate electrode part CG, no cap insulating film is formed but the metal silicide film SIL is formed. In FIG 13, the parts corresponding to those of the semiconductor device of FIG 1 are denoted by the same reference symbols, and the explanation thereof will be omitted. Note that FIGs. 13 to 15 schematically show distribution states of electrons and holes at the time of operations.

As described above, when holes are injected from the memory gate electrode part MG side to the silicon nitride film (middle layer insulating film 107, charge accumulating part) by using an FN tunnel phenomenon through an FN tunnel erasing method, electric field concentration occurs on each of corners of the memory gate electrode part MG in the comparative example shown in FIG 13, and holes are more effectively injected into these corner portions.

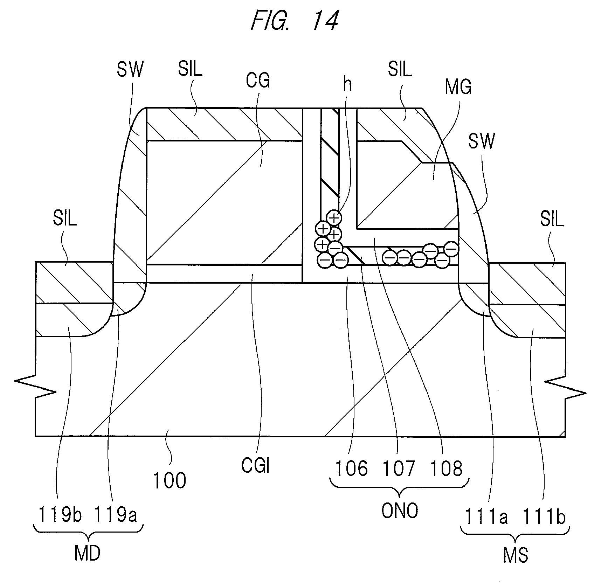

Subsequently, when electrons are injected to the end portion of the memory gate electrode part MG on the control gate electrode part CG side by the SSI injection method (SSI writing method), the holes cannot be completely eliminated due to a difference in an injection method. Therefore, as shown in FIG 14, the distributions of electrons and holes are mismatched with each other at the end portion of the memory gate electrode part MG on the control gate electrode part CG side. In other words, the silicon nitride film (middle layer insulating film 107, charge accumulating part) has a portion where electrons are localized and a portion where holes are localized. Particularly, at the corners of the memory gate electrode part MG, the collectively-injected holes cannot be rewritten by the electrons.

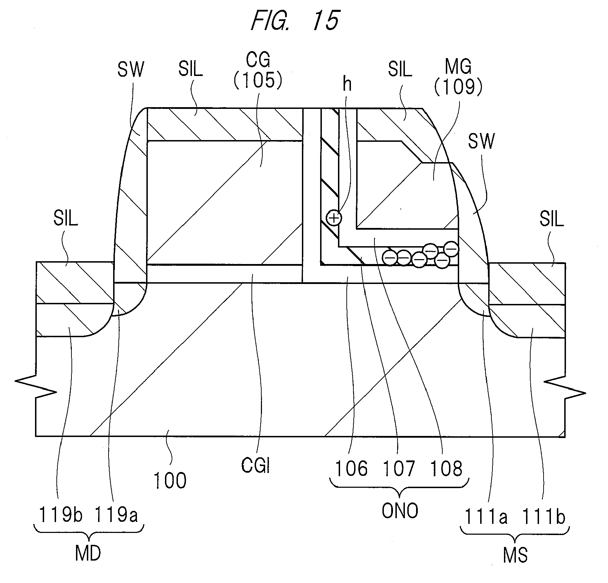

Then, since the localized electrons and the localized holes disappear in a pair, a predetermined amount of electrons cannot be maintained. Particularly, at the corner of the memory gate electrode part MG, a required amount of electrons cannot be maintained. In this manner, the retention property (holding property) is deteriorated (FIG 15). Such deterioration of the retention property can be confirmed by an acceleration test (by being left under a high temperature environment of, for example, about 150°C).

Moreover, when the fin F structure is adopted, not only the upper surface of the fin F but also the side surface of the fin F serves as a channel region, and therefore, the mismatch in the distributions of the electrons and the holes tends to occur on the side surface of the fin F. Therefore, the deterioration in the retention property due to the localization of the electrons and the holes becomes large. For example, there is a case in which the width of a fin is about 10 nm and the height of the fin is about 40 nm In this case, the channel region on the side surface of the fin F becomes larger than the channel region on the upper surface of the fin F, and therefore, a counter measure against the mismatch in the distributions of the electrons and the holes become important.

On the other hand, in the present embodiment, as shown in FIG 1, since the thick film portion CGIa is formed in the end portion of the control gate insulating film CGI on the memory gate electrode part MG side, the electrons can be more effectively injected to the corner portions of the memory gate electrode part MG, so that the mismatch in the distributions of the electrons and the holes can be suppressed. In other words, holes that have been collectively injected to the corner portions of the memory gate electrode part MG can be rewritten by collectively injecting the electrons to the corner portions of the memory gate electrode part MG Thus, the mismatch in the distributions of the electrons and the holes can be moderated, and so that the retention property can be improved.

Further, since the thick film portion CGIa is formed on not only the upper surface of the fin F but also on the side surface of the fin F, the mismatch in the distributions of electrons and holes can be moderated.

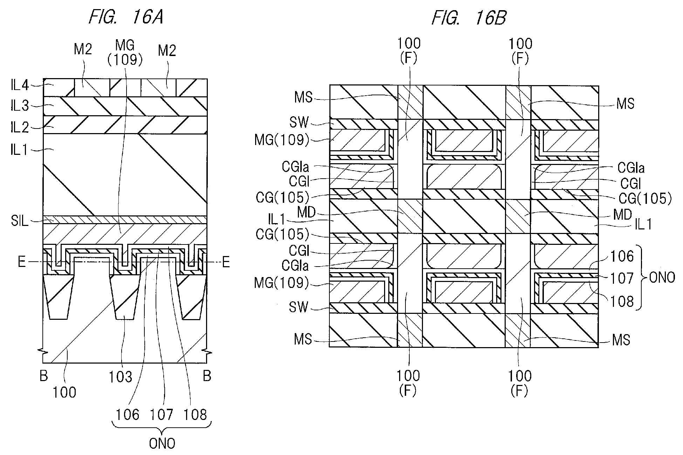

FIGs. 16A and 16B are a cross-sectional view and a plan view showing the semiconductor device of the present embodiment. FIG 16A shows a cross-sectional view, and FIG 16B shows a plan view obtained by cutting FIG 16A in a portion E-E in a horizontal direction.

The thick film portion CGIa in the end portion of the control gate insulating film CGI on the memory gate electrode part MG side shown in FIG 1 is formed along the side surface of the fin F as shown in FIG 16B.

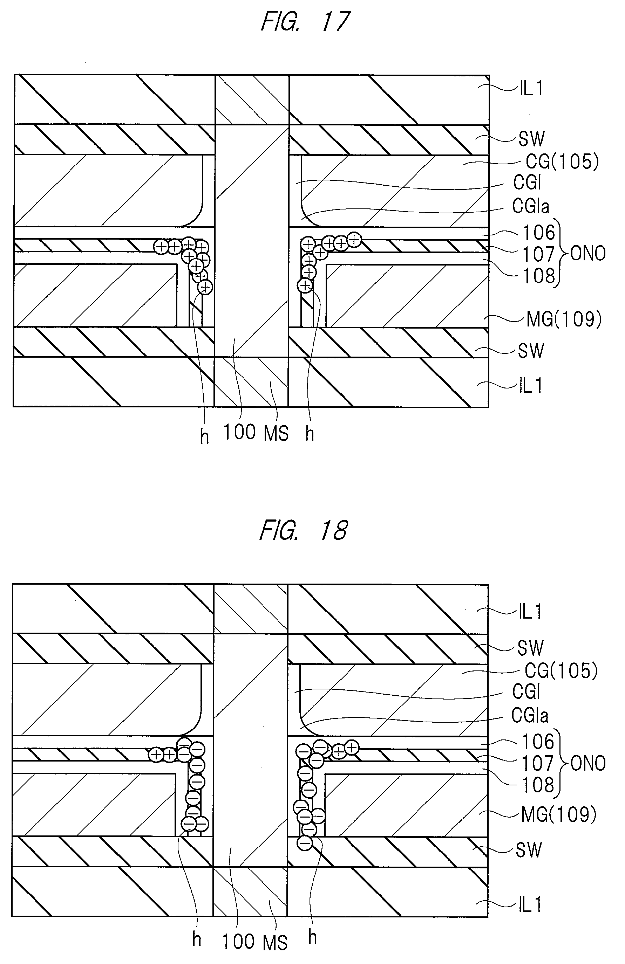

Each of FIGs. 17 to 19 schematically shows a horizontal cross-sectional surface of the semiconductor device of the present embodiment and the distribution state of the electrons and the holes at the time of operations.

As shown in FIG 17, when holes are injected from the memory gate electrode part MG side to the silicon nitride film (middle layer insulating film 107, charge accumulating part) by using an FN tunnel phenomenon through an FN tunnel erasing method, electric field concentration occurs on each of corners of the memory gate electrode part MG, and the holes are more effectively injected into these corner portions.

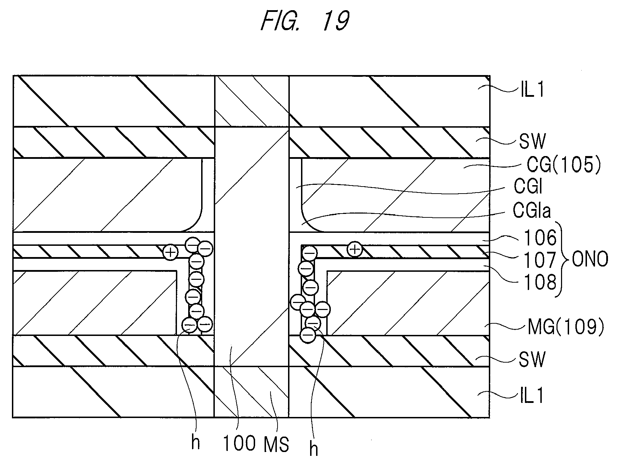

Subsequently, by the SSI injection system, the electrons are injected to the end portion of the memory gate electrode part MG on the control gate electrode part CG side. In this case, as shown in FIG 18, the injection electric field of hot electrons from the memory gate electrode part MG is generated in the thick film portion CGIa in the end portion of the control gate insulating film CGI on the memory gate electrode part MG side, and therefore, the electrons can be more effectively injected to the corner portions of the memory gate electrode part MG than those in a case of, for example, the comparative example shown in FIG 14. Thus, the mismatch of the distributions of electrons/holes can be moderated, and a predetermined amount of the electrons can be maintained even if the localized electrons and the localized holes disappear in a pair after this (FIG 19). For example, even after an acceleration test at a high temperature of about 160°C, the predetermined amount of electrons can be maintained. Thus, the retention property of the memory cells can be improved.

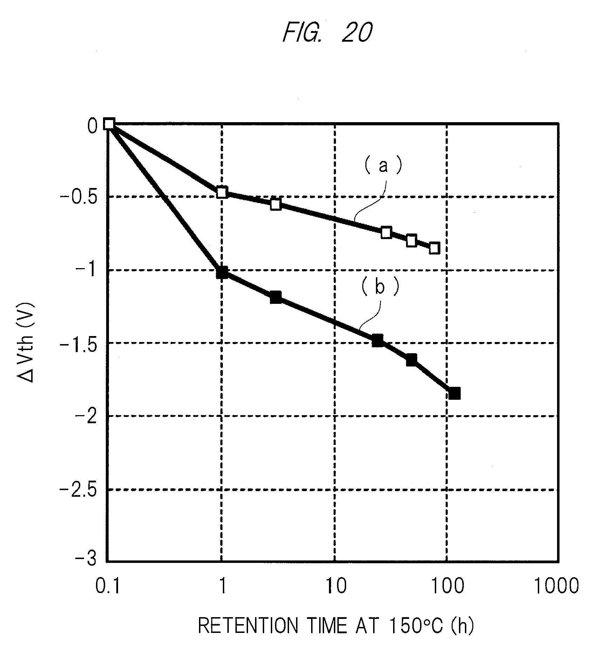

FIG 20 is a view showing a relation between change in a threshold potential and retention time at a high temperature. A vertical axis indicates a change amount of the threshold potential (reduction amount, ΔVth [V]), and a horizontal axis indicates the retention time [h]. A graph (a) indicates the case of the present embodiment, and a graph (b) indicates the case ofthe comparative example (FIG 14, etc.).

When the thick film portion CGIa is formed in the end portion of the control gate insulating film CGI on the memory gate electrode part MG side as in the present embodiment, it is found that the retention property is improved more than that in the case of the comparative example without the thick film portion. When the fin structure is adopted, a ratio of the side surface of the fin F to the channel region becomes high as described above, and therefore, it is very effective to improve the retention property by moderating the mismatch in the distributions of electrons/holes. In this manner, the configuration of the present embodiment is effectively applied to a memory cell having the fin structure.

In FIG 1 or others, note that the explanation has been made for the semiconductor device having the memory cell region MA in which the memory cells are formed. However, in addition to the memory cell region MA, a peripheral circuit region PA in which a peripheral circuit is formed may be provided in the semiconductor device. In the peripheral circuit region PA, a MISFET (Metal Insulator Semiconductor Field Effect Transistor) forming the peripheral circuit is formed. For example, various circuits for driving the memory cell array 1009 shown in FIG 6 can be formed in the peripheral circuit region PA as the peripheral circuits.

### (Description of Structure of Peripheral Transistor)

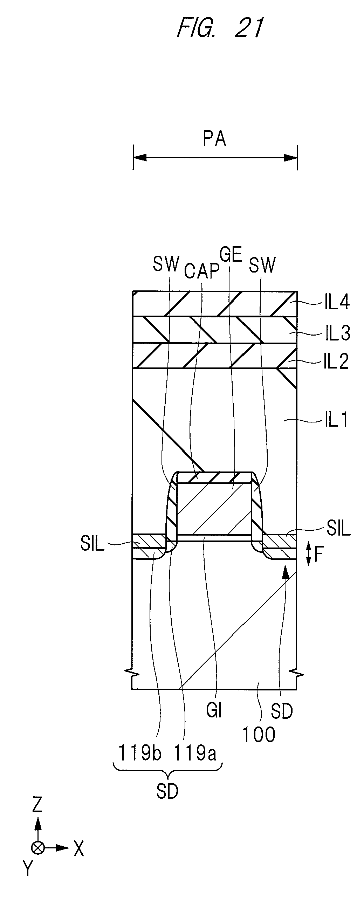

FIG 21 is a cross-sectional view showing the semiconductor device of the present embodiment. FIG 21 shows a cross-sectional surface of a peripheral transistor (element) formed in the peripheral circuit region PA.

As shown in FIG 21, the peripheral transistor has: a gate electrode part GE placed above the semiconductor substrate 100 (fin F); and a source/drain region SD formed in the semiconductor substrate 100 (fins F) on both sides of the gate electrode part GE. The fin F is formed of the upper portion of the semiconductor substrate 100, and the plane shape of the fin F has a line shape (rectangular shape having its longer side in the X-direction) having a certain width (length in the Y-direction). The gate electrode part GE extends in the Y-direction (direction intersecting an A-A cross-sectional portion, that is, vertical direction ofthe paper) so as to cross the fins F.

For the gate electrode part GE, for example, the same-layer film as that of the control gate electrode part CG can be used. Moreover, the peripheral transistor has a gate insulating film GI placed between the gate electrode part GE and the semiconductor substrate 100 (fin F). The gate insulating film GI such as a silicon oxide film can be used. Moreover, as the gate insulating film GI, the same-layer film as that of the control gate insulating film CGI may be used. However, in the end portion of the gate insulating film GI, it is not required to form the thick film portion CGIa.

Furthermore, on the side wall of the gate electrode part GE, a sidewall insulating film SW made of an insulating film is formed. The source/drain region SD is formed of an n⁺-type semiconductor region 119b and an n⁻-type semiconductor region 119a. The n⁻-type semiconductor region 119a is formed to be self-aligned with respect to the side wall of the gate electrode part GE. Moreover, the n⁺-type semiconductor region 119b is formed to be self-aligned with respect to the side surface of the sidewall insulating film SW, and has a deeper junction depth and a higher impurity concentration than those of the n⁻-type semiconductor region 119a. On the upper portion of this source/drain region SD (n⁺-type semiconductor region 119b), a metal silicide film SIL is formed. Moreover, on the upper portion of the gate electrode GE, a cap insulating film CAP is formed.

Moreover, on the peripheral transistor (cap insulating film CAP), interlayer insulating films IL1, IL2, IL3 and IL4 are formed. Each of these films is formed of, for example, a silicon oxide film. Note that plugs and wirings may be formed in the interlayer insulating films (IL1 to IL4) although not shown.

### [Description of Manufacturing Method]

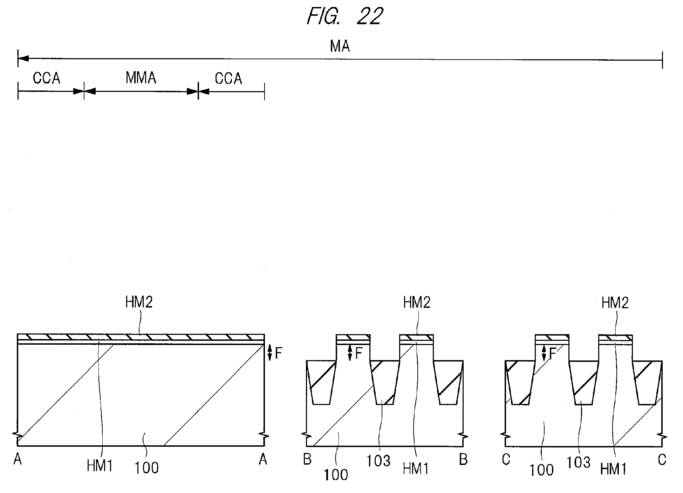

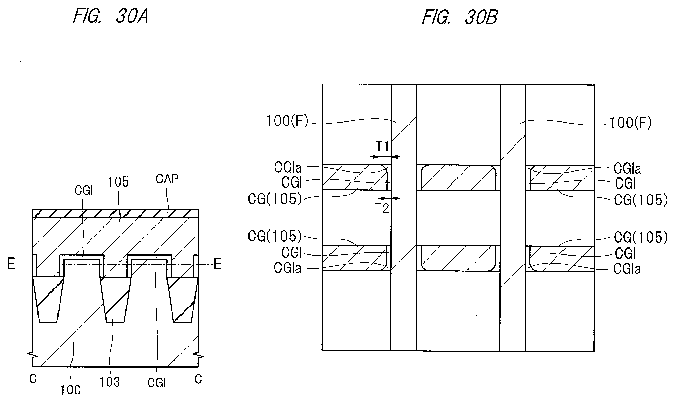

Subsequently, with reference to FIGs. 22 to 38, a method of manufacturing the semiconductor device of the present embodiment will be described, and besides, a configuration of the semiconductor device will be further clarified. Each of FIGs. 22 to 38 is a cross-sectional view showing a manufacturing process of the semiconductor device of the present embodiment. Note that FIG 30 includes a plan view in a part of the drawing.

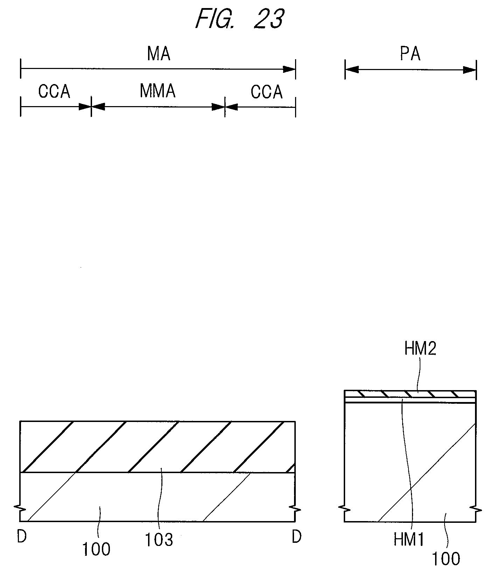

First, as shown in FIGs. 22 and 23, for example, a semiconductor substrate made of p-type single crystal silicon having a resistivity of about 1 to 10 Ωcm is prepared as the semiconductor substrate 100. Subsequently, by thermally oxidizing the semiconductor substrate 100, a silicon oxide film HM1 having a thickness of about 10 nm is formed. Subsequently, on the silicon oxide film HM1, a silicon nitride film HM2 having a thickness of about 50 nm is deposited by using a CVD (Chemical Vapor Deposition) method or others. Subsequently, by using a photolithography technique and a dry etching technique, the silicon oxide film HM1, the silicon nitride film HM2 and the semiconductor substrate 100 are etched, so that an element isolation trench is formed. Subsequently, by depositing a silicon oxide film on the silicon nitride film HM2 including the inside of the element isolation trench by using the CVD method or others, and by removing the silicon oxide film outside of the element isolation trench by using a CMP (Chemical Mechanical Polishing) method or others, an insulating film such as a silicon oxide film or others is buried inside the element isolation trench Such an element isolation method is referred to as an STI (Sallow Trench Isolation) method. This element isolation region 103 has a line shape (rectangular shape having its long side in the X-direction) having a certain width (length in the Y-direction). A plurality of linear element isolation regions 103 are placed in the Y-direction with a certain interval (pitch).

Then, by etching the surface of the insulating film, the surface of the element isolation region 103 is receded. Thus, the upper portion of the semiconductor substrate 100 between the element isolation regions 103 is formed into a convex portion (convex portion having a rectangular parallelepiped shape). This convex portion becomes the fin F (see a hatching portion in FIG 4). That is, the linear element isolation region 103 and the linear fin F are alternately placed. Note that the linear fin F is also formed in the peripheral circuit region PA.

At this time, it is preferable to adjust the width of the fin F, the width and depth of the element isolation region 103, the thickness of the memory gate electrode part MG, and others so that the bottom surface of the memory gate electrode part MG formed on the element isolation region 103 is upper than a half position of the height of the fin F (height difference between the upper surface of the fin F and the upper surface of the element isolation region 103). In this manner, by placing the bottom surface of the memory mate electrode part MG to be upper than the half position of the height of the fin F, the electrons can be more effectively injected to the corner portions of the memory gate electrode part MG by the injection electric field of hot electrons from the memory gate electrode part MG

Subsequently, by removing the silicon nitride film HM2, a p-type impurity (for example, boron (B) or others) is ion-implanted while using the silicon oxide film HM1 as a through film. Thus, the p-type impurity is introduced into the fin F (semiconductor substrate 100 (fin F)). The introduction region of the p-type impurity is referred to as a p-type well (not shown). An n-type well may be formed by ion-implanting an n-type impurity to a region not shown.

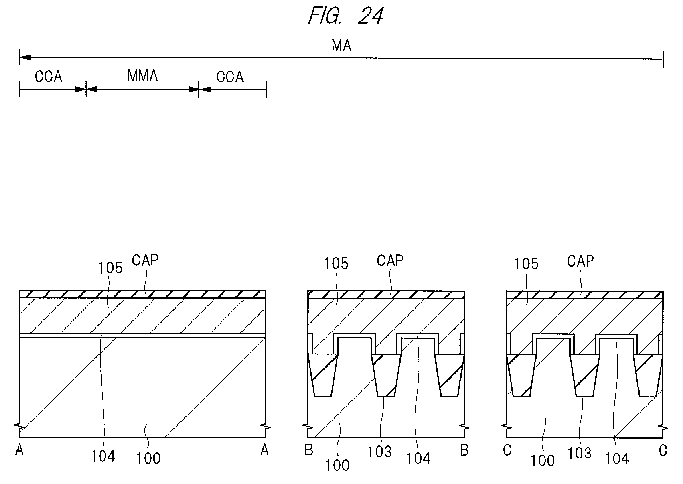

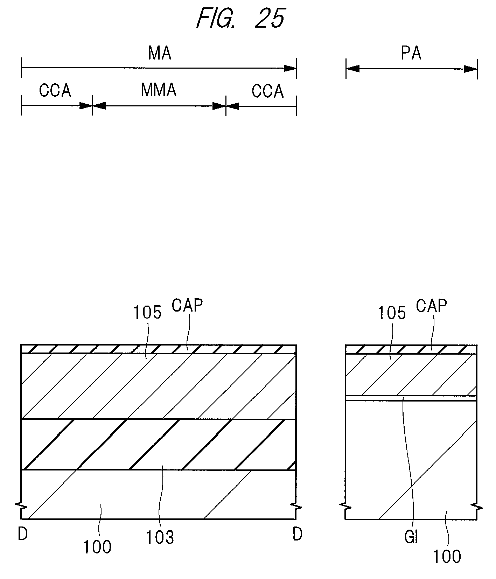

Subsequently, as shown in FIGs. 24 and 25, after removing the silicon oxide film HM1 by wet etching, an insulating film 104 is formed on the semiconductor substrate 100 (fin F). This insulating film 104 becomes the control gate insulating film CGI and the gate insulating film GI. For example, on the semiconductor substrate 100 (fin F), a silicon oxide film having a thickness of about 2 nm is formed by thermal oxidation. Subsequently, on the insulating film 104 (CGI, GI), a polysilicon film 105 for the control gate electrode part CG and the gate electrode part GE is formed. For example, on the insulating film 104 (CGI, GI) and the element isolation region 103, the polysilicon film 105 (CG, GE) having a thickness of about 70 nm is formed by using a CVD method or others. Subsequently, on the polysilicon film 105 (CG, GE), a cap insulating film CAP is formed. For example, on the polysilicon film 105 (CG, GE), a silicon nitride film having a thickness of about 20 nm is formed by using the CVD method or others.

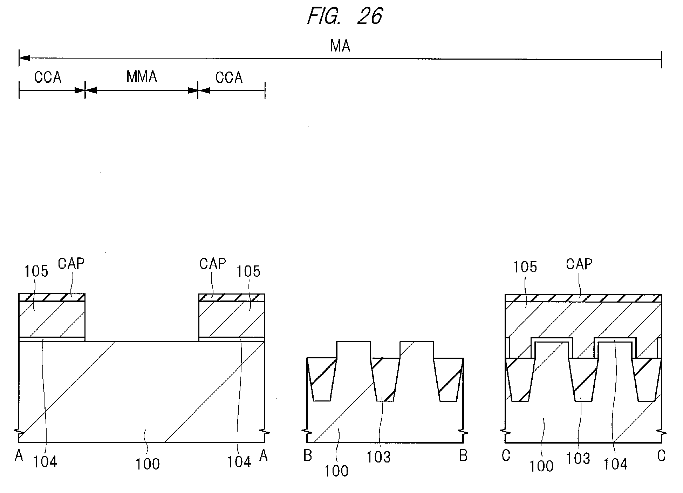

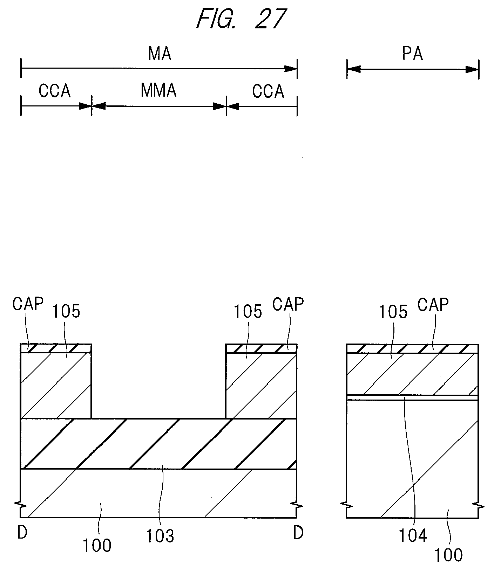

Subsequently, as shown in FIGs. 26 and 27, the stacked film formed of the insulating film 104 and the polysilicon film 105 in the region MMA is removed by using a photolithography technique and a dry etching technique. Thus, in the region CCA, the stacked film formed of the insulating film 104 (CGI, GI) and the polysilicon film 105 is left. Moreover, in this side surface (side surface exposed to the region MMA) of the stacked film, the insulating film 104 (CGI, GI) and the polysilicon film 105 (CG, GE) are exposed.

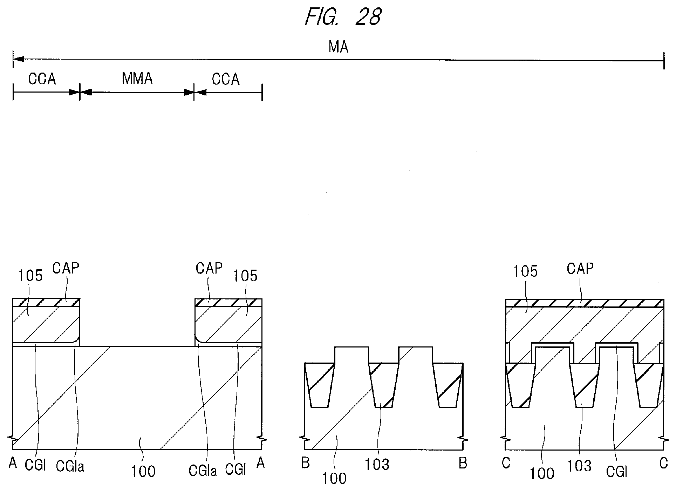

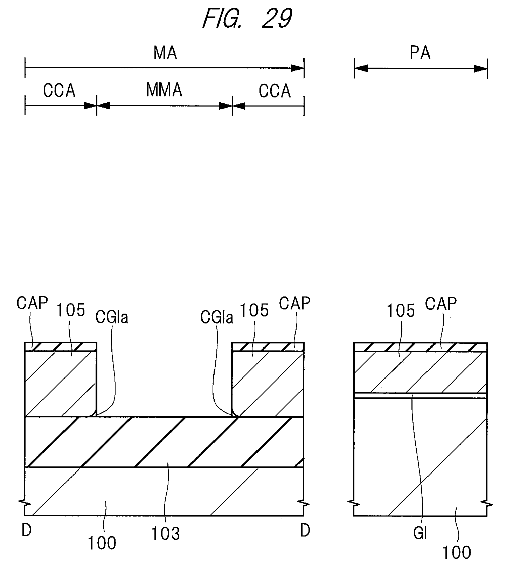

Subsequently, as shown in FIGs. 28 and 29, by thermal oxidation, a thick film portion CGIa is formed in the end portion (the above-described exposed portion) of the insulating film 104 (CGI, GI). FIG 30A shows a cross-sectional view, and FIG 30B shows a plan view obtained by cutting FIG 30A along an E-E portion thereof in a horizontal direction. As shown in FIGs. 16B and 30B, the thick film portion CGIa shown in FIG 1 is also formed along the side surface of the fin F. The thick film portion CGIa has a bird's beak shape so that the film thickness in the Z-direction becomes gradually larger as being closer to the memory gate electrode part MG side. In other words, the film thickness of the thick film portion CGIa is larger than the film thickness of the end portion on the side opposite to the memory gate electrode part MG side of the insulating film 104 (CGI, GI) (in FIG 30, T1 > T2).

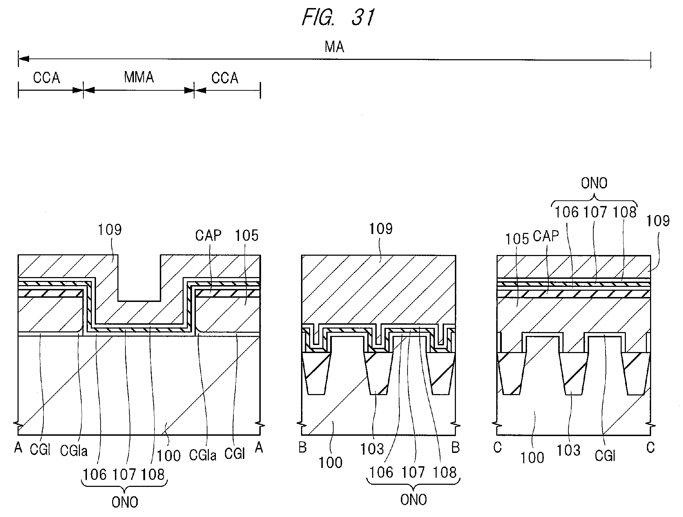

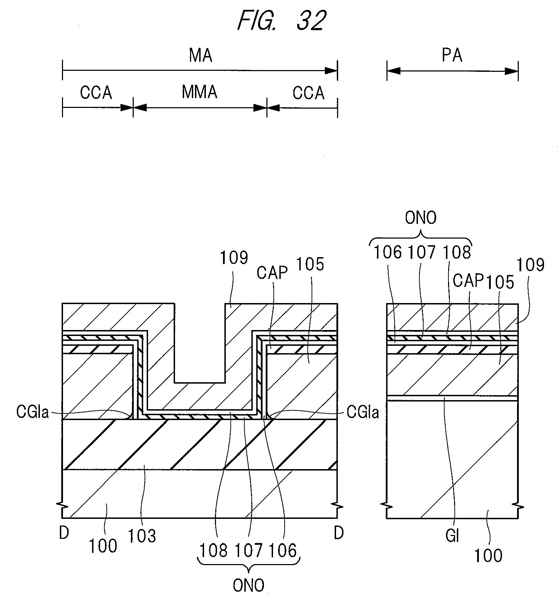

Subsequently, as shown in FIGs. 31 and 32, an insulating film ONO (106, 107, 108) is formed. First, for example, a silicon oxide film is formed as a lower layer insulating film 106 on the semiconductor substrate 100 (fin F) including the control gate electrode part CG The silicon oxide film is formed by, for example, thermal oxidation to have a thickness of about 4 nm. Note that the silicon oxide film may be formed by a CVD method or others. Then, on the lower layer insulating film 106, for example, a silicon nitride film is formed as a middle layer insulating film 107 to be deposited to have a thickness of about 7 nm by a CVD method or others. The middle layer insulating film 107 functions as a charge accumulating part of a memory cell. Subsequently, on the middle layer insulating film 107, an upper layer insulating film 108 is formed. For example, on the middle layer insulating film 107, a silicon oxide film is deposited as the upper layer insulating film 108 to have a thickness of about 9 nm by a CVD method or others.

Then, on the insulating film ONO (106, 107, 108), a conductive film 109 which becomes the memory gate electrode part MG is formed. For example, on the insulating film ONO (106, 107, 108), a polysilicon film having a thickness of about 40 nm is deposited as the conductive film 109 by a CVD method or others.

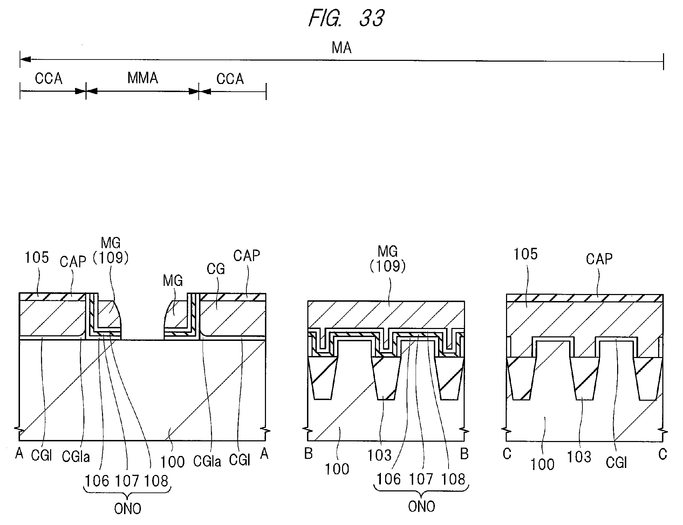

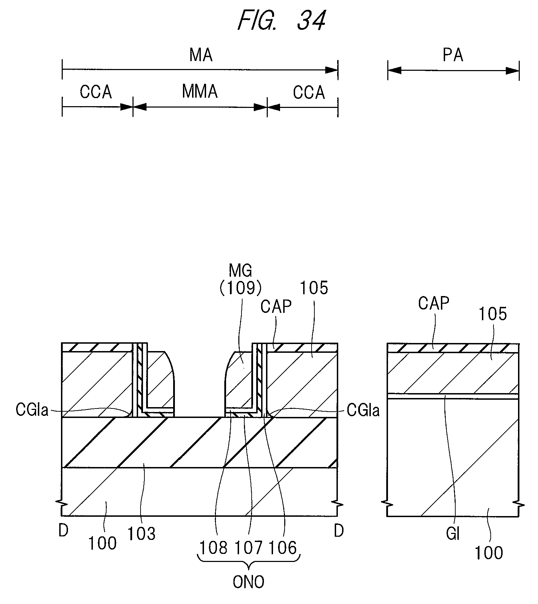

Then, as shown in FIGs. 33 and 34, a side-wall-form memory gate electrode part MG is formed along the side wall of the control gate electrode part CG

For example, the polysilicon film is etched back. In the etch-back process, by using anisotropic dry etching, the polysilicon film is removed by a predetermined thickness from the surface thereof. By this process, the polysilicon film can remain to be the side wall form (a side wall film form) on the side wall of the control gate electrode part CG via the insulating film ONO. Note that the polysilicon films remain on both sides of the region CCA, and one of them becomes the main gate electrode part MG Note that the other side-wall-form polysilicon film is removed by a photolithography technique and a dry etching technique. In order to improve the processability of the memory gate, note that a dummy gate formation region may be formed. For example, in the end portion of the memory array, there is a risk of variation in the property even when a memory cell is formed. For example, the dimension of the polysilicon film is varied to cause the variation in the property of the memory cell. Therefore, such an end portion of the memory array is formed as the dummy gate formation region, and a polysilicon film formed on both end portions of the control gate electrode part CG is formed as a dummy gate, so that control is performed not to contribute to the operation of the memory cell.

Then, the insulating film ONO (106, 107, 108) is etched while using the memory gate electrode part MG as a mask In this manner, the insulating film ONO (106, 107, 108) remains between the memory gate electrode part MG and the semiconductor substrate 100 (fin F), and between the control gate electrode part CG and the memory gate electrode part MG

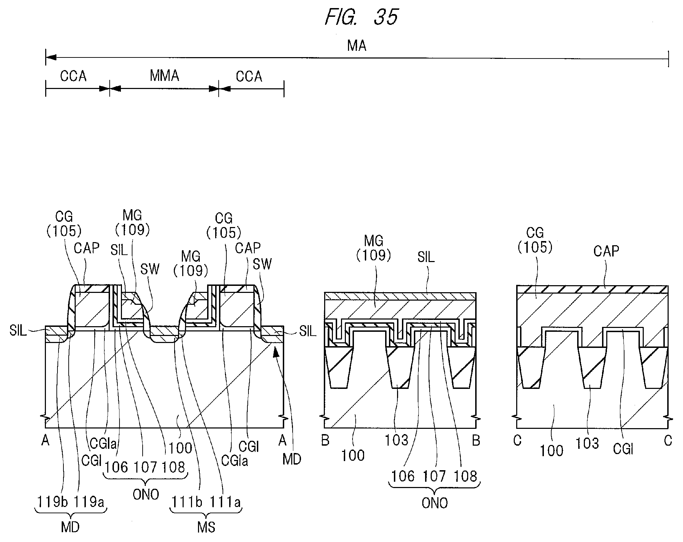

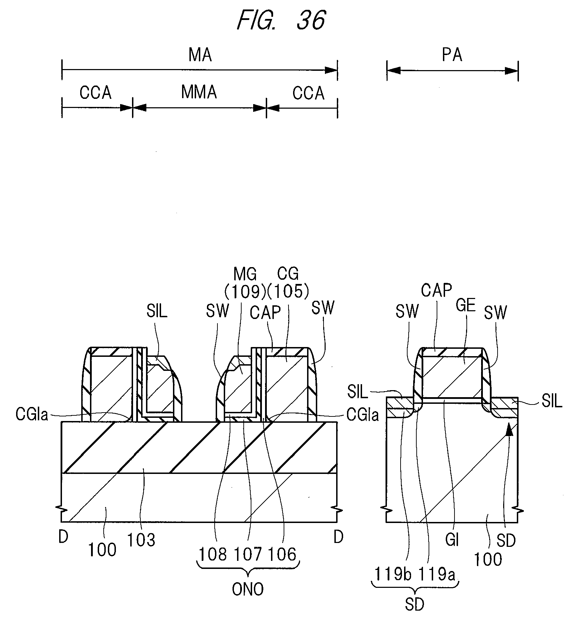

Then, as shown in FIGs. 35 and 36, the gate insulating film GI and the gate electrode GE are formed in the memory cell region MA and the peripheral circuit region PA. For example, by using a photolithography technique and a dry etching technique, the insulating film 104 (GI), the polysilicon film 105 (GE), and the cap insulating film CAP in the peripheral circuit region PA are processed.

Then, a source region MS and a drain region MD are formed in the memory cell region MA, and the source/drain region SD is formed in the peripheral circuit region PA

For example, an n⁻-type semiconductor regions 111a, 119a are formed by injecting n-type impurity such as arsenic (As) or phosphorus (P) into the semiconductor substrate 100 (fin F) while using the memory gate electrode part MG and the control gate electrode part CG as masks. At this time, the n⁻-type semiconductor region 111a is formed to be self aligned with respect to the side wall of the memory gate electrode part MG And, an n⁻-type semiconductor region 119a is formed by injecting n-type impurity such as arsenic (As) or phosphorus (P) into the semiconductor substrate 100 (fin F) while using the gate electrode part GE as a mask At this time, the n⁻-type semiconductor region 119a is formed to be self aligned with respect to the side wall of the gate electrode part GE.

Then, a sidewall film (a sidewall insulating film) SW is formed on the side wall of each of the memory gate electrode part MG, the control gate electrode part CG, and the gate electrode part GE. For example, a silicon oxide film is deposited on the semiconductor substrate 100 (fin F) including the memory gate electrode part MG, the control gate electrode part CG, and the gate electrode part GE by a CVD method or others. The sidewall film SW is formed by removing the silicon oxide film by a predetermined thickness from the surface thereof, by using anisotropic dry etching. Then, n⁺-type semiconductor regions 111b, 119b are formed by injecting n-type impurity such as arsenic (As) or phosphorus (P) into the semiconductor substrate 100 (fin F) while using the memory gate electrode part MG, the control gate electrode part CG, the gate electrode part GE, and the side wall insulating film SW as masks. At this time, the n⁺-type semiconductor regions 111b, 119b are formed to be self aligned with respect to the sidewall insulating film SW The n⁺-type semiconductor region 111b has a higher impurity concentration and a deeper junction depth than those of the n⁻-type semiconductor region 111a. The n⁺-type semiconductor region 119b has a higher impurity concentration and a deeper junction depth than those of the n⁻-type semiconductor region 119a. By this process, the source region MS including the n⁻-type semiconductor region 111a and the n⁺-type semiconductor region 111b is formed, and the drain region MD including the n⁻-type semiconductor region 119a and the n⁺-type semiconductor region 119b is formed. Also, the source/drain region SD including the n⁻-type semiconductor region 119a and the n⁺-type semiconductor region 119b is formed

Then, a metal silicide film SIL is formed on the memory gate electrode part MG, the source region MS, the drain region MD, and the source/drain region SD by using a salicide technique.

For example, a metal film (now shown) is formed on the memory gate electrode part MG, the source region MS, the drain region MD, and the source/drain region SD, and then, the semiconductor substrate 100 (fin F) is subjected to a heat treatment, so that the metal film reacts with the memory gate electrode part MG, the source region MS, the drain region MD, and the source/drain region SD. As a result, a metal silicide film SIL is formed. The metal film is made of, for example, nickel (Ni), a nickel-platinum (Pt) alloy, or others, and can be formed by a sputtering method or others. Then, an unreacted metal film is removed. By the metal silicide film SIL, contact resistance and diffusion resistance can be reduced

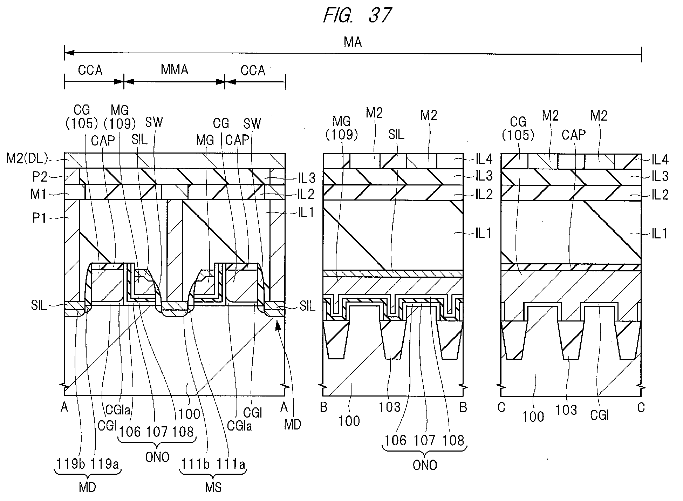

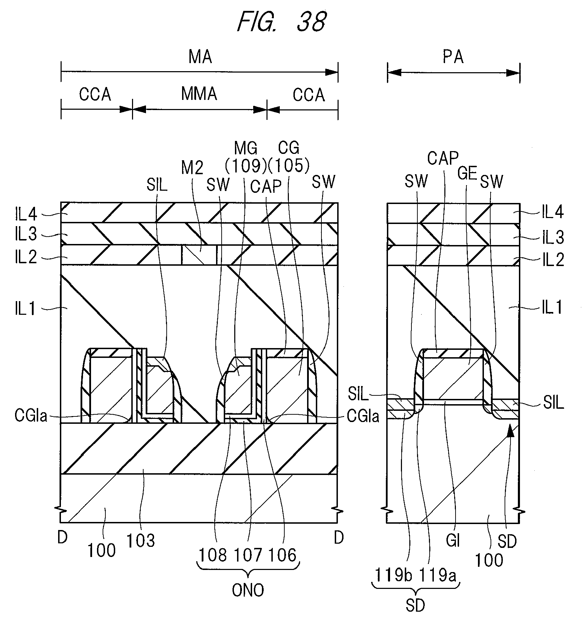

After that, as shown in FIGs. 37 and 38, a silicon oxide film IL1 as an interlayer insulating film IL1 is deposited above the control gate electrode part CG, the memory gate electrode part MG, the gate electrode part GE, and others by a CVD method or others. Then, a plug P1 is formed in the silicon oxide film IL1, and besides, a wiring M1 is formed on the plug P1. The plug P1 can be formed by, for example, burying a conductive film into a contact hole in the interlayer insulating film IL1. The wiring M1 can be formed by, for example, burying a conductive film in a wiring trench in the interlayer insulating film IL2. After this, the interlayer insulating films IL3 and IL4, the plug P2, and the wiring M1 can be formed by repeating the step of forming the interlayer insulating film, the plug, and the wiring.

By the above-described manufacturing process, the semiconductor device according to the present embodiment can be formed.

### (Second Embodiment)

In the semiconductor device of the first embodiment, the thick film portion of the control gate insulating film CGI is prepared as a single-layer film (single layer thermal-oxide film). However, the thick film portion of the control gate insulating film CGI may be prepared as a stacked film (for example, a stacked film of a thermal-oxide film and a deposit film).

Hereinafter, with respect to drawings, a structure of a semiconductor device of the present embodiment will be described

### [Description of Structure]

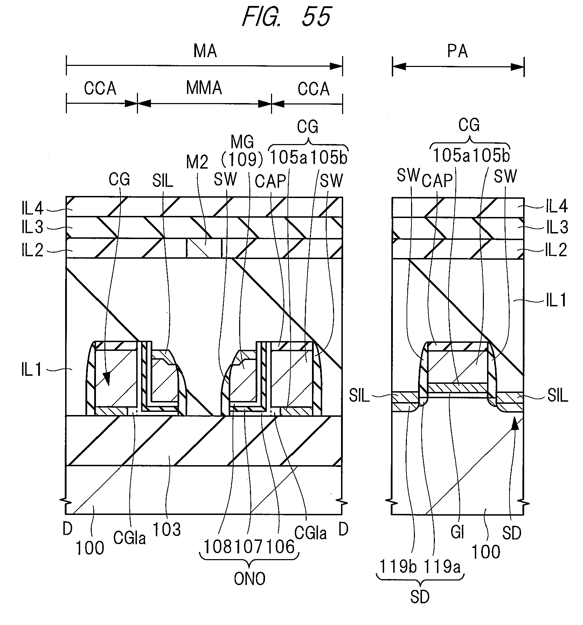

A semiconductor device of the present embodiment has a memory cell (memory transistor, control transistor) formed in a memory cell region MA and a peripheral transistor formed in a peripheral circuit region PA (see FIG 55).

### (Description of Memory Cell Structure)

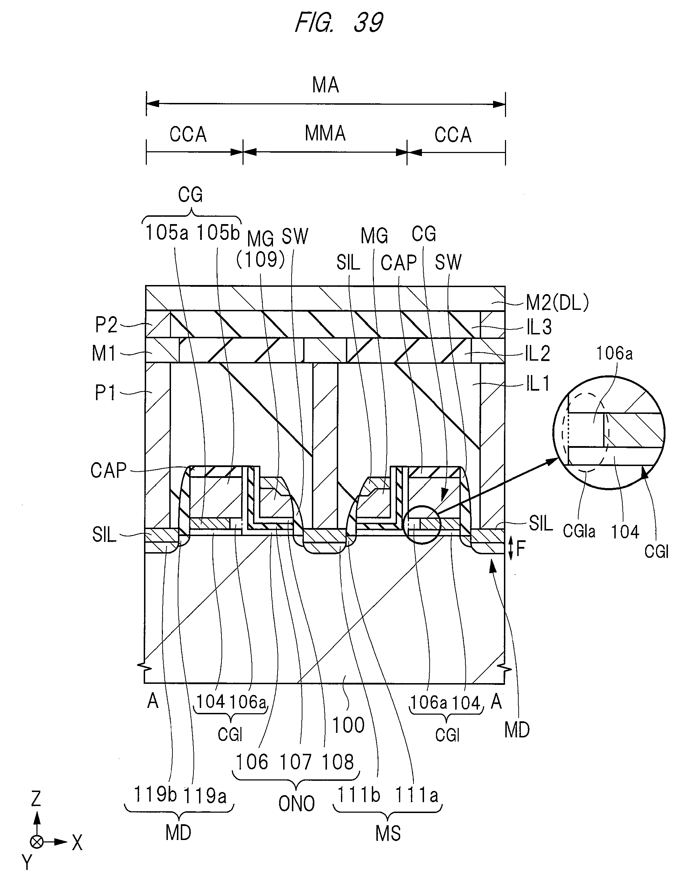

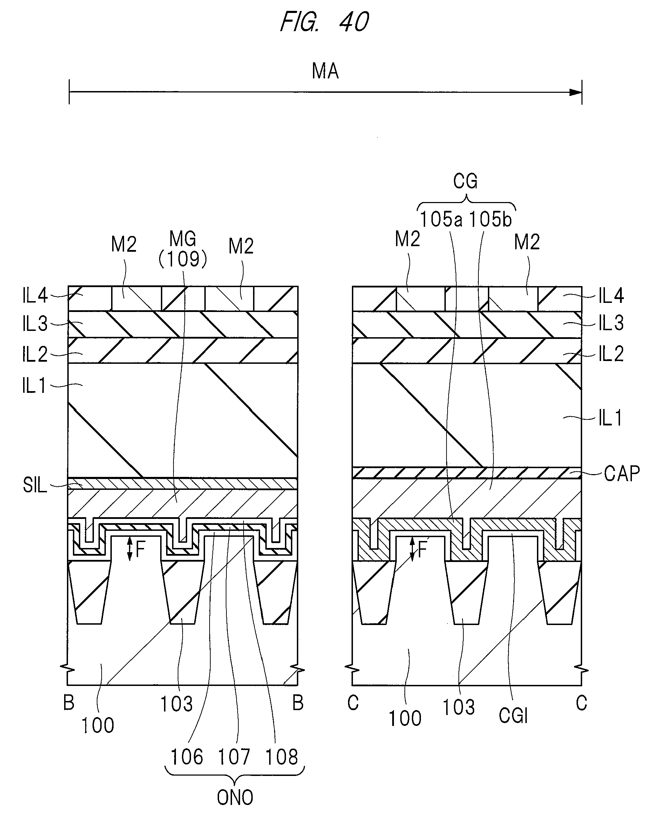

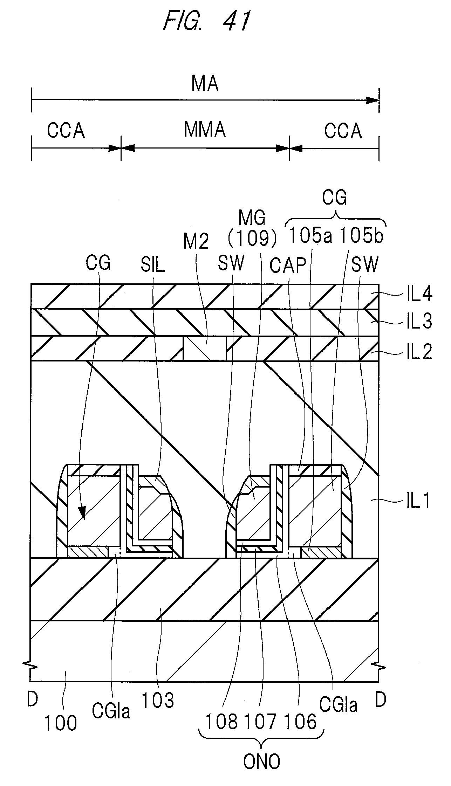

Each of FIGs. 39 to 41 is a cross-sectional view showing the semiconductor device of the present embodiment. The structure of the present embodiment is different from that of the first embodiment (see FIG 1 or others) in that the thick film portion CGIa of the control gate insulating film CGI is made of a stacked film and in that the control gate electrode part CG is made of a stacked film. The following is mainly the detailed description about differences from the first embodiment.

As shown in FIGs. 39 to 41, the memory cell (memory element) is formed of a control transistor having the control gate electrode part CG and a memory transistor having the memory gate electrode part MG

More specifically, the memory cell has the control gate electrode part CG placed on the semiconductor substrate 100 (fin F) and the memory gate electrode part MG which is placed on the semiconductor substrate 100 (fin F) and which is adjacent to the control gate electrode part CG

The control gate electrode part CG and the memory gate electrode part MG are placed on the rectangular-parallelepiped-shape fin F via a gate insulating film. The fin F is made of an upper portion of the semiconductor substrate 100 (fin F), and a plane shape of the fin F has a line shape (rectangular shape having its longer side in an X-direction) having a certain width (length in a Y-direction).

The control gate electrode part CG and the memory gate electrode part MG extend in the Y-direction (direction intersecting an A-A cross-sectional portion, that is, vertical direction in the paper) so as to cross the fin F (see FIG 4).

The memory gate electrode part MG is formed of, for example, a polysilicon film.

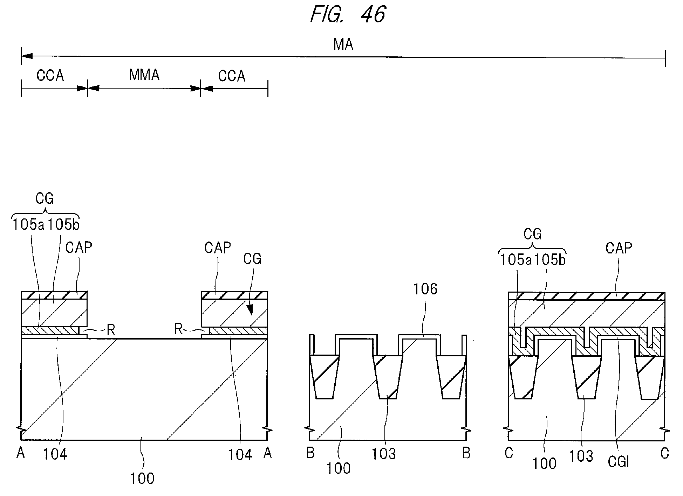

Moreover, the control gate electrode part CG is formed of a stacked film of a silicon germanium film 105a and a polysilicon film 105b formed thereon. Here, the end portion of the silicon germanium film 105a on the memory gate electrode part MG side is retreated from the end portion of the polysilicon film 105b on the memory gate electrode part MG side. That is, a hollow portion (concave portion, undercut portion, see "R" of FIG 46) of the silicon germanium film 105a is formed below the end portion of the polysilicon film 105b on the memory gate electrode part MG side. Moreover, into the hollow portion, a part of a lower layer insulating film 106 of insulating films ONO (106, 107, 108) comes. The part of the lower layer insulating film 106 coming into the hollow portion is indicated by a reference symbol 106a. In other words, below the end portion of the polysilicon film 105b on the memory gate electrode part MG side, the silicon germanium film 105a is not formed but the part 106a of the lower layer insulating film is placed.

Furthermore, the insulating films ONO (106, 107, 108) between the memory gate electrode part MG and the semiconductor substrate 100 (fin F) is provided, and a control gate insulating film CGI between the control gate electrode part CG and the semiconductor substrate 100 (fin F) is provided.

The insulating films ONO is formed of, for example, the lower layer insulating film 106, the middle layer insulating film 107 formed thereon, and the upper layer insulating film 108 further formed thereon.

The control gate insulating film CGI has a thick film portion CGIa in its end portion on the memory gate electrode part MG side. This thick film portion CGIa is formed of a stacked film. That is, the thick film portion CGIa is formed of a stacked film of a first insulating film portion and a second insulating film portion formed thereon. The first insulating film portion is a portion in an end portion of an insulating film 104 on the memory gate electrode part MG side, the insulating film 104 through which a film thickness is almost the same being placed on the semiconductor substrate 100 (fin F) between the control gate electrode part CG and the semiconductor substrate 100 (fin F). The second insulating film portion is a part of the lower layer insulating film 106 of the insulating films ONO (106, 107, 108) placed between the memory gate electrode part MG and the semiconductor substrate 100 (fin F), the part being a portion 106a of the end portion on the control gate electrode part CG side. This portion 106a is placed so as to come into a lower portion of the control gate electrode part CG, the lower portion being a lower portion of the longitudinal portion (vertical portion) of the lower layer insulating film 106.

In this manner, by increasing the film thickness of the end portion of the control gate insulating film CGI on the memory gate electrode part MG side, the retention property (charge holding property) of the memory cell can be improved as explained in the first embodiment.

Moreover, the memory cell further has a drain region MD and a source region MS formed in the fin F of the semiconductor substrate 100. Furthermore, a metal silicide film SIL is formed on the upper portions of the drain region MD (n⁺-type semiconductor region 119b), the source region MS (n⁺-type semiconductor region 111b), etc. And, a metal silicide film SIL is formed on the upper portion of the memory gate electrode part MG And, a cap insulating film CA is formed on the upper portion of the control gate electrode part CG The cap insulating film CAP is formed of, for example, a silicon nitride film.

Furthermore, on the memory cell, interlayer insulating films (IL1, IL2, IL3, IL4) are formed. In these films, plugs (P1, P2) and wirings (M1, M2) are formed.

In the above-described memory cell, note that the configuration of the memory array (FIGs. 4 to 6) and operations of the memory cell (FIGs. 7 to 12) are the same as those of the first embodiment, and therefore, the description thereof will be omitted.

Moreover, in the semiconductor device, in addition to the memory cell region MA, a peripheral circuit region PA in which a peripheral circuit is formed may be provided. Since the configuration of the peripheral transistor formed in the peripheral circuit region PA is the same as that of the first embodiment, the description thereof will be omitted (see FIG 21).

### [Description of Manufacturing Method]

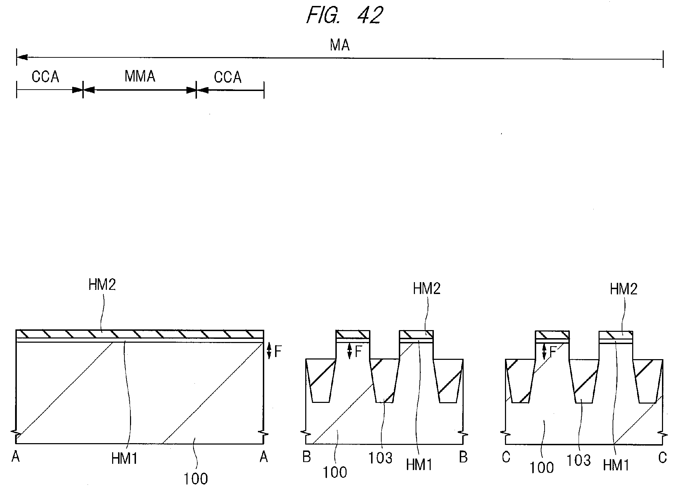

Subsequently, with reference to FIGs. 42 to 55, a method of manufacturing the semiconductor device of the present embodiment will be described, and besides, a configuration of the semiconductor device will be more clarified. Each of FIGs. 42 to 55 is a cross-sectional view showing manufacturing processes of the semiconductor device of the present embodiment. Note that the differences from the first embodiment will be mainly described in detail.

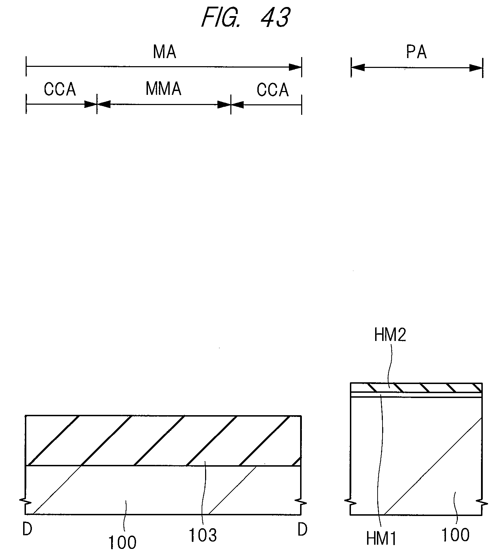

First, as shown in FIGs. 42 and 43, by etching the semiconductor substrate 100 while using a silicon oxide film HM1 and a silicon nitride film HM2 as masks, an element isolation trench is formed. Subsequently, an insulating film such as a silicon oxide film is buried inside the element isolation trench, and the surface of the element isolation region 103 is receded by etching the surface of the insulating film. Thus, the fin F can be formed (see hatching portions in FIG 4). At this time, it is preferable to form the bottom surface of the memory gate electrode part MG formed on the element isolation region 103 to be upper than the position of the half height of the fin F. Note that the fin F is formed also in the peripheral circuit region PA.

Subsequently, the silicon nitride film HM2 is removed, a p-type impurity (for example, boron (B) or others) is ion-implanted thereto by using the silicon oxide film HM1 as a through film, so that a p-type well (not shown) is formed.

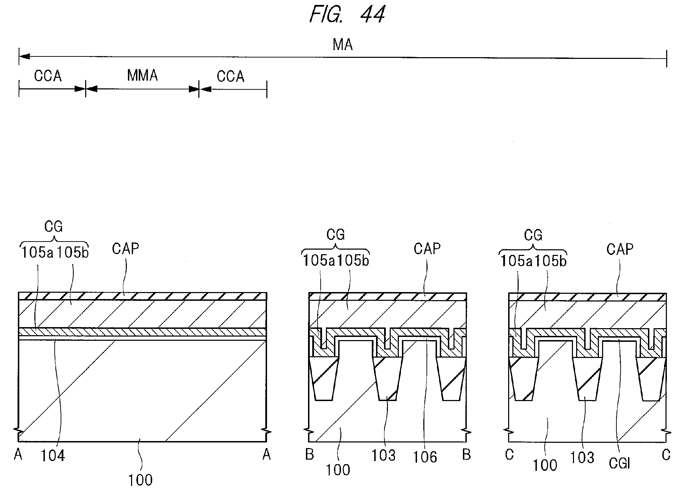

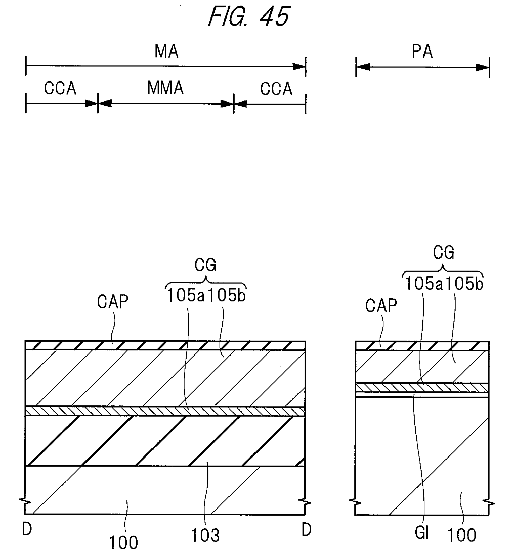

Subsequently, as shown in FIGs. 44 and 45, the silicon oxide film HM1 is removed, and then, an insulating film 104 (CGI, GI), which becomes the control gate insulating film CGI and the gate insulating film GI, is formed on the semiconductor substrate 100 (fin F) by, for example, a thermal oxidation process.

Subsequently, on the insulating film 104, a conductive film for the control gate electrode part CG and the gate electrode part GE is formed. For example, a stacked film of a silicon germanium film 105a having a film thickness of about 8 nm and a polysilicon film 105b having a film thickness of about 60 nm is formed. That is, the control gate electrode part CG is formed of the silicon germanium film 105a and the polysilicon film 105b. Moreover, the gate electrode part GE is formed of the silicon germanium film 105a and the polysilicon film 105b. These films are formed by using, for example, a CVD method or others. Subsequently, the cap insulating film CAP is formed on the polysilicon film 105b. For example, on the polysilicon film 105b, a silicon nitride film having a thickness of about 20 nm is formed by using a CVD method or others.

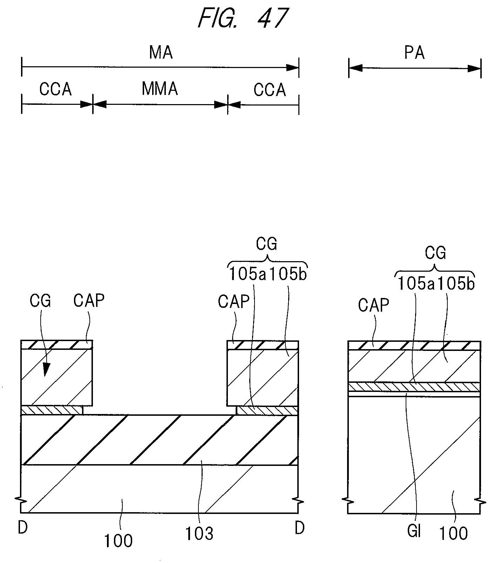

Subsequently, as shown in FIGs. 46 and 47, the insulating film 104, the silicon germanium film 105a, the polysilicon film 105b and the cap insulating film CAP in the region MMA are removed by using a photolithography technique and a dry etching technique. Thus, from side surfaces exposed to the region MMA, the silicon germanium film 105a and the polysilicon film 105b are exposed. Subsequently, the silicon germanium film 105a is selectively etched by about 8 nm by wet etching. Thus, a hollow portion R is formed below the polysilicon film 105b.

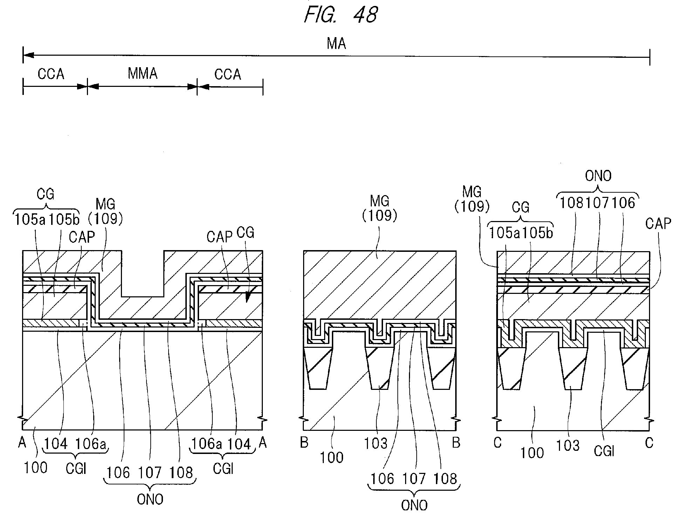

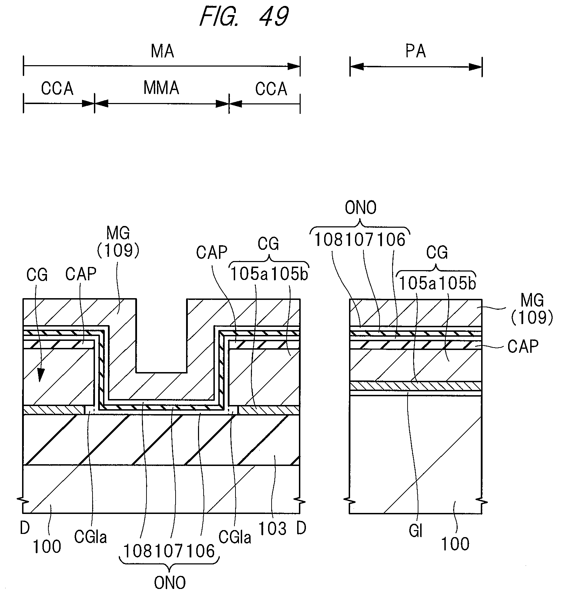

Subsequently, as shown in FIGs. 48 and 49, the insulating films ONO (106, 107, 108) are formed. First, on the semiconductor substrate 100 (fin F) including the control gate electrode part CG, for example, a silicon oxide film is formed as the lower layer insulating film 106. The silicon oxide film is formed so as to have a film thickness of, for example, about 4 nm by using a CVD method or others. Here, the silicon oxide film serving as the lower layer insulating film 106 is also formed inside the hollow portion R below the polysilicon film 105b. Therefore, in the end portion of the control gate insulating film CGI on the memory gate electrode part MG side, the insulating film 104 and the silicon oxide film serving as the lower layer insulating film 106 are stacked. As described above, the insulating film 104 is a silicon oxide film (thermal-oxide film) formed by, for example, a thermal oxidation method, and the lower-layer insulating film 106 to be stacked thereon is a silicon oxide film (deposit film) formed by a deposition method.

Subsequently, on the lower layer insulating film 106, for example, a silicon nitride film is formed as a middle layer insulating film 107 to be deposited to have a thickness of about 7 nm by a CVD method or others. The middle layer insulating film 107 functions as a charge accumulating part of a memory cell. Subsequently, on the middle layer insulating film 107, an upper layer insulating film 108 is formed. Subsequently, on the middle layer insulating film 107, for example, a silicon oxide film is deposited as the upper layer insulating film 108 to have a thickness of about 9 nm by a CVD method or others.

Subsequently, on the insulating film ONO (106, 107, 108), a conductive film 109 which becomes the memory gate electrode part MG is formed. For example, on the insulating film ONO (106, 107, 108), a polysilicon film 105b having a thickness of about 40 nm is deposited as the conductive film 109 by a CVD method or others.

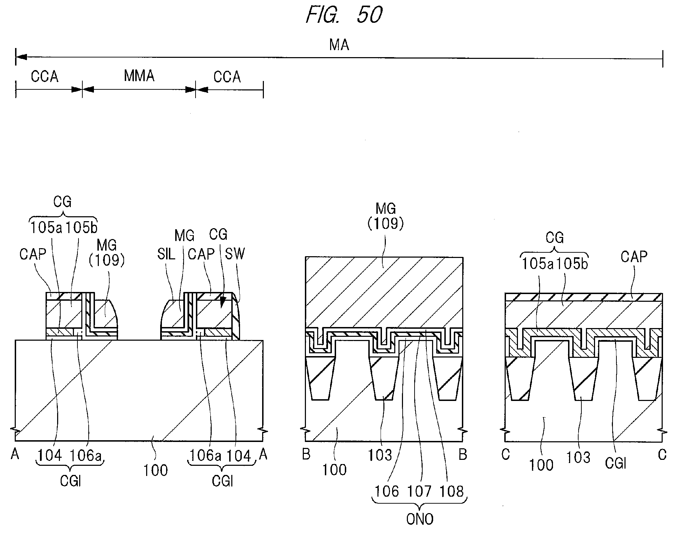

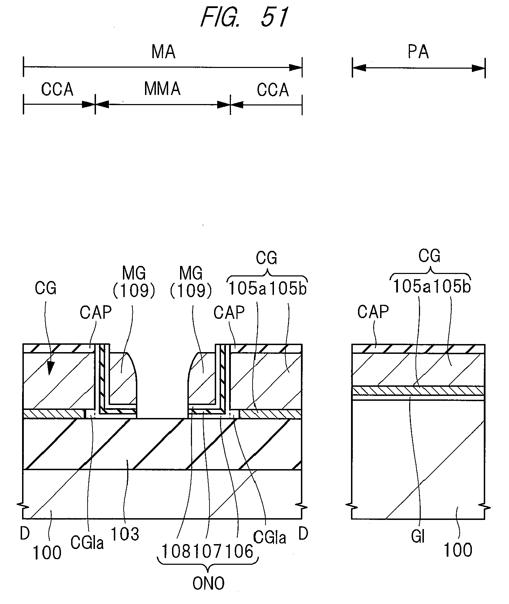

Subsequently, as shown in FIGs. 50 and 51, a side-wall-form memory gate electrode part MG is formed along the side wall of the control gate electrode part CG For example, the polysilicon film 105b is removed by a predetermined film thickness from the surface thereof by anisotropic dry etching.

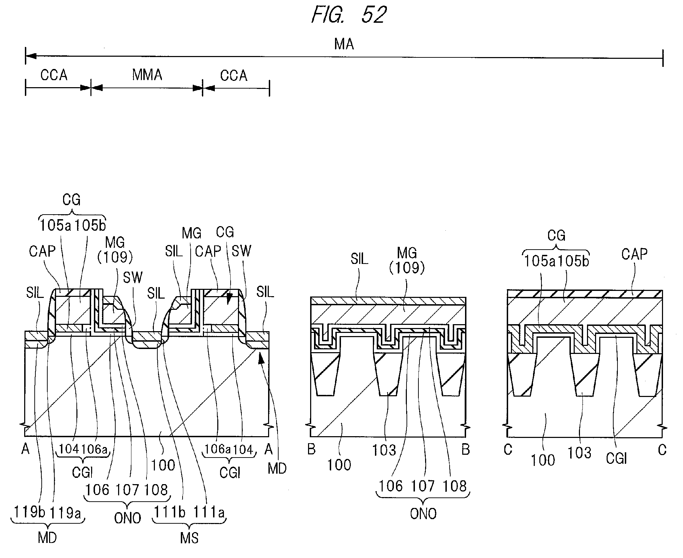

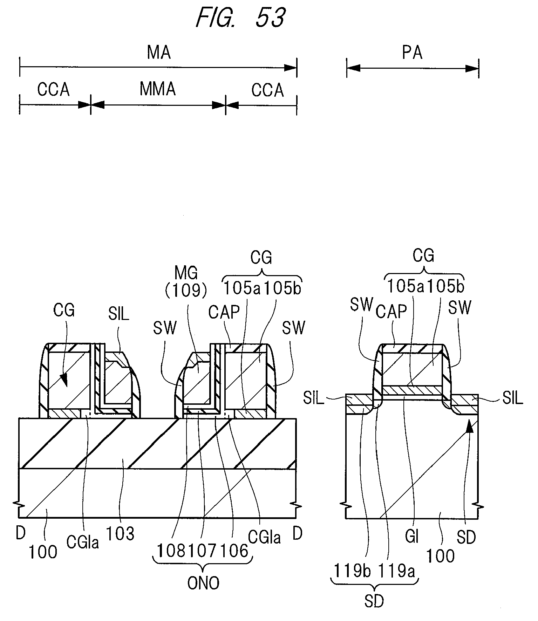

Subsequently, as shown in FIGs. 52 and 53, in the peripheral circuit region PA, the gate insulating film GI and the gate electrode part GE are formed. For example, by using a photolithography technique and a dry etching technique, the insulating film 104 (GI), the polysilicon film 105b, the silicon germanium film 105a and the cap insulating film CAP in the peripheral circuit region PA are processed. Thus, the gate electrode part GE formed of a stacked film of the silicon germanium film 105a and the polysilicon film 105b is formed.

Subsequently, a source region MS and a drain region MD are formed in the memory cell region MA, and a source/drain region SD is formed in the peripheral circuit region PA. These regions can be formed as similar to the first embodiment.

Subsequently, a metal silicide film SIL is formed on the memory gate electrode part MG, the source region MS, the drain region MD, and the source/drain region SD by using a salicide technique. The metal silicide film SIL can be formed as similar to the first embodiment.

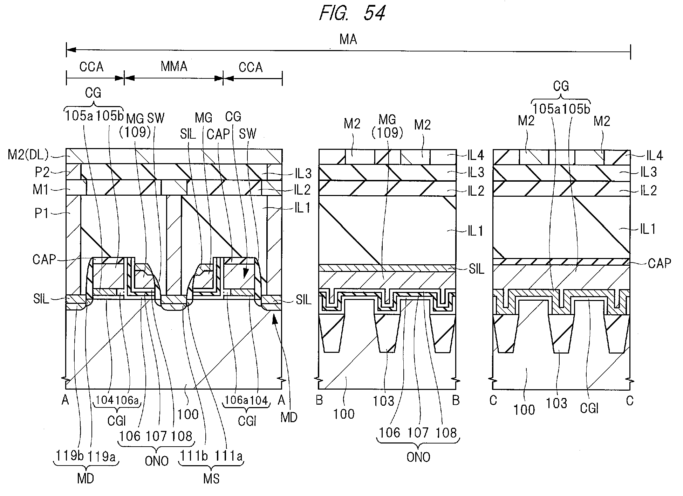

After that, as shown in FIGs. 54 and 55, the interlayer insulating films (IL1, IL2, IL3 and IL4), the plugs (P1 and P2), and the wirings (M1 and M2) are formed above the control gate electrode part CG, the memory gate electrode part MG, the gate electrode part GE, and others. The interlayer insulating films, the plugs, and the wirings can be formed as similar to the first embodiment.

By the above-described manufacturing process, the semiconductor device according to the present embodiment can be formed.

### (Third Embodiment)

In the semiconductor device of the first embodiment, the gate electrode part GE of the peripheral transistor is formed by the same film as that of the control gate electrode part CG However, the gate electrode part GE of the peripheral transistor may be formed by a film different from that of the control gate electrode part CG

Hereinafter, with respect to drawings, a structure of a semiconductor device of the present embodiment will be described.

### [Description of Structure]

A semiconductor device of the present embodiment has a memory cell (memory transistor, control transistor) formed in a memory cell region MA and a peripheral transistor formed in a peripheral circuit region PA.

### (Description of Memory Cell Structure)

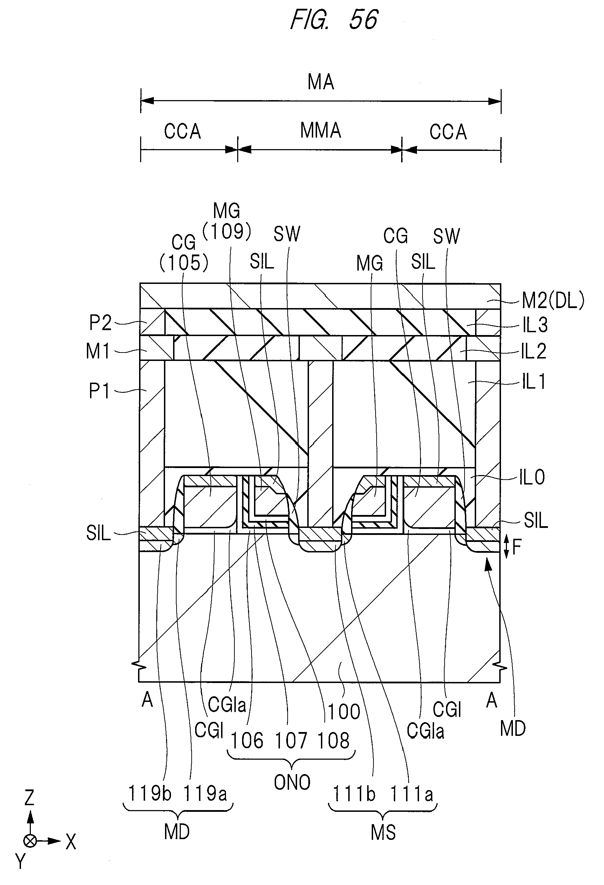

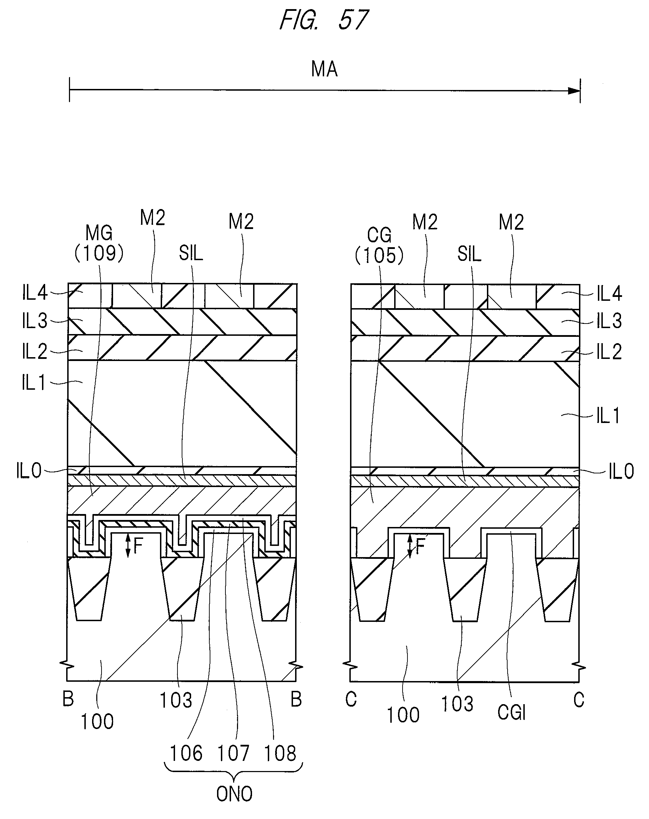

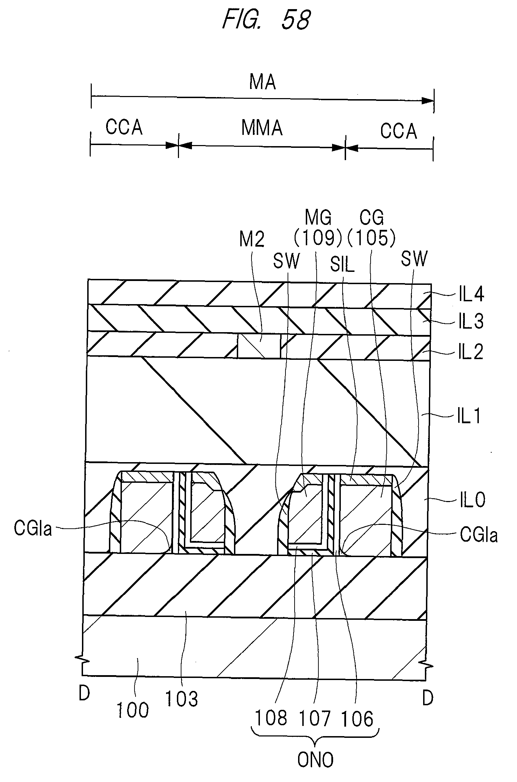

Each of FIGs. 56 to 58 is a cross-sectional view showing the semiconductor device of the present embodiment. The structure of the present embodiment is different from that of the first embodiment in that not the cap insulating film CAP but the metal silicide film SIL is placed on the control gate electrode part CG

As shown in FIGs. 56 to 58, the memory cell (memory element) is formed of a control transistor having the control gate electrode part CG and a memory transistor having the memory gate electrode part MG

More specifically, the memory cell has the control gate electrode part CG placed on the semiconductor substrate 100 (fin F) and the memory gate electrode part MG which is placed on the semiconductor substrate 100 (fin F) and which is adjacent to the control gate electrode part CG

The control gate electrode part CG and the memory gate electrode part MG are placed on the rectangular-parallelepiped-shape fin F via a gate insulating film. The fin F is made of an upper portion of the semiconductor substrate 100 (fin F), and a plane shape of the fin F has a line shape (rectangular shape having its longer side in an X-direction) having a certain width (length in a Y-direction).

The control gate electrode part CG and the memory gate electrode part MG extend in the Y-direction (direction intersecting an A-A cross-sectional portion, that is, vertical direction in the paper) so as to cross the fin F (see FIG 4).

Each of the memory gate electrode part MG and the control gate electrode part CG is formed of, for example, a polysilicon film.

And, the control gate insulating film CGI is placed between the control gate electrode part CG and the semiconductor substrate 100 (fin F). This control gate insulating film CGI is formed of, for example, a silicon oxide film. And, this control gate insulating film CGI has a thick film portion CGIa in its end portion on the memory gate electrode part MG side.

In this manner, by increasing the film thickness of the end portion of the control gate insulating film CGI on the memory gate electrode part MG side, the retention property (charge holding property) of the memory cell can be improved as explained in the first embodiment.

The memory cell further has the insulating films ONO (106, 107, 108) placed between the memory gate electrode part MG and the semiconductor substrate 100 (fin F).

Moreover, the memory cell further has a drain region MD and a source region MS formed in the fin F of the semiconductor substrate 100. Furthermore, a metal silicide film SIL is formed on the upper portions of the drain region MD (n⁺-type semiconductor region 119b), the source region MS (n⁺-type semiconductor region 111b), etc. And, a metal silicide film SIL is formed on the upper portion of the memory gate electrode part MG and the control gate electrode part CG

Furthermore, on the memory cell, interlayer insulating films (IL1, IL2, IL3, IL4) are formed. In these films, plugs (P1, P2) and wirings (M1, M2) are formed.

In the above-described memory cell, note that the configuration of the memory array (FIGs. 4 to 6) and operations of the memory cell (FIGs. 7 to 12) are the same as those of the first embodiment, and therefore, the description thereof will be omitted.

Moreover, in the semiconductor device, in addition to the memory cell region MA, a peripheral circuit region PA in which a peripheral circuit is formed may be provided. The configuration of the peripheral transistor formed in the peripheral circuit region PAwill be described below.

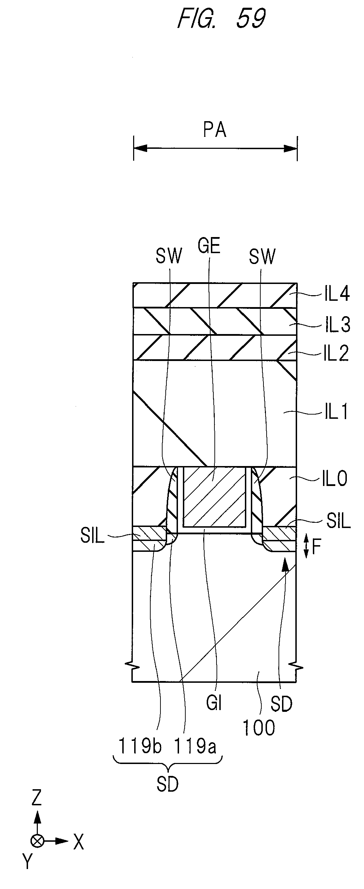

FIG 59 is a cross-sectional view showing a semiconductor device of the present embodiment. In FIG 59, the cross-sectional surface of the peripheral transistor formed in the peripheral circuit region PA is shown.

As shown in FIG 59, the peripheral transistor has a gate electrode part GE placed above the semiconductor substrate 100 (fin F), and a source/drain region SD formed in the semiconductor substrate 100 (fins F) on both sides of the gate electrode part GE. Each fin F is formed of the upper portion of the semiconductor substrate 100, and the plane shape of the fin F has a line shape (rectangular shape having its longer side in the X-direction) having a certain width (length in the Y-direction). The gate electrode part GE extends in the Y-direction (direction intersecting an A-A cross sectional portion, that is, vertical direction in the paper) so as to cross the fin F.

As the gate electrode part GE, for example, a film different from that of the control gate electrode part CG can be used. Moreover, the peripheral transistor has a gate insulating film GI placed between the gate electrode part GE and the semiconductor substrate 100 (fin F). As the gate insulating film GI, a film different from the control gate insulating film CGI can be used.

For example, as the gate insulating film GI, a stacked film of a thermal-oxide film and a high-k insulating film can be used. Moreover, as the gate electrode part GE, a metal electrode film can be formed. As the metal electrode film, a stacked film made of tantalum nitride/titanium/aluminum can be used. In this manner, an insulating film having a high dielectric constant film can be used as the gate insulating film GI, and a conductive film having a metal film or a metal alloy film can be used as the gate electrode part GE.

Moreover, the gate insulating film GI is formed on the bottom surface and side wall of the concave portion formed in an interlayer insulating film IL0. Moreover, the gate electrode part GE is buried inside the concave portion via the gate insulating film GI.

On the side wall portion of the gate electrode part GE, a sidewall insulating film SW made of an insulating film is formed. The source/drain region SD is made of an n⁺-type semiconductor region 119b and an n⁻-type semiconductor region 119a. The n⁻-type semiconductor region 119a is formed so as to be self-aligned with respect to the side wall of the gate electrode part GE. Moreover, the n⁺-type semiconductor region 119b is formed so as to be self-aligned with respect to the side surface of the sidewall insulating film SW, and has a deeper junction depth and a higher impurity concentration than those of the n⁻-type semiconductor region 119a. On the upper portion of this source/drain region SD (n⁺-type semiconductor region 119b), a metal silicide film SIL is formed.

Moreover, on the peripheral transistor (cap insulating film CAP), interlayer insulating films IL1, IL2, IL3 and IL4 are formed. Each of these films is made of, for example, a silicon oxide film. In FIG 59, note that plugs and wirings may be formed in the interlayer insulating films (IL1 to IL4) although not shown therein.

### [Description of Manufacturing Method]

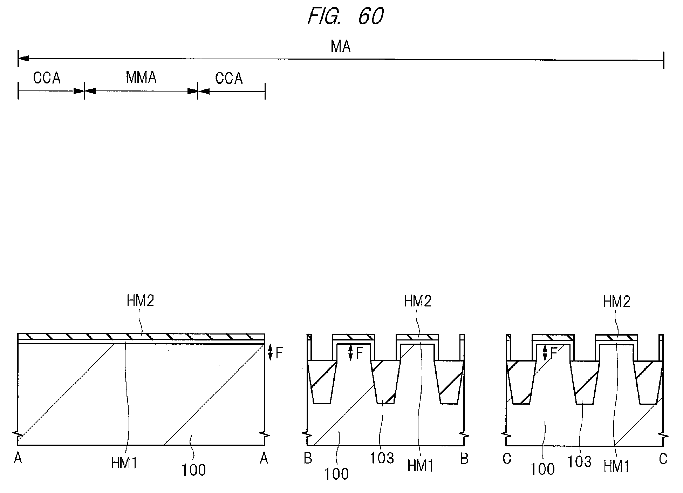

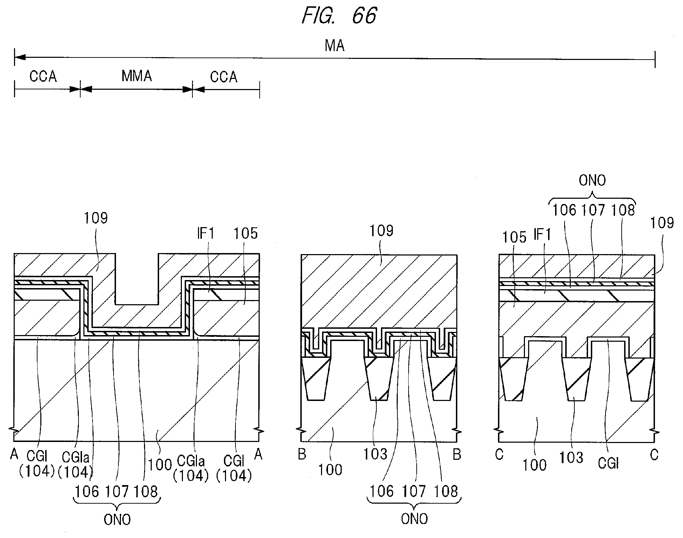

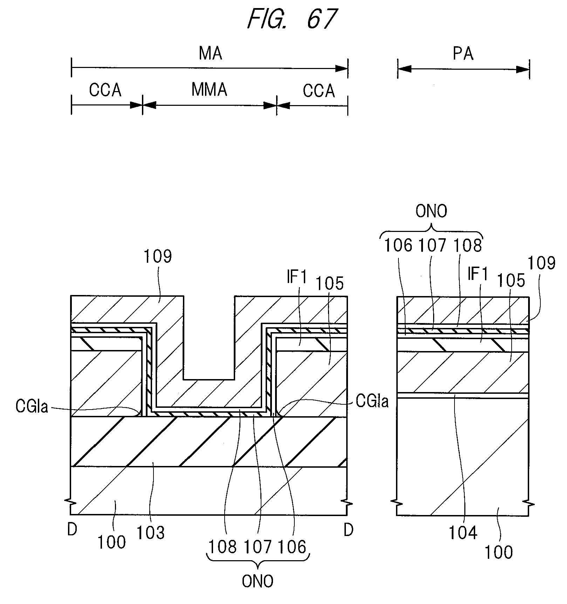

Subsequently, with reference to FIGs. 60 to 85, a method of manufacturing the semiconductor device of the present embodiment will be described, and besides, a configuration of the semiconductor device will be more clarified. Each of FIGs. 60 to 85 is a cross-sectional view showing manufacturing processes of the semiconductor device of the present embodiment. Note that the differences from the first embodiment will be mainly described in detail.

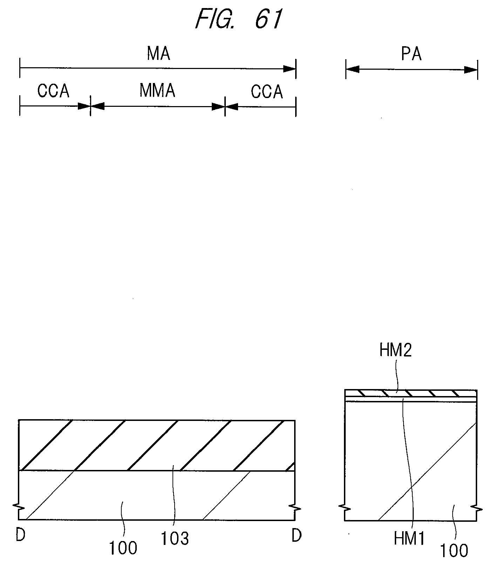

First, as shown in FIGs. 60 and 61, by etching the semiconductor substrate 100 while using a silicon oxide film HM1 and a silicon nitride film HM2 as masks, an element isolation trench is formed. Subsequently, an insulating film such as a silicon oxide film is buried inside the element isolation trench, and the surface of the element isolation region 103 is receded by etching the surface of the insulating film. Thus, the fin F can be formed (see hatching portions in FIG 4). At this time, it is preferable to form the bottom surface of the memory gate electrode part MG formed on the element isolation region 103 to be upper than the position of the half height of the fin F. Note that the fin F is formed also in the peripheral circuit region PA.

Subsequently, the silicon nitride film HM2 is removed, a p-type impurity (for example, boron (B) or others) is ion-implanted thereto by using the silicon oxide film HM1 as a through film, so that a p-type well (not shown) is formed.

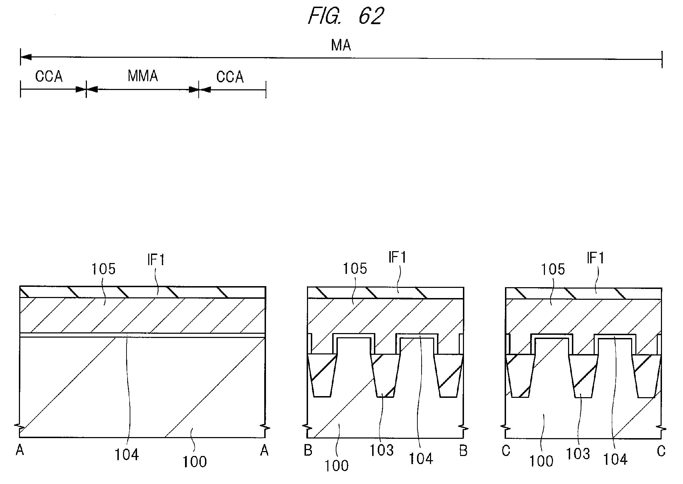

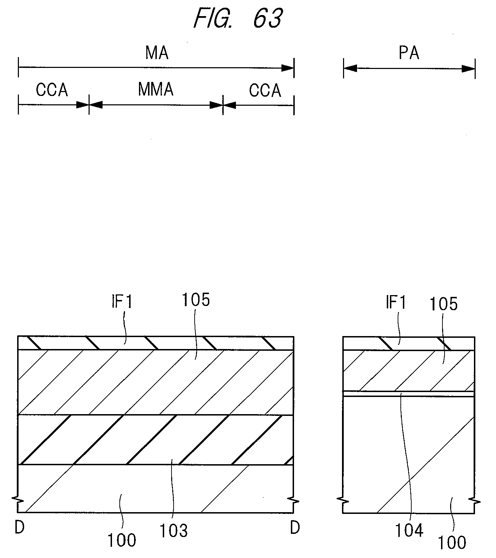

Subsequently, as shown in FIGs. 62 and 63, the silicon oxide film HM1 is removed, and then, an insulating film 104, which becomes the control gate insulating film CGI and the gate insulating film GI, is formed on the semiconductor substrate 100 (fin F) by, for example, a thermal oxidation process.

Subsequently, on the insulating film 104, a polysilicon film for the control gate electrode part CG and the gate electrode part GE is formed by using a CVD method or others. Subsequently, a silicon nitride film having a thickness of about 30 nm is formed on the polysilicon film 105 as an insulating film IF1 by using a CVD method or others.

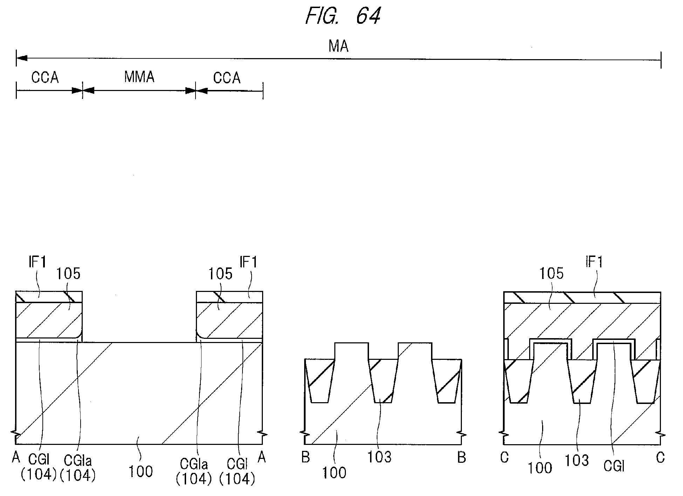

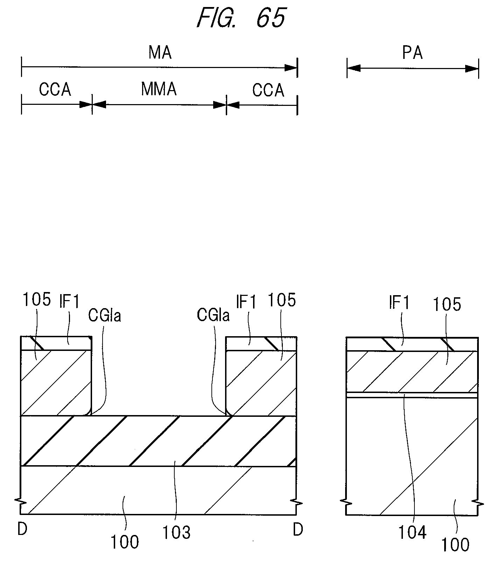

Subsequently, as shown in FIGs. 64 and 65, the insulating film 104, the polysilicon film 105, and the insulating film IF1 in the region MMA are removed by using a photolithography technique and a dry etching technique, and the thermal oxidization is performed, so that the thick film portion CGIa is formed in the end portion of the insulating film 104 exposed from the side surface in the region MMA.

Subsequently, as shown in FIGs. 48 and 49, the insulating films ONO (106, 107, 108) are formed. The insulating films ONO can be formed as similar to those of the first embodiment.

Subsequently, on the insulating film ONO (106, 107, 108), a conductive film (polysilicon film) 109 which becomes the memory gate electrode part MG is formed.

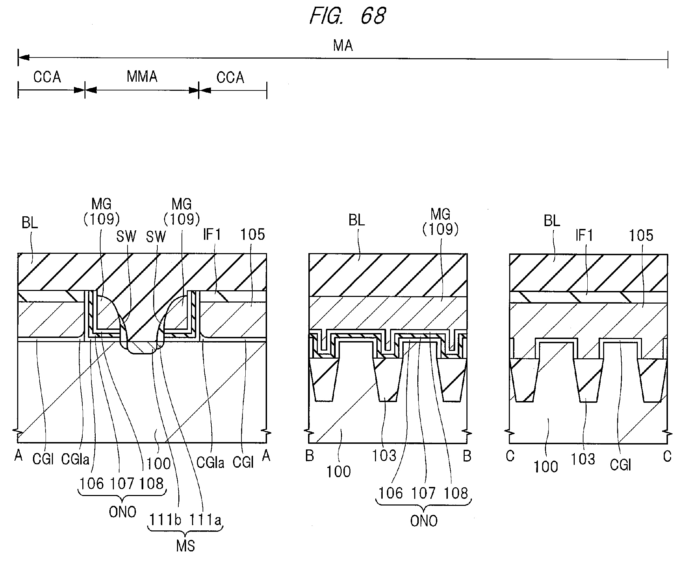

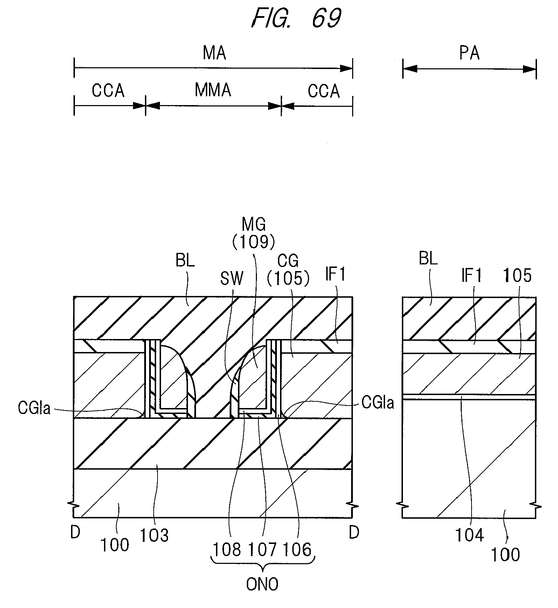

Subsequently, as shown in FIGs. 68 and 69, a side-wall-form memory gate electrode part MG is formed along the side wall of the stacked film of the insulating film 104 and the polysilicon film 105 (CGIa and CGI) in the region CCA (the control gate electrode part CG). For example, the polysilicon film 105b is removed by a predetermined film thickness from the surface thereof by anisotropic dry etching.

Subsequently, an n⁻-type semiconductor region 111a is formed by injecting an n-type impurity such as arsenic (As), phosphorus (P) or others into the semiconductor substrate 100 (fin F) in the region MMA of the memory cell region MA Subsequently, a sidewall film (sidewall insulating film) SW is formed on the side wall portion of the memory gate electrode part MG, and an n⁺-type semiconductor region 111b is formed by injecting the n-type impurity such as arsenic (As), phosphorus (P) or others into the semiconductor substrate 100 (fin F) in the region MMA. By these processes, a source region MS, made of the n⁻-type semiconductor region 111a and the n⁺-type semiconductor region 111b, is formed.

Subsequently, a buried insulating film BL for use in burying the region MMA of the memory cell region MA is formed. For example, on the entire surface of the semiconductor substrate 100, a silicon oxide film, more specifically, an SOG (Spin On Glass) film, is formed as the buried insulating film BL. The SOG film has a high wet-etching rate, and is preferably used for the buried insulating film BL.

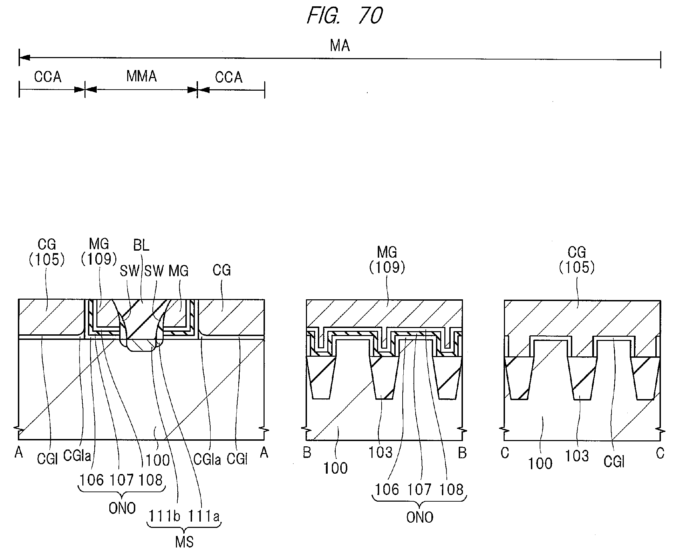

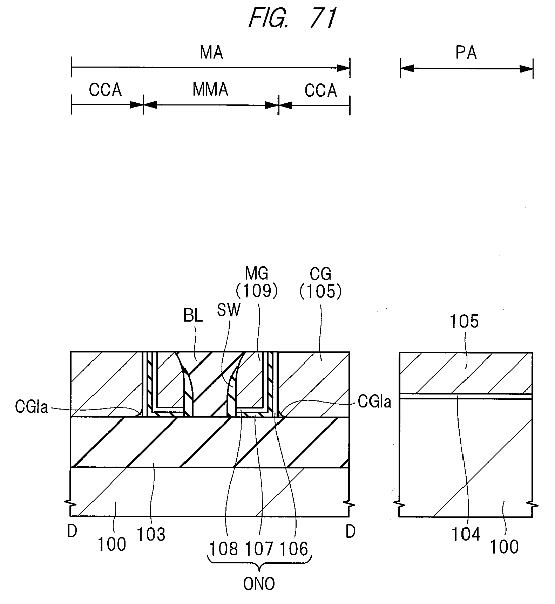

Subsequently, as shown in FIGs. 70 and 71, the upper portion of the SOG film is removed by using a CMP method or others until the memory gate electrode part MG is exposed. For example, the surface height of the SOG film is set to about 50 nm from the surface of the semiconductor substrate 100. By adjusting the surface height of the SOG film, an injecting process of an n-type impurity described later can be easily controlled.

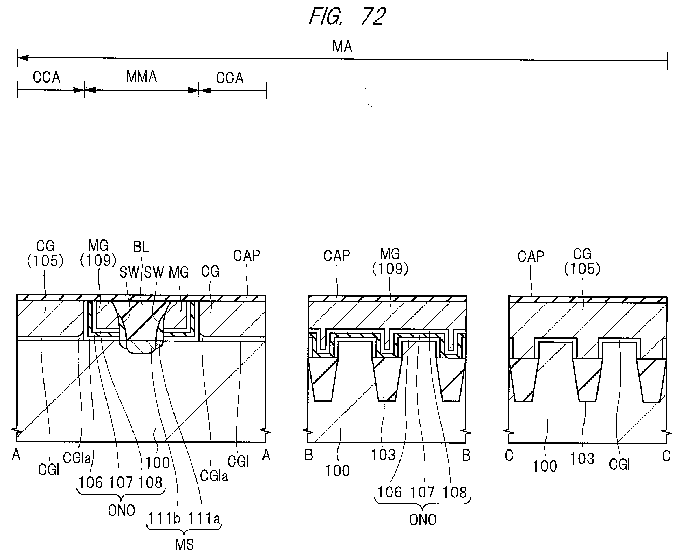

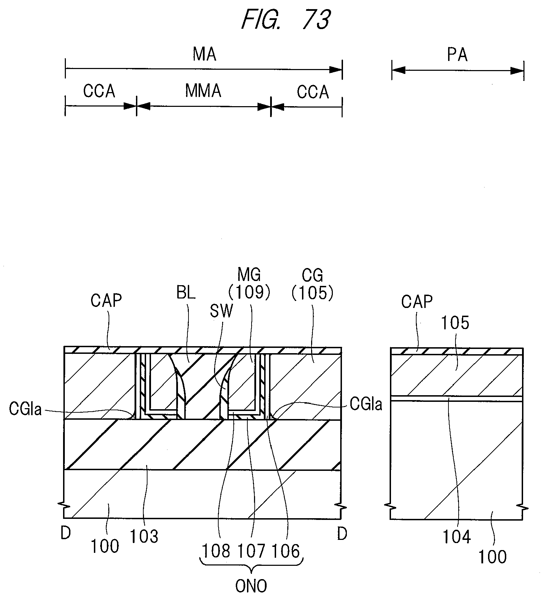

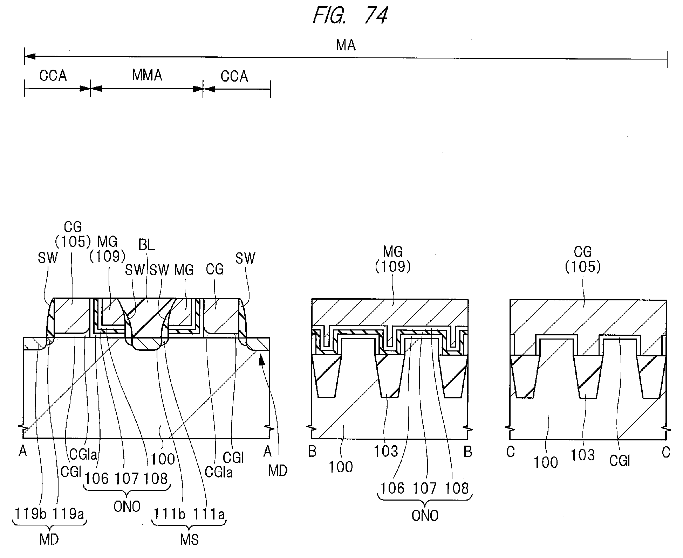

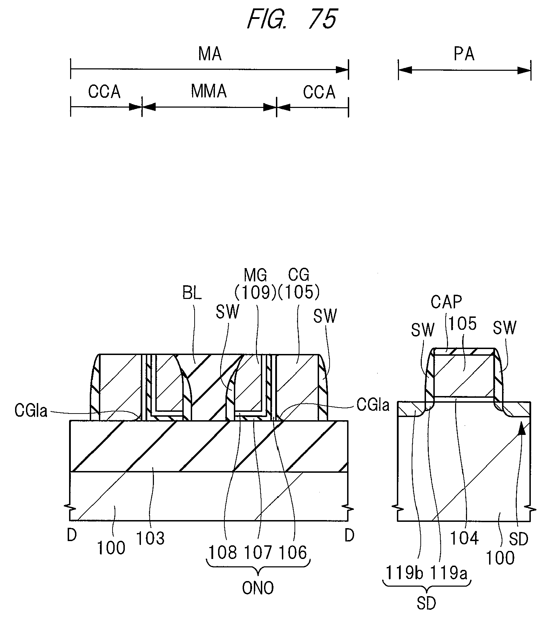

Subsequently, as shown in FIGs. 72 and 73, on the entire surface of the semiconductor substrate 100, a silicon nitride film is formed by a CVD method or others as a cap insulating film CAP. Subsequently, as shown in FIGs. 74 and 75, the control gate electrode part CG is formed by removing the cap insulating film CAP in the memory cell region MA and by processing the insulating film 104 and the polysilicon film 105. Thus, the formation region of the drain region MD is exposed. At this time, also in the peripheral circuit region PA, by processing the insulating film 104, the polysilicon film 105 and the cap insulating film CAP, a stacked film of them (primary gate electrode part) is formed

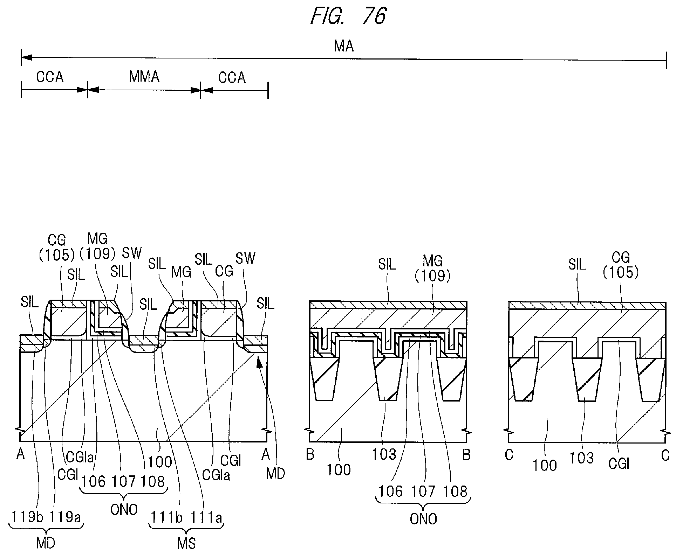

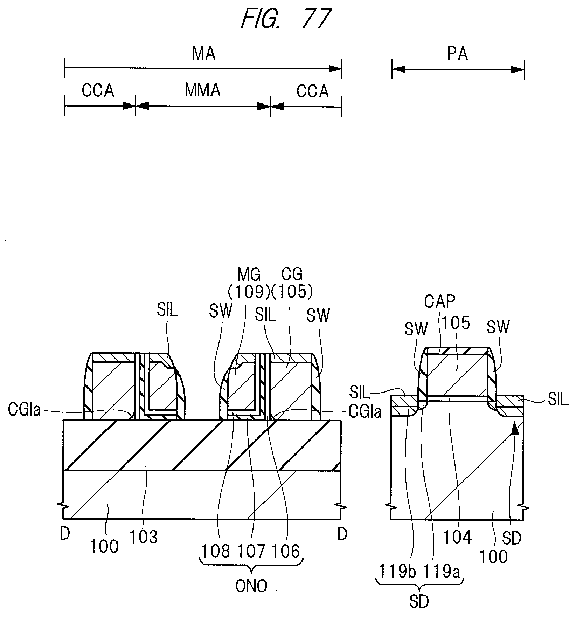

Subsequently, as shown in FIGs. 76 and 77, an n⁻-type semiconductor region 119a is formed by injecting an n-type impurity such as arsenic (As), phosphorus (P) or others into the semiconductor substrate 100 (fin F) in the region CCA and the peripheral circuit region PA Subsequently, a sidewall film (sidewall insulating film) SW is formed on the side wall portions of the control gate electrode part CG and the above-described stacked film (primary gate electrode part) in the peripheral circuit region PA Subsequently, an n⁺-type semiconductor region 119b is formed by injecting the n-type impurity such as arsenic (As), phosphorus (P) or others into the semiconductor substrate 100 (fin F) in the region CCA and the peripheral circuit region PA. By these processes, a drain region MD, made of the n⁻-type semiconductor region 119a and the n⁺-type semiconductor region 119b, is formed. Also, a source/drain region SD, made of the n⁻-type semiconductor region 119a and the n⁺-type semiconductor region 119b, is formed

Subsequently, a metal silicide film SIL is formed on the memory gate electrode part MG, the control gate electrode part CG, the source region MS, the drain region MD, and the source/drain region SD by using a salicide technique. The metal silicide film SIL can be formed as similar to the first embodiment.

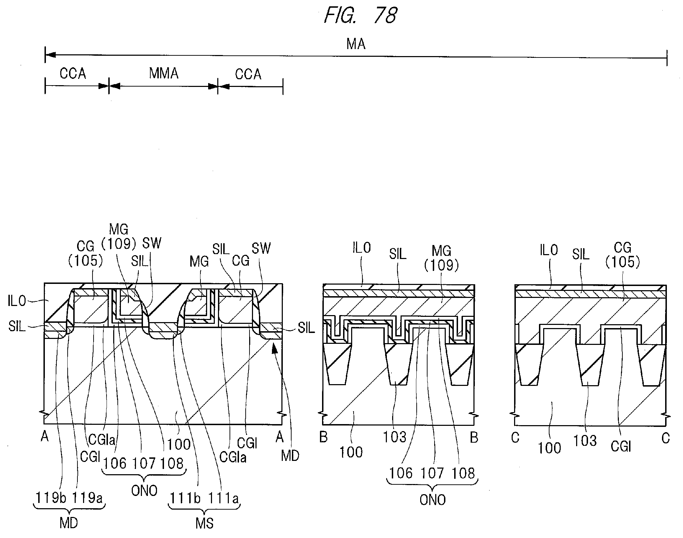

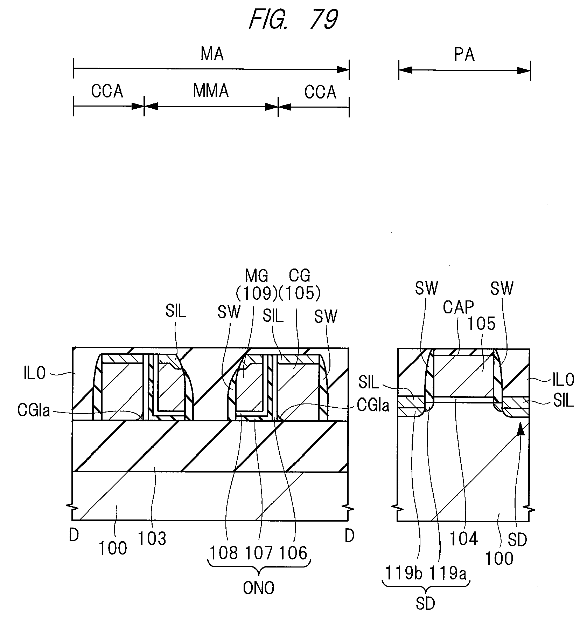

Subsequently, as shown in FIGs. 78 and 79, a silicon oxide film is deposited as the interlayer insulating film IL0 above the control gate electrode part CG, the memory gate electrode part MG, and the above-described stacked film (primary gate electrode part) in the peripheral circuit region PA, by using a CVD method or others. Subsequently, the upper portion of the silicon oxide film IL0 is removed by using a CMP method or others until the cap insulating film CAP is exposed.

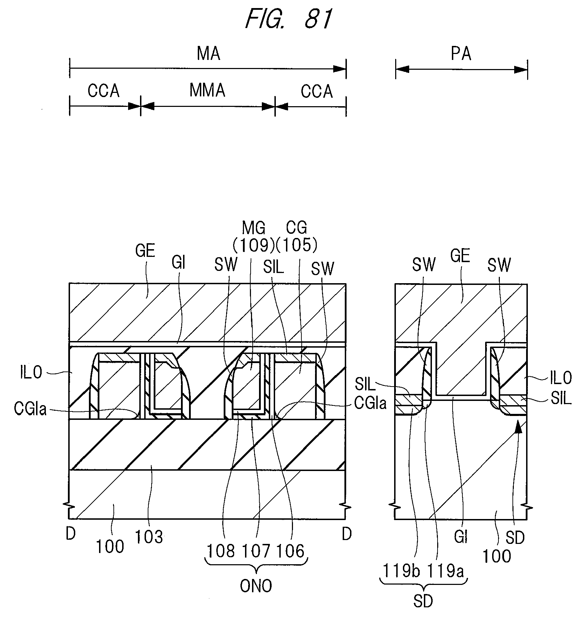

Subsequently, the cap insulating film CAP, and the polysilicon film 105 and the insulating film 104 in the peripheral circuit region PA, are removed by etching. By this process, a concave portion (trench) is formed in the gate electrode part formation region of the peripheral transistor (see FIG 81).

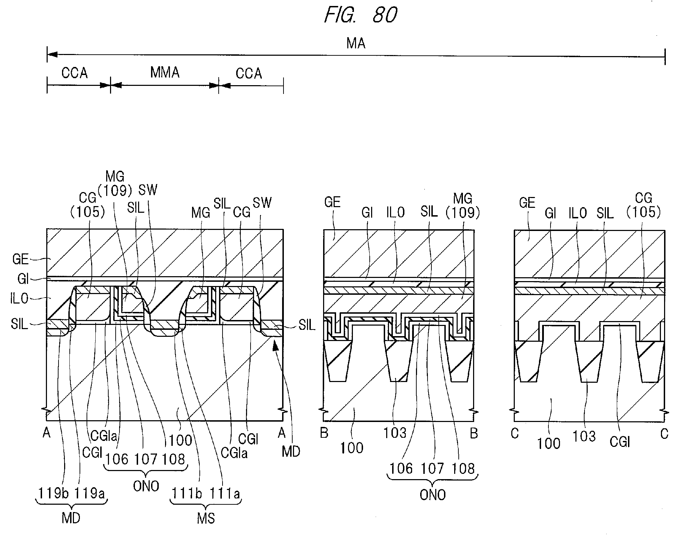

Subsequently, as shown in FIGs. 80 and 81, the gate insulating film GI of the peripheral transistor is formed in the concave portion. For example, the gate insulating film GI is made of a stacked film of a thermal-oxide film and a high-k insulating film. For example, by thermal oxidation on the bottom surface of the concave portion, a silicon oxide film having a film thickness of about 1 nm is formed, and an Hf oxide film having a film thickness of about 5 nm is formed as the high-k insulating film on the silicon oxide film and on the side wall of the concave portion by using a CVD method or others.

Subsequently, on the gate insulating film GI, a metal electrode film to be the gate electrode part GE is formed. For example, after forming a titanium nitride film on the gate insulating film GI as a barrier film (not shown), a metal electrode film is deposited on this titanium nitride film. As the metal electrode film, a stacked film having a film thickness of about 20 nm made of tantalum nitride/titanium/aluminum can be used. These films can be formed by, for example, a sputtering method or others. When a p-channel type MISFET is formed as the peripheral transistor, note that a stacked film having a film thickness of about 20 nm made of tantalum nitride/titanium nitride/tantalum nitride can be used as the metal electrode film.

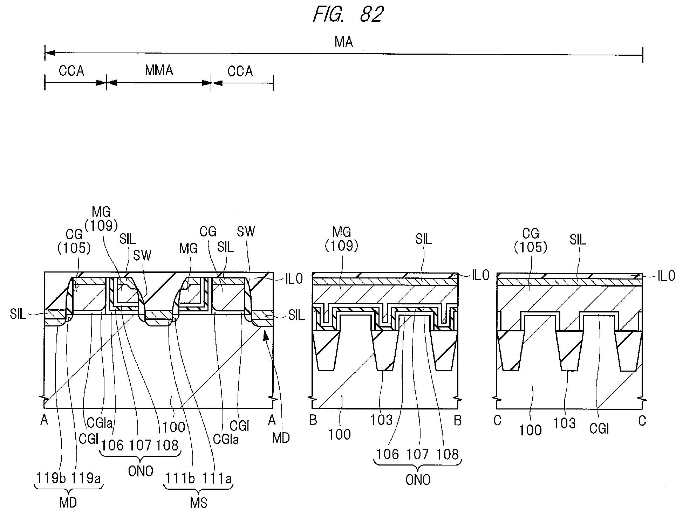

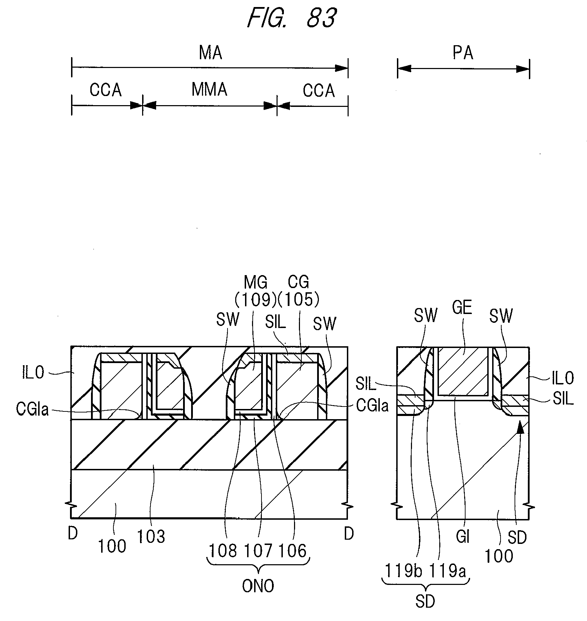

Subsequently, as shown in FIGs. 82 and 83, the stacked film of the thermal-oxide film and the high-k insulating film, and the metal electrode film, are removed by using a CMP method or others until the surface of the interlayer insulating film IL0 is exposed. By this process, in the concave portion, the gate insulating film GI and the gate electrode part GE are formed. The structural part of such gate insulating film GI and gate electrode part GE is referred to as a high-k/metal structure.

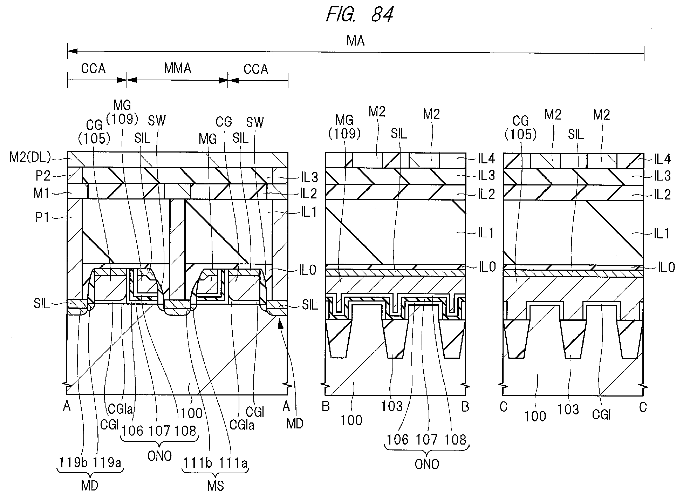

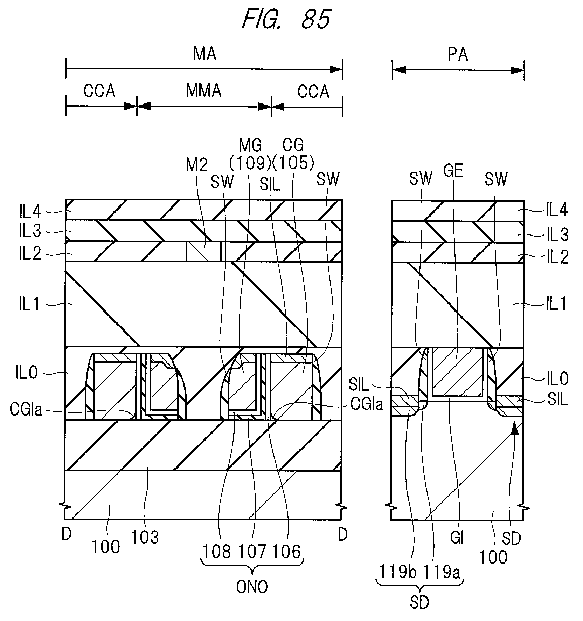

After that, as shown in FIGs. 84 and 85, interlayer insulating films (IL1, IL2, IL3, IL4), the plugs (P1, P2), and the wirings (M1, M2) are formed above the control gate electrode part CG, the memory gate electrode part MG, the gate electrode part GE, and others by a CVD method or others. The interlayer insulating films, the plugs, and the wirings can be formed as similar to those of the first embodiment.

By the above-described manufacturing process, the semiconductor device according to the present embodiment can be formed.

### (Fourth Embodiment)

In the semiconductor device of the first embodiment, the control gate insulating film CGI is prepared as a single layer thermal-oxide film. However, a flat portion and a thick film portion of the control gate insulating film CGI may be prepared as different films from each other (a thermal-oxide film and a deposit film).

Hereinafter, with respect to drawings, a structure of a semiconductor device of the present embodiment will be described.

### [Description of Structure]

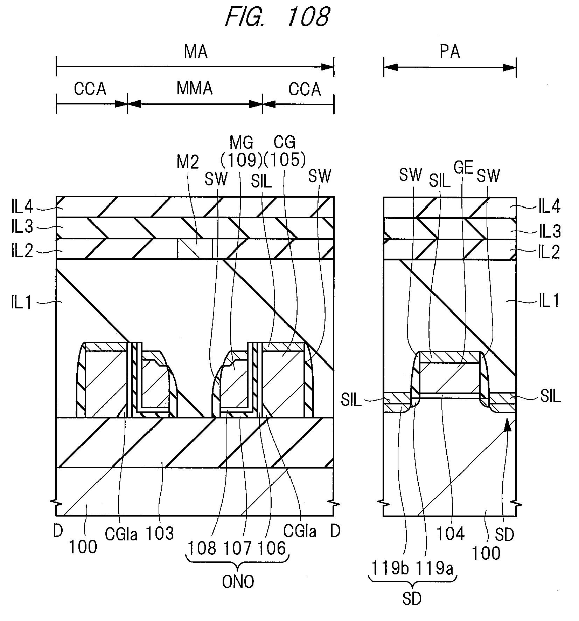

A semiconductor device of the present embodiment has a memory cell (memory transistor, control transistor) formed in a memory cell region MA and a peripheral transistor formed in a peripheral circuit region PA (see FIG 108).

### (Description of Memory Cell Structure)

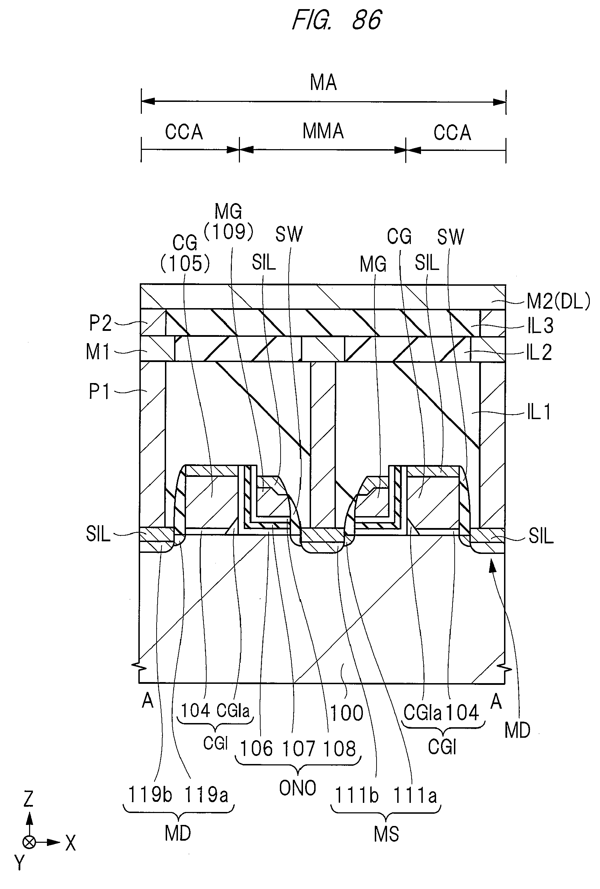

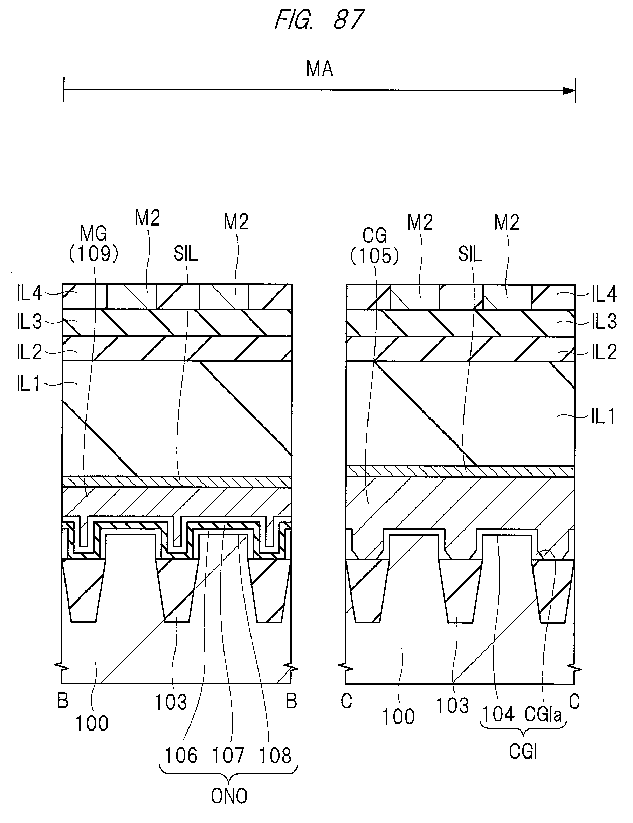

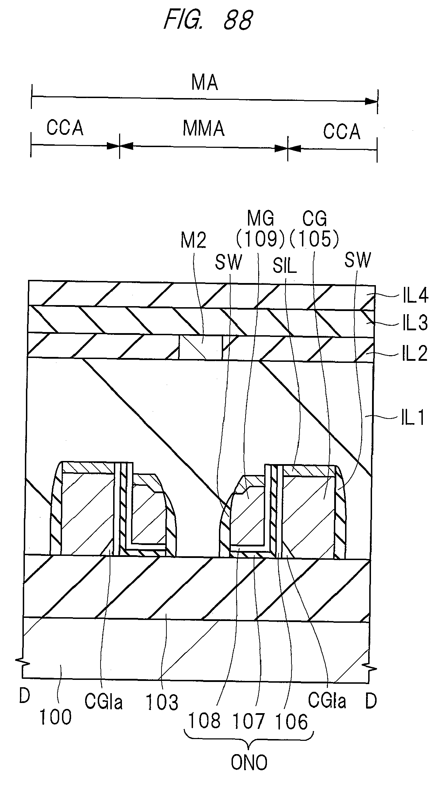

Each of FIGs. 86 to 88 is a cross-sectional view showing the semiconductor device of the present embodiment.

As shown in FIGs. 86 to 88, the memory cell (memory element) is formed of a control transistor having the control gate electrode part CG and a memory transistor having the memory gate electrode part MG

More specifically, the memory cell has the control gate electrode part CG placed on the semiconductor substrate 100 (fin F) and the memory gate electrode part MG which is placed on the semiconductor substrate 100 (fin F) and which is adjacent to the control gate electrode part CG

The control gate electrode part CG and the memory gate electrode part MG are placed on the rectangular-parallelepiped-shape fin F via a gate insulating film. The fin F is made of an upper portion of the semiconductor substrate 100 (fin F), and a plane shape of the fin F has a line shape (rectangular shape having its longer side in an X-direction) having a certain width (length in a Y-direction).

The control gate electrode part CG and the memory gate electrode part MG extend in the Y-direction (direction intersecting an A-A cross-sectional portion, that is, vertical direction in the paper) so as to cross the fin F (see FIG 4).

Each of the memory gate electrode part MG and the control gate electrode part CG is formed of, for example, a polysilicon film.

And, the control gate insulating film CGI is placed between the control gate electrode part CG and the semiconductor substrate 100 (fin F). This control gate insulating film CGI is formed of, for example, a silicon oxide film. And, this control gate insulating film CGI has a flat portion (lateral portion) in which the film thickness is almost the same and a thick film portion CGIa having a film thickness larger than that of the flat portion and being located in its end portion on the memory gate electrode part MG side.

In this manner, by increasing the film thickness of the end portion of the control gate insulating film CGI on the memory gate electrode part MG side, the retention property (charge holding property) of the memory cell can be improved as explained in the first embodiment.

The memory cell further has the insulating films ONO (106, 107, 108) placed between the memory gate electrode part MG and the semiconductor substrate 100 (fin F).

Moreover, the memory cell further has a drain region MD and a source region MS formed in the fin F of the semiconductor substrate 100. Furthermore, a metal silicide film SIL is formed on the upper portions of the drain region MD (n⁺-type semiconductor region 119b), the source region MS (n⁺-type semiconductor region 111b), etc. And, a metal silicide film SIL is formed on the upper portion of the memory gate electrode part MG and the control gate electrode part CG

Furthermore, on the memory cell, interlayer insulating films (IL1, IL2, IL3, IL4) are formed. In these films, plugs (P1, P2) and wirings (M1, M2) are formed.

In the above-described memory cell, note that the configuration of the memory array (FIGs. 4 to 6) and operations of the memory cell (FIGs. 7 to 12) are the same as those of the first embodiment, and therefore, the description thereof will be omitted.

Moreover, in the semiconductor device, in addition to the memory cell region MA, a peripheral circuit region PA in which a peripheral circuit is formed may be provided. The configuration of the peripheral transistor formed in the peripheral circuit region PA is the same as that in the case of the first embodiment, and therefore, the description thereof is omitted (see FIG 21).

### [Description of Manufacturing Method]

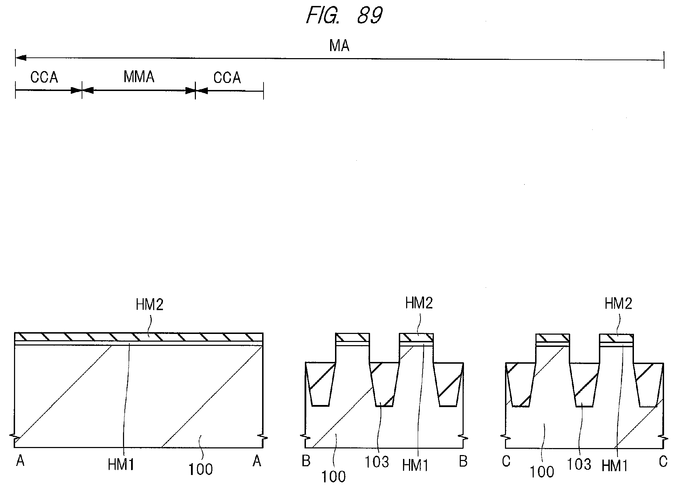

Subsequently, with reference to FIGs. 89 to 108, a method of manufacturing the semiconductor device of the present embodiment will be described, and besides, a configuration of the semiconductor device will be more clarified. Each of FIGs. 89 to 108 is a cross-sectional view showing manufacturing processes of the semiconductor device of the present embodiment. Note that the differences from the first embodiment will be mainly described in detail.

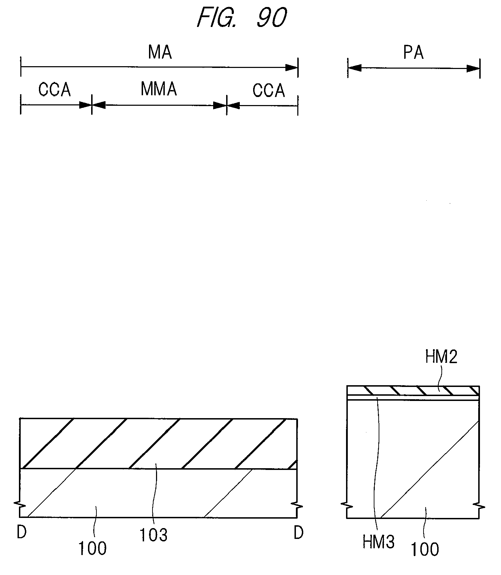

First, as shown in FIGs. 89 and 90, by etching the semiconductor substrate 100 while using a silicon oxide film HM1 and a silicon nitride film HM2 as masks, an element isolation trench is formed. Subsequently, an insulating film such as a silicon oxide film is buried inside the element isolation trench, and the surface of the element isolation region 103 is receded by etching the surface of the insulating film. Thus, the fin F can be formed (see hatching portions in FIG 4). At this time, it is preferable to form the bottom surface of the memory gate electrode part MG formed on the element isolation region 103 to be upper than the position of the half height of the fin F. Note that the fin F is formed also in the peripheral circuit region PA.

Subsequently, the silicon nitride film HM2 is removed, a p-type impurity (for example, boron (B) or others) is ion-implanted thereto by using the silicon oxide film HM1 as a through film, so that a p-type well (not shown) is formed.

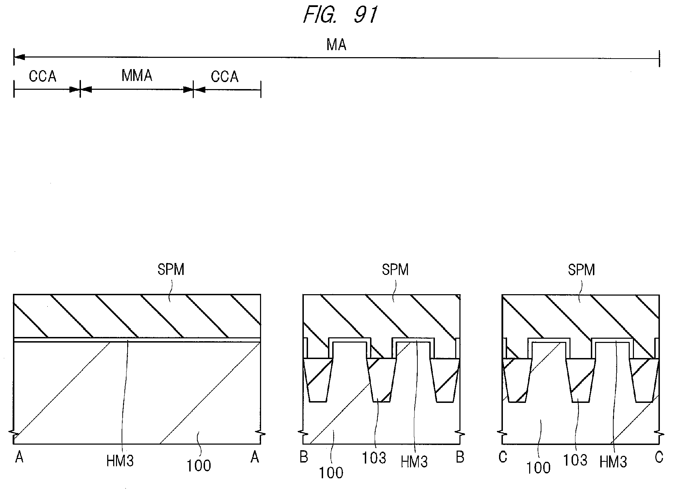

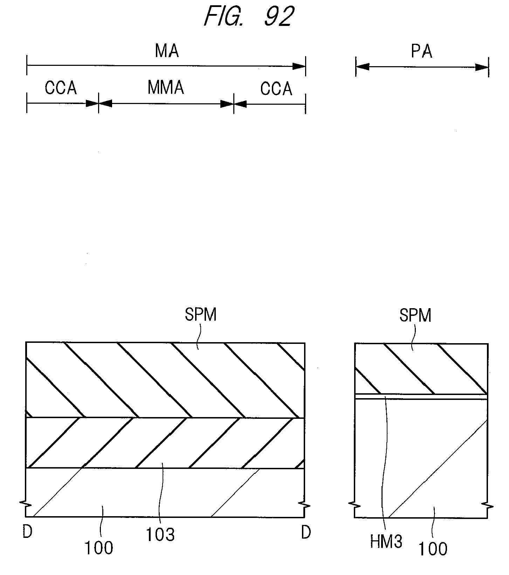

Subsequently, as shown in FIGs. 91 and 92, the silicon oxide film HM1 is removed, and then, the insulating film HM3 is formed on the semiconductor substrate 100 (fin F) by, for example, a thermal oxidation process.

Subsequently, on the insulating film HM3, a silicon nitride film having a thickness of about 80 nm is formed as an insulating film (sacrificed film, insulating film for spacer) SPM by using a CVD method or others.

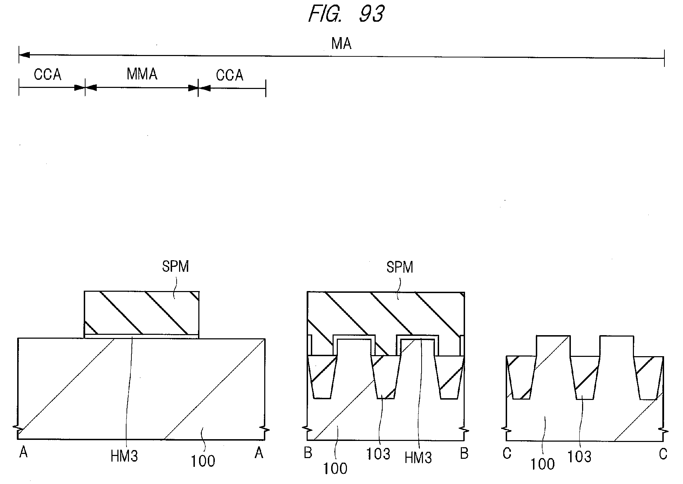

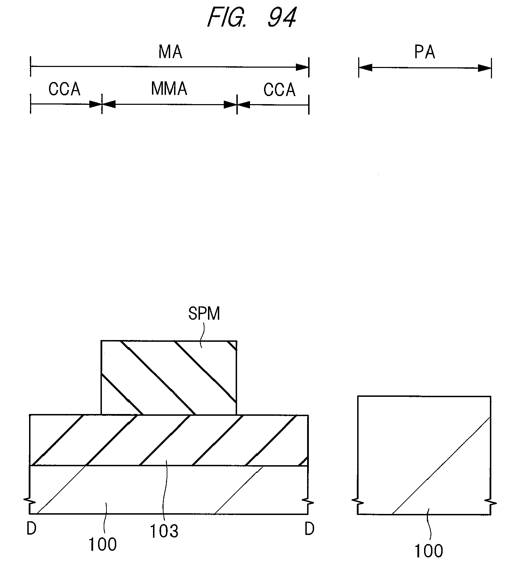

Subsequently, as shown in FIGs. 93 and 94, the insulating films HM3 and SPM in the region CCA and the peripheral circuit region PA are removed by using a photolithography technique and a dry etching technique. Thus, in the region MMA, a stacked film of the insulating films HM3 and SPM is left.

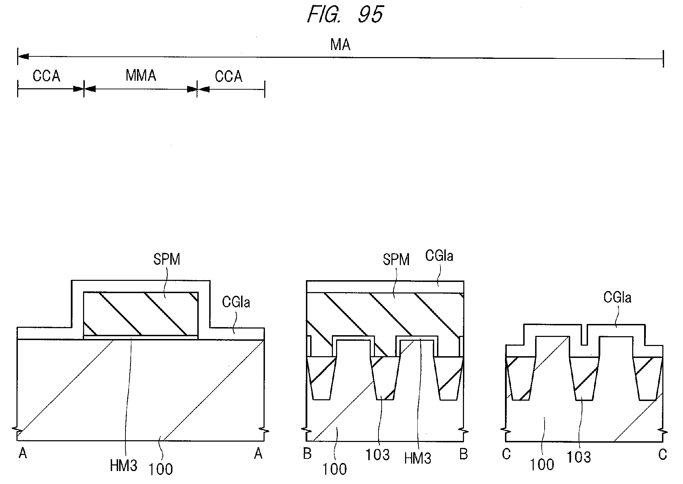

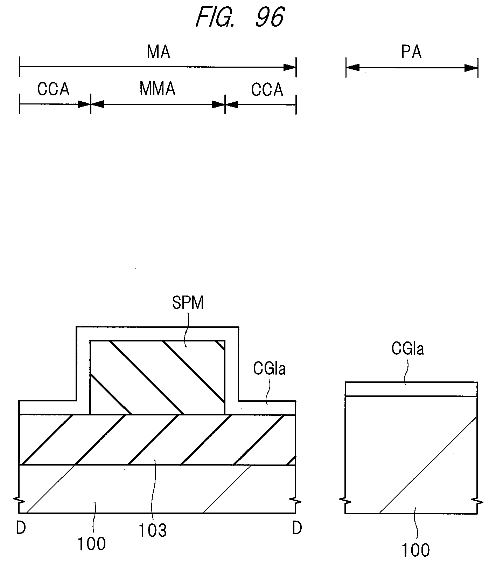

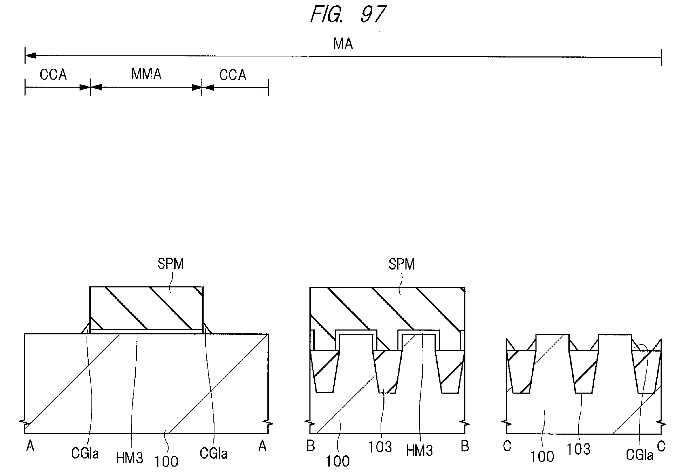

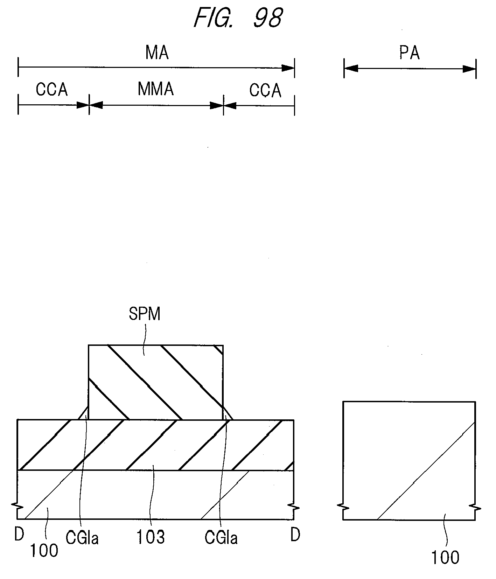

Subsequently, as shown in FIGs. 95 and 96, an insulating film to be the thick film portion CGIa is formed on the entire surface of the semiconductor substrate 100. For example, a silicon oxide film having a thickness of about 10 nm is formed on the side surfaces and upper surface of the stacked film of the insulating film HM3 and the insulating film SPM by using a CVD method or others. Subsequently, as shown in FIGs. 97 and 98, this silicon oxide film is etched back. At this time, the etch back conditions are adjusted so that the silicon oxide film (sidewall film) is left only in the lower portion of the side surfaces of the stacked film of the insulating film HM3 and the insulating film SPM. The silicon oxide film left in the lower portions of the side surfaces becomes the thick film portion CGIa. At this time, as shown as a C-C line cross-sectional portion of FIG 97, the thick film portion CGIa is also formed on the side surfaces of the fin F.

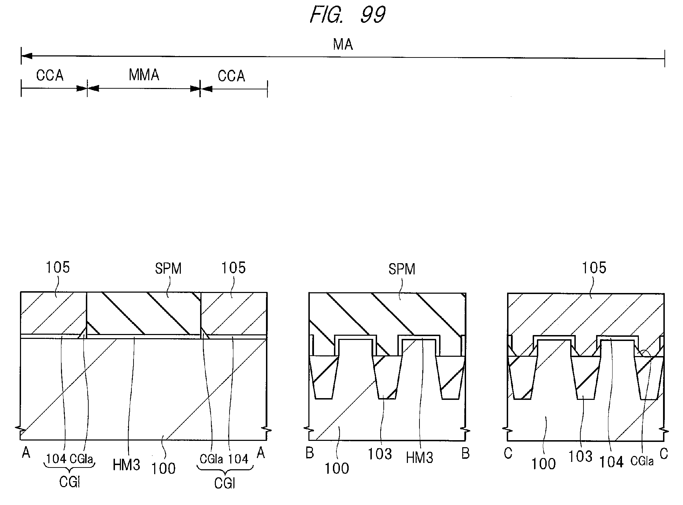

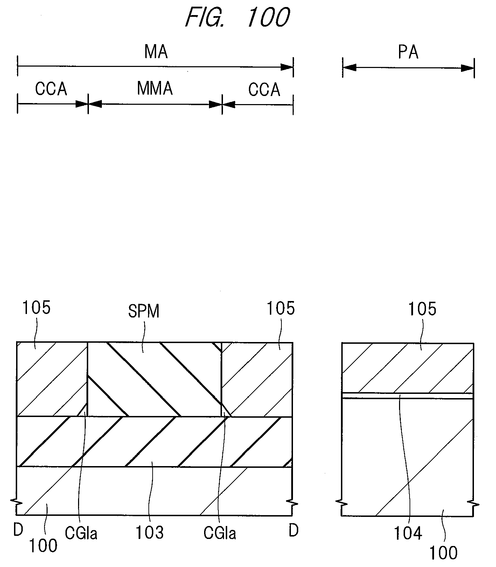

Subsequently, as shown in FIGs. 99 and 100, on the region CCA and the peripheral circuit region PA, the insulating film 104 to be the control gate insulating film CGI and the gate insulating film GI is formed by, for example, thermal oxidation. Thus, the control gate insulating film CGI made of the insulating film (thermal-oxide film) 104 and the silicon oxide film (sidewall film) serving as the stacked film is formed. In this manner, the thick film portion and the flat portion (at least a film located in the end portion of the control gate insulating film CGI on the side opposite to the memory gate electrode part MG side) may be prepared as different films from each other.

Subsequently, on the insulating film 104 and the insulating film SPM, a polysilicon film 105 having a film thickness of about 150 nm for the control gate electrode part CG and the gate electrode part GE is formed. Subsequently, the polysilicon film 105 is removed by using a CMP method or others, until the insulating film SPM is exposed. Subsequently, the insulating film SPM and the insulating film HM3 forming the lower layer thereof are removed by etching. By these processes, a concave portion (trench) is formed in the region MMA (see FIG 10).

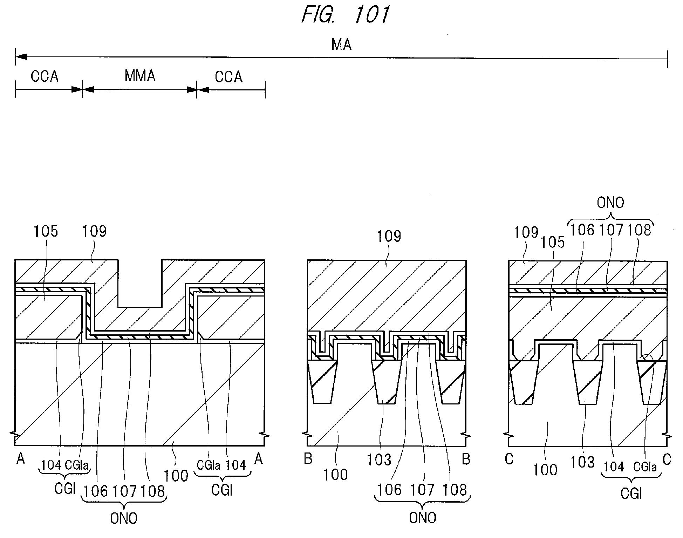

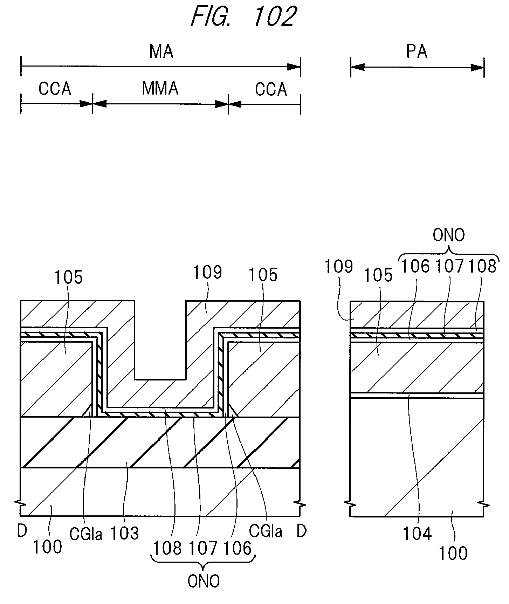

Subsequently, as shown in FIGs. 101 and 102, insulating films ONO (106, 107, 108) are formed. First, inside the above-described concave portion and on the polysilicon film 105, for example, a silicon oxide film is formed as the lower layer insulating film 106. This silicon oxide film is formed so as to have a film thickness of about 4 nm by thermal oxidation or others. Subsequently, on the lower layer insulating film 106, for example, a silicon nitride film is deposited so as to have a film thickness of about 7 nm by a CVD method or others as the middle layer insulating film 107. The middle layer insulating film 107 becomes a charge accumulating part in the memory cell. Subsequently, on the middle layer insulating film 107, an upper layer insulating film 108 is formed. For example, on the middle layer insulating film 107, a silicon oxide film is deposited so as to have a film thickness of about 9 nm by a CVD method or others as the upper layer insulating film 108.

Subsequently, a conductive film 109 to be the memory gate electrode part MG is formed on the insulating films ONO (106, 107, 108). For example, on the insulating films ONO (106, 107, 108), a polysilicon film having a thickness of about 40 nm is deposited as the conductive film 109 by using a CVD method or others.

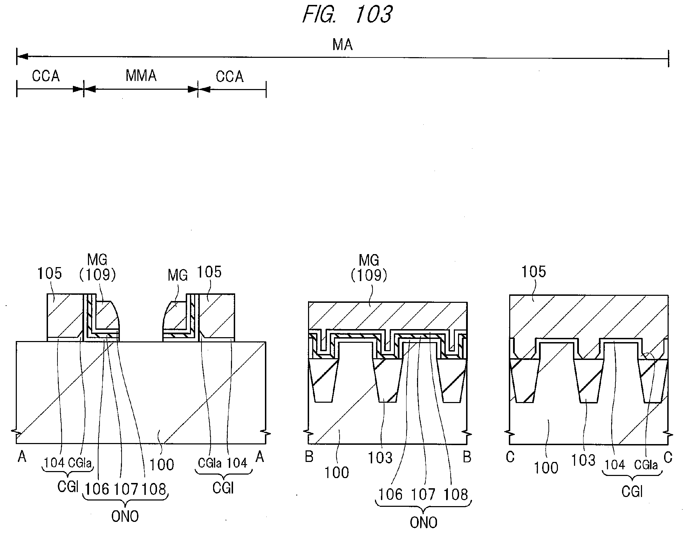

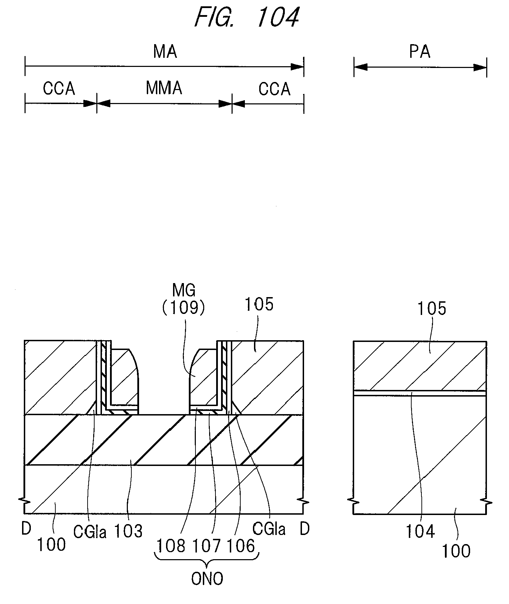

Subsequently, as shown in FIGs. 103 and 104, the side-wall-form memory gate electrode part MG is formed on side wall portions of the stacked film (control gate electrode part CG) of the insulating film 104 and the polysilicon film 105 in the region CCA For example, the polysilicon film is removed by a predetermined film thickness from the surface, by an anisotropic dry etching process.

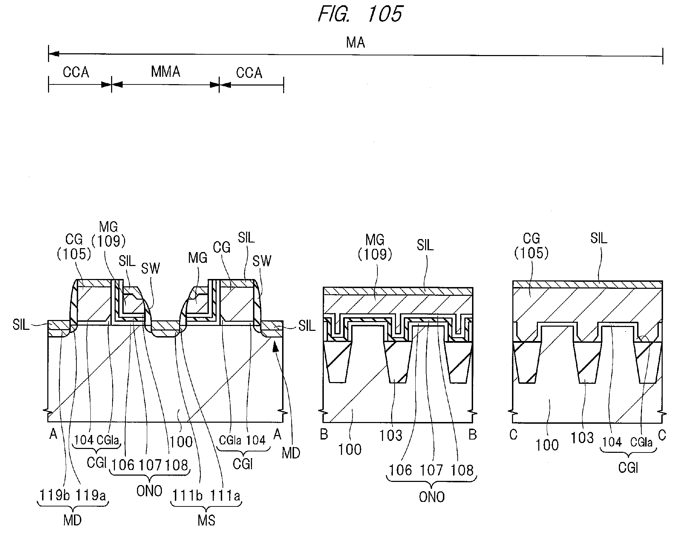

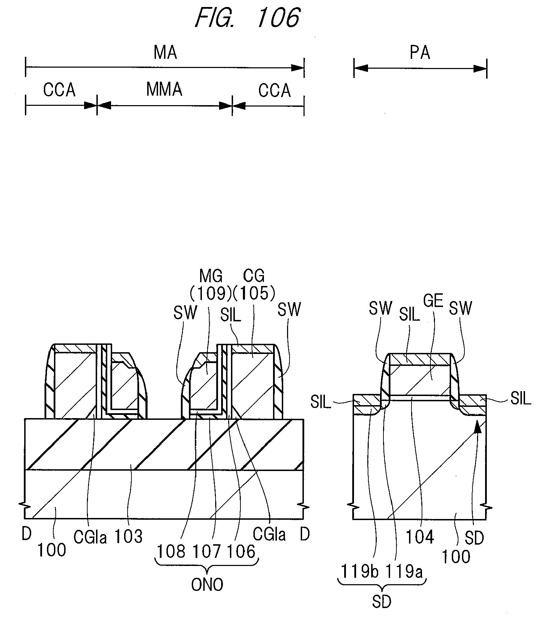

Subsequently, as shown in FIGs. 105 and 106, the gate insulating film GI and the gate electrode part GE are formed in the peripheral circuit region PA. For example, by using a photolithography technique and a dry-etching technique, the insulating film 104 and the polysilicon film 105 in the peripheral circuit region PA are processed (see FIG 106).

Subsequently, the source region MS and the drain region MD are formed in the memory cell region MA, and a source/drain region SD is formed in the peripheral circuit region PA. These regions can be formed as similar to those of the first embodiment.

Subsequently, a metal silicide film SIL is formed on the control gate electrode part CG, the memory gate electrode part MG, the source region MS, the drain region MD, the gate electrode part GE, and the source/drain region SD by using a salicide technique. The metal silicide film SIL can be formed as similar to the first embodiment.

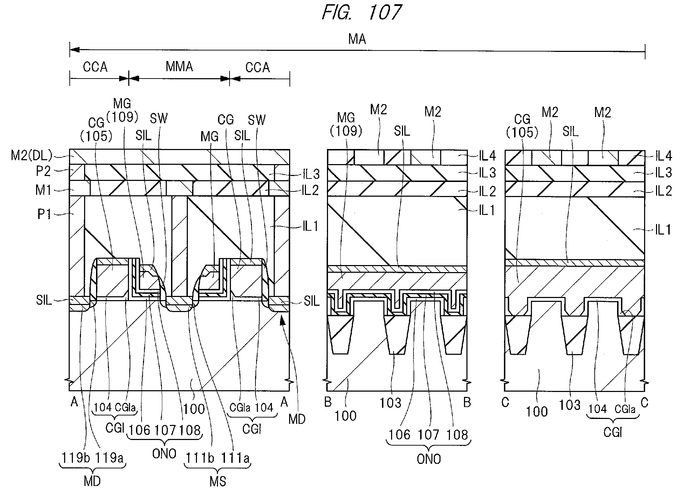

After that, as shown in FIGs. 107 and 108, interlayer insulating films (IL1, IL2, IL3, IL4), the plugs (P1, P2), and the wirings (M1, M2) are formed above the control gate electrode part CG, the memory gate electrode part MG, the gate electrode part GE, and others by a CVD method or others. The interlayer insulating films, the plugs, and the wirings can be formed as similar to those of the first embodiment.

By the above-described manufacturing process, the semiconductor device according to the present embodiment can be formed.

### (Applied Example 1)

In the semiconductor device of the above-described first to fourth embodiments, the memory cell and the peripheral transistor are formed on the fins. However, the memory cell and the peripheral transistor may be formed on a flat active region of a semiconductor substrate.

For example, the region of fins F shown in FIG 4 may become an active region (p-type well) whose surface height level is almost the same as that of the element isolation region 103. In this case, the source line SL can be formed by utilizing the active region, and therefore, the plug P1 and the source line SL can be omitted.

### (Applied Example 2)

The upper layer insulating film 108 forming the insulating film ONO may be prepared as a stacked film For example, the upper layer insulating film 108 is formed of a stacked film of a silicon oxynitride film formed on the middle layer insulating film 107, a silicon nitride film formed thereon and a silicon oxide film formed thereon. In other words, the upper layer insulating film 108 is formed of a stacked film obtained by stacking the silicon oxynitride film, the silicon nitride film and the silicon oxide film from below.

### (Applied Example 3)

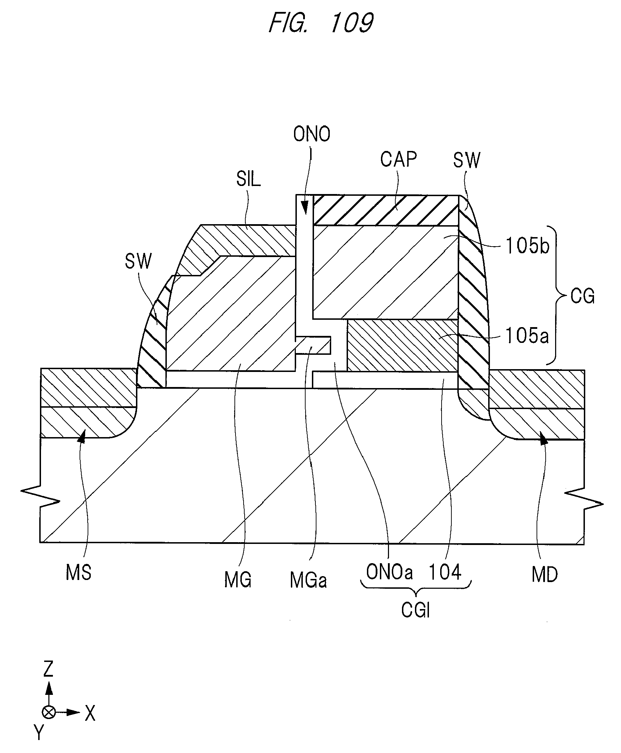

The second embodiment may have a configuration in which the hollow portion (concave portion, undercut portion) of the silicon germanium film 105a below the end portion of the polysilicon film on the memory gate electrode part MG side is formed to be larger so that parts of each of the insulating films ONO (106, 107, 108) and the memory gate electrode part MG comes into the hollow portion. The part of the insulating film ONO coming into the hollow portion is indicated by a reference symbol "ONOa", and the part of the memory gate electrode part MG coming into the hollow portion is indicated by a reference symbol "MGa". FIG 109 is a cross-sectional view showing a semiconductor device of the applied example.

In this manner, the film thickness of the end portion of the control gate insulating film CGI on the memory gate electrode part MG side is made larger, so that the retention property (charge holding property) of the memory cell can be improved as described in the first embodiment.

Moreover, by the part MGa of the memory gate electrode part MG coming into the hollow portion, a resistance of the channel below the control gate electrode part CG can be reduced at the time of reading, so that the reading property can be improved.

In the foregoing, the invention made by the present inventors has been concretely described based on the embodiments. However, it is needless to say that the present invention is not limited to the foregoing embodiments and various modifications and alterations can be made within the scope of the present invention.

For example, the memory cell of the second or fourth embodiment and the peripheral transistor of the third embodiment may be combined with each other.

## Claims

1. A semiconductor device **characterized by**:
a semiconductor substrate;
a first gate electrode part placed above the semiconductor substrate;
a second gate electrode part placed above the semiconductor substrate so as to be adjacent to the first gate electrode part;
a first insulating film formed between the first gate electrode part and the semiconductor substrate; and
a second insulating film which is formed between the second gate electrode part and the semiconductor substrate and between the first gate electrode part and the second gate electrode part, and which has a charge accumulating part therein,
wherein the first insulating film has a thick film portion in an end portion on a second gate electrode part side, and the thick film portion has a film thickness larger than a film thickness of an end portion of the first insulating film on a side opposite to the second gate electrode part side.

2. The semiconductor device according to claim 1, further **characterized by**:
a fin having a rectangular parallelepiped shape formed in an upper portion of the semiconductor substrate so as to extend in a first direction,
wherein the first gate electrode part is placed on the fin via the first insulating film, and extends in a second direction crossing the first direction.

3. The semiconductor device according to claim 1, **characterized in that**,
by injecting holes from the second gate electrode part into the charge accumulating part, electrons accumulated in the charge accumulating part are erased.

4. The semiconductor device according to claim 3, **characterized in that**,
by injecting electrons from the semiconductor substrate into the charge accumulating part, electrons are accumulated in the charge accumulating part.

5. The semiconductor device according to claim 1, **characterized in that**
the thick film portion has a first film portion and a second film portion formed on the first film portion,
the first film portion is an end portion of a first film on the second gate electrode part side, the first film being formed between the first gate electrode part and the semiconductor substrate, and
the second film portion is a part of the second insulating film.

6. The semiconductor device according to claim 5, **characterized in that**
the second insulating film has a middle layer insulating film to be the charge accumulating part, an upper layer insulating film on the middle layer insulating film, and a lower layer insulating film below the middle layer insulating film, and
a part of the second insulating film is an end portion of the lower layer insulating film, which is located below the first gate electrode part.

7. The semiconductor device according to claim 6, **characterized in that**
the first gate electrode part has a first layer and a second layer formed on the first layer, and
the end portion of the lower layer insulating film and the first layer are adjacent to each other.

8. The semiconductor device according to claim 1, **characterized in that**
the thick film portion of the first insulating film and the end portion of the first insulating film on the side opposite to the second gate electrode part side are made of different films from each other.

9. The semiconductor device according to claim 2, further **characterized by**:
an element isolation portion which extends along the fin in the first direction and whose surface height level is a height level of a bottom surface of the fin,
wherein a bottom surface of the second gate electrode part located on the element isolation portion is placed to be upper than a half position of the height level of the fin.

10. The semiconductor device according to claim 1, **characterized in that**
the second insulating film has a middle layer insulating film to be the charge accumulating part, an upper layer insulating film on the middle layer insulating film, and a lower layer insulating film below the middle layer insulating film, and
the upper layer insulating film has a stacked film obtained by stacking a silicon oxynitride film, a silicon nitride film and a silicon oxide film from below.

11. The semiconductor device according to claim 1, further **characterized by**:
a first element which is formed in a first region of the semiconductor substrate and which has the first gate electrode part, the second gate electrode part, the first insulating film and the second insulating film; and
a second element which is formed in a second region of the semiconductor substrate and which has a third gate electrode part placed on the semiconductor substrate via a third insulating film and a source/drain region formed in the semiconductor substrate on both sides of the third gate electrode part.

12. The semiconductor device according to claim 11, **characterized in that**
the third insulating film has a high dielectric constant film, and
the third gate electrode part has a metal film or a metal compound film.

13. A method of manufacturing a semiconductor device **characterized by** steps of:
(a) successively forming a first insulating film and a first conductive film on a semiconductor substrate;
(b) removing the first insulating film and the first conductive film in a first region of the semiconductor substrate;
(c) forming a thick film portion in an end portion of the first insulating film on the first region side;
(d) successively forming a second insulating film and a second conductive film on an upper surface and a side surface of the first conductive film; and
(e) by etching the second insulating film and the second conductive film, allowing the second conductive film to be left on side walls of the first insulating film and the first conductive film on the first region side via the second insulating film.

14. The method of manufacturing the semiconductor device according to claim 13, further **characterized by** a step of:
before the step of (a), forming a fin having a rectangular parallelepiped shape in an upper portion of the semiconductor substrate,
wherein the thick film portion in the step of (c) is formed on an upper surface and a side surface of the fin.

15. The method of manufacturing the semiconductor device according to claim 13, further **characterized by** a step of:
(g) forming a transistor having a gate electrode part placed on the semiconductor substrate via a third insulating film and a source/drain region formed in the semiconductor substrate on both sides of the gate electrode part.

16. The method of manufacturing the semiconductor device according to claim 15, **characterized in that**
the third insulating film has a high dielectric constant film, and
the gate electrode part has a metal film or a metal compound film.

17. The method of manufacturing the semiconductor device according to claim 14, further **characterized by** a step of:
forming an element isolation portion which extends along the fin in the first direction and whose surface height level is a height level of a bottom surface of the fin,
wherein a bottom surface of the second conductive film located on the element isolation portion is placed to be upper than a half position of the height level of the fin.

18. The method of manufacturing the semiconductor device according to claim 13, **characterized in that**
the second insulating film has a middle layer insulating film to be a charge accumulating part, an upper layer insulating film on the middle layer insulating film, and a lower layer insulating film below the middle layer insulating film, and
the upper layer insulating film has a stacked film obtained by stacking a silicon oxynitride film, a silicon nitride film and a silicon oxide film from below.

19. A method of manufacturing a semiconductor device **characterized by** steps of:
(a) forming a first insulating film on a semiconductor substrate, and forming a first conductive film having a first layer portion on the first insulating film and a second layer portion on the first layer portion;
(b) removing the first insulating film and the first conductive film in a first region of the semiconductor substrate;
(c) by removing the first insulating film and the first layer portion exposed from side surfaces of the first layer portion and the second layer portion, forming a hollow portion between the first insulating film and the second layer portion;
(d) successively forming a second insulating film and a second conductive film on an upper surface and a side surface of the first conductive film, and placing a part of the second insulating film in the hollow portion to form a thick film portion made of the first insulating film and the part of the second insulating film in an end portion of the first insulating film on the first region side; and
(e) by etching the second insulating film and the second conductive film, allowing the second conductive film to be left on side walls of the first insulating film and the first conductive film on the first region side via the second insulating film.

20. A method of manufacturing a semiconductor device **characterized by** steps of:
(a) forming a sacrificed film in a first region of a semiconductor substrate;
(b) by forming a sidewall film in a lower portion of a side surface of the sacrificed film and by forming an insulating film on a surface of the semiconductor substrate, forming a first insulating film made of the sidewall film and the insulating film;
(c) forming a first conductive film on the first insulating film;
(d) after removing the sacrificed film, successively forming a second insulating film and a second conductive film on an upper surface and a side surface of the first conductive film; and
(e) by etching the second insulating film and the second conductive film, allowing the second conductive film to be left on side walls of the first insulating film and the first conductive film on the first region side via the second insulating film.
